# EUROPEAN PATENT SPECIFICATION

(11) **EP 3 845 950 B1**
(45) Date of publication and mention of the grant of the patent: **17.07.2024**
(21) Application number: 19854649.1
(22) Date of filing: 27.08.2019
(51) Int. Cl.: G02B 26/10, G01S 7/481, G01S 17/89, G01S 17/08, F21V 5/00, G06V 10/145, H01S 5/183, G02B 1/00, F21S 41/00, G06V 10/147, H01S 5/00, H01S 5/42

(54) **LIDAR DEVICE**
LIDAR-VORRICHTUNG
DISPOSITIF LIDAR

(30) Priority: 28.08.2018 US 201862723804 P; 20.11.2018 KR 20180143972; 20.11.2018 KR 20180143973; 20.11.2018 KR 20180143974
(43) Date of publication of application: 07.07.2021
(73) Proprietor: SOS Lab Co., Ltd., Gwangju 61005 (KR)
(72) Inventor: JANG, Jun Hwan, Suwon-si Gyeonggi-do 16508 (KR); YOON, Hee Sun, Incheon 21996 (KR)
(74) Representative: Dantz, Jan Henning
(86) International application number: PCT/KR2019/010954
(87) International publication number: WO 2020/045967

(56) References cited:
- JP-A- 2000 009 422
- KR-A- 20170 063 196
- KR-A- 20180 013 598
- KR-A- 20180 015 489
- US-A1- 2007 071 056
- US-A1- 2017 287 151
- US-A1- 2018 039 102
- US-A1- 2018 129 866

## Description

### [TECHNICAL FIELD]

The present disclosure relates to a light detection and ranging (LiDAR) device, and more particularly, to a LiDAR device for obtaining information on a distance to an obstacle by steering a laser beam using a metasurface including a nanopillar.

### [BACKGROUND ART]

In active use of edge-emitting lasers, in recent years, interest in the vertical cavity surface emitting laser (VCSEL) has been increasing. The VCSEL is a semiconductor laser that emits a laser in a vertical direction on an upper surface and has advantages in that it is easy to mass produce because of its simple manufacturing process and it is able to be manufactured in a small size because of its high degree of integration.

The VCSEL has mostly been applied to the telecommunications field, but recently, attempts to apply the VCSEL to the optical system have been vigorously made. Particularly, with autonomous-driving vehicles being in the spotlight, attempts to apply the VCSEL to a light detection and ranging (LiDAR) device have been vigorously made.

US2017/287151 discloses a light generator including a light source configured to emit light, and a first meta optical device including a first metasurface including nanostructures having sub-wavelength dimensions that are less than a wavelength of the light emitted from the light source, the first metasurface being configured to form a distribution of light rays from the light emitted from the light source to thereby radiate structured light.

In US 2018/129866 a light-emitting device is provided comprising an illuminator with at least one light source having a stack of layers comprising a layer with a light emitting surface, and a metalayer disposed at the stack of layers to receive light from the light emitting surface, and having a plurality of spaced light scattering posts to receive light from the light emitting surface and change the direction of the light from the direction of the light received from the light emitting surface, wherein the light source and metalayer are arranged to cooperatively form a predetermined far-field light intensity radiation pattern.

US2018/039102 discloses a meta optical device having no phase defect.

The meta optical device comprises a support layer, and a plurality of nanostructures provided above the support layer, the plurality of nanostructures being arranged to form a dimension distribution that changes a phase of incident light with a certain regularity based on positions of the plurality of nanostructures, and having dimension values that are less than a wavelength of the incident light, wherein signs of slopes of a phase change graph showing a phase change of the incident light with respect to the dimension values of the plurality of nanostructures are consistent.

US2007/071056 discloses a laser ranging and detection by sequentially emitting a plurality of beams from a vertical-cavity surface-emitting laser structure, re-directing the beams through optical elements such that they are fanned out over the region of view, and detecting any beams that may be reflected by objects in the region of view. The range and bearing of such objects can be determined from the beam time-of-flight and beam angle.

### [DETAILED DESCRIPTION OF THE INVENTION]

### [TECHNICAL PROBLEM]

A problem to be solved according to an embodiment relates to reducing the size of a light detection and ranging (LiDAR) device by using a vertical cavity surface emitting laser (VCSEL) element.

A problem to be solved according to another embodiment relates to generating a scanning point cloud by forming various subwavelength patterns using nanopillars.

A problem to be solved according to still another embodiment relates to realizing a solid-state lidar device capable of three-dimensional scanning using a metasurface.

Problems to be solved by the present invention are not limited to those mentioned above, and other unmentioned problems should be clearly understood by those of ordinary skill in the art to which the present invention pertains from the present specification and the accompanying drawings.

### [TECHNICAL SOLUTION]

These problems are solved by a lidar device having the features of claim 1. An aspect of the present disclosure is directed to a lidar device for measuring a distance to an obstacle within a field of view having a vertical direction and a horizontal direction and being formed by a plurality of scanning points. The device may include a laser emitting unit including a plurality of VCSEL(Vertical Cavity Surface Emitting Laser) elements arranged in a form of array and emitting a laser beam; a metasurface including a plurality of beam steering cells arranged in a form of two-dimensional array having a row direction corresponding to the vertical direction and a column direction corresponding to the horizontal direction, wherein the plurality of the beam steering cells guide the laser beam to the plurality of the scanning points by using nanopillars disposed on an emission surface side of the laser emitting unit; wherein the nanopillars form a subwavelength pattern in the plurality of the beam steering cells, wherein the subwavelength pattern of a specific cell among the plurality of the beam steering cells includes: an increment of a first attribute being repeated along a direction from a center of the metasurface to a row of the specific cell and a change rate of the first attribute being increased according to a distance from the row of the specific cell to the center of the metasurface, an increment of a second attribute being repeated along a direction from the center of the metasurface to a column of the specific cell and a change rate of the second attribute being related to a distance from the column of the specific cell to the center of the metasurface, and wherein the first attribute is related to at least one of a width, a height, and a number per unit length of the nanopillars, and the second attribute is related to at least one of a width, a height, and a number per unit length of the nanopillars.

Another aspect of the present disclosure is directed to a laser emitting device, whose a field of view being formed by a plurality of scanning points distributed in a vertical direction and a horizontal direction, the device comprising: a laser emitting unit including a plurality of VCSEL(Vertical Cavity Surface Emitting Laser) elements arranged in a form of array and emitting a laser beam; a metasurface including a plurality of beam steering cells arranged in a form of two-dimensional array having a row direction corresponding to the vertical direction and a column direction corresponding to the horizontal direction, wherein the plurality of the beam steering cells guide the laser beam to the plurality of the scanning points by using nanopillars disposed on an emission surface side of the laser emitting unit; wherein the nanopillars form a subwavelength pattern in the plurality of the beam steering cells, wherein the subwavelength pattern of a specific cell among the plurality of the beam steering cells includes: an increment of a first attribute being repeated along a direction from a center of the metasurface to a row of the specific cell and a change rate of the first attribute being increased according to a distance from the row of the specific cell to the center of the metasurface, an increment of a second attribute being repeated along a direction from the center of the metasurface to a column of the specific cell and a change rate of the second attribute being increased according to a distance from the column of the specific cell to the center of the metasurface, and wherein the first attribute is related to at least one of a width, a height, and a number per unit length of the nanopillars, and, the second attribute is related to at least one of a width, a height, and a number per unit length of the nanopillars.

Yet another aspect of the present disclosure is directed to a lidar device for measuring a distance to an obstacle within a field of view having a vertical direction and a horizontal direction and being formed by a plurality of scanning points, the device comprising: a laser emitting unit including a plurality of VCSEL(Vertical Cavity Surface Emitting Laser) elements arranged in a form of array and emitting a laser beam; a metasurface including a plurality of beam steering cells guiding the laser beam to the plurality of the scanning points by using nanopillars disposed on an emission surface side of the laser emitting unit; wherein the nanopillars form a subwavelength pattern in the plurality of the beam steering cells, wherein the subwavelength pattern of a specific cell among the plurality of the beam steering cells includes: an increment of a first attribute being repeated along a first component of a steering direction in which the specific cell guides the laser beam and a change rate of the first attribute being increased according to a magnitude of the first component, an increment of a second attribute being repeated along a second component of a steering direction in which the specific cell guides the laser beam and a change rate of the second attribute being increased according to a magnitude of the second component, and wherein the first component corresponds to the vertical direction of the field of view and the second component corresponds to the horizontal direction of the field of view.

Still yet another aspect of the present disclosure is directed to a laser emitting device whose a field of view being formed by a plurality of scanning points distributed in a vertical direction and a horizontal direction, the device comprising: a laser emitting unit including a plurality of VCSEL(Vertical Cavity Surface Emitting Laser) elements arranged in a form of array and emitting a laser beam; a metasurface including a plurality of beam steering cells guiding the laser beam to the plurality of the scanning points by using nanopillars disposed on an emission surface side of the laser emitting unit; wherein the nanopillars form a subwavelength pattern in the plurality of the beam steering cells, wherein the subwavelength pattern of a specific cell among the plurality of the beam steering cells includes: an increment of a first attribute being repeated along a first component of a steering direction in which the specific cell guides the laser beam and a change rate of the first attribute being increased according to a magnitude of the first component, an increment of a second attribute being repeated along a second component of a steering direction in which the specific cell guides the laser beam and a change rate of the second attribute being increased according to a magnitude of the second component, and wherein the first component corresponds to the vertical direction of the field of view and the second component corresponds to the horizontal direction of the field of view.

Further still another aspect of the present disclosure is directed to a lidar device comprising: a polygonal mirror rotating along a rotational axis, reflecting a laser beam provided from a side toward an object and receiving a laser beam reflected from the object; a laser emitting module including a plurality of VCSEL(Vertical Cavity Surface Emitting Laser) elements emitting a laser beam toward the polygonal mirror and arranged along the rotational axis; a metasurface forming, via a plurality of nanopillars disposed on an emission surface side of the laser emitting module, a beam of line pattern line pattern being extended along the rotational axis using the laser beam emitted from the laser emitting module; and a sensor unit receiving, via the polygonal mirror, the laser beam reflected from the object.

Further still another aspect of the present disclosure is directed to a lidar device comprising: a laser emitting module for including a plurality of VCSEL(Vertical Cavity Surface Emitting Laser) elements emitting a laser beam; a metasurface forming a beam of line pattern extended along a first axis which is one of a vertical axis and a horizontal axis, wherein the metasurface includes a plurality of steering cells steering the laser beam along the first axis by using a nanopillar disposed on an emission surface side of the laser emitting module; a scanning mirror transforming the beam of line pattern to a beam of plane pattern and receiving a laser beam reflected from an object, by being rotated along the first axis; and a sensor unit for receiving the laser beam reflected from the object via the scanning mirror.

### [ADVANTAGEOUS EFFECTS OF THE INVENTION]

A lidar device according to an embodiment can be miniaturized by using a vertical cavity surface emitting laser (VCSEL) element.

A lidar device according to another embodiment generates a scanning point cloud by forming various subwavelength patterns using nanopillars.

A lidar device according to yet another embodiment realizes a solid-state lidar device capable of three-dimensional scanning using a metasurface.

Advantageous effects of the present invention are not limited to those described above, and other unmentioned advantageous effects should be clearly understood by those of ordinary skill in the art to which the present invention pertains from the present specification and the accompanying drawings.

### [DESCRIPTION OF THE DRAWINGS]

FIG. 1 is a pictorial diagram illustrating a laser emitting device according to an embodiment;
FIGS. 2 to 7 are cross-sectional views of a laser emitting device according to various embodiments;
FIGS. 8 to 14 are views for describing a beam steering unit according to various embodiments;
FIG. 15 is a pictorial diagram illustrating a laser beam emitted from a laser emitting device according to an embodiment;
FIG. 16 is a view illustrating a beam steering unit according to an embodiment;
FIG. 17 is a view illustrating a beam projection surface according to an embodiment;
FIG. 18 is a pictorial diagram illustrating a laser emitting device according to an embodiment;
FIG. 19 is a pictorial diagram illustrating a laser emitting device according to an embodiment;
FIG. 20 is an exploded perspective view of a laser emitting device according to an embodiment;
FIGS. 21 to 23 are exploded perspective views of a laser emitting device according to various embodiments viewed from the side;
FIGS. 24 to 26 are exploded perspective views of a laser emitting device according to various embodiments;
FIGS. 27 and 28 are exploded perspective views of the laser emitting device of FIG. 26 viewed from the side;
FIGS. 29 to 31 are block diagrams for describing a light detection and ranging (LiDAR) device according to various embodiments;
FIGS. 32 to 35 are pictorial diagrams illustrating a lidar device according to various implementations;
FIG. 36 is a top view of the lidar device of FIG. 35 viewed from the top; and
FIG. 37 is a view for describing a lidar device according to still another implementation.

### [BEST MODE]

The foregoing objects, features and advantages of the present disclosure will become more apparent from the following detailed description related to accompanying drawings.

Hereinafter, specific embodiments, which are illustrated in the drawings, will be described in detail.

In the drawings, the thicknesses of layers and regions are exaggerated for clarity. When it is indicated that an element or layer is "on" or "above" another element or layer, this includes a case in which another layer or element is interposed therebetween as well as a case in which the element or layer is directly above the other element or layer. In principle, like reference numerals designate like elements throughout the specification. In the following description, like reference numerals are used to designate elements which have the same function within the same idea illustrated in the drawings of each embodiment.

When detailed description of known functions or configurations related to the present disclosure is deemed to unnecessarily blur the gist of the invention, the detailed description thereof will be omitted. Also, numerals (e.g., first, second, etc.) used in the description herein are merely identifiers for distinguishing one element from another element.

In addition, the terms "module" and "unit" used to refer to elements in the following description are given or used in combination only in consideration of ease of writing the specification, and the terms themselves do not have distinct meanings or roles.

According to one embodiment, a lidar device for measuring a distance to an object within a field of view having a vertical direction and a horizontal direction and being formed by a plurality of scanning points according to claim 1 is provided.

Herein, a steering direction of the beam steering cell may have a vertical component in a range of -M° to M° and a horizontal component in a range of -N° to N°, wherein N is greater than M.

Herein, a location of each of the plurality of scanning points included in the field of view may be related to a location of the beam steering cell in the metasurface.

Herein, the nanopillars may have a cylindrical or polygonal column shape.

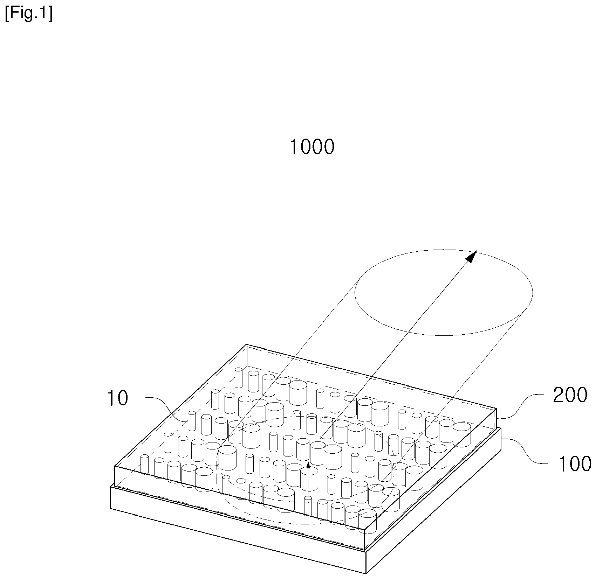

FIG. 1 is a pictorial diagram illustrating a laser emitting device 1000 according to an embodiment.

The laser emitting device 1000 according to an embodiment may emit a laser beam in various directions.

The laser emitting device 1000 according to an embodiment may include a laser emitting unit 100 and a beam steering unit 200.

The laser beam emitted from the laser emitting unit 100 may be steered by the beam steering unit 200. Accordingly, laser beams of various shapes may be formed. For example, the laser emitting device 1000 may emit a laser beam in the form of a planar beam. As another example, the laser emitting device 1000 may emit a laser beam in the form of a linear beam. Alternatively, the laser emitting device 1000 may output a laser beam in the form of a point light source.

Hereinafter, each configuration of the laser emitting device 1000 will be described in detail.

The laser emitting unit 100 may emit a laser beam to one side. The beam steering unit 200 may be disposed at one side of the laser emitting unit 100 and steer the laser beam emitted from the laser emitting unit 100. The beam steering unit 200 may steer the emitted laser beam on the basis of a nanopattern formed by a plurality of nanopillars 10. Accordingly, a flight path of the laser beam emitted from the laser emitting unit 100 may be determined by the nanopattern. The nanopattern may have the same meaning as a subwavelength pattern.

The laser emitting unit 100 may emit laser beams having various wavelengths. For example, the laser emitting unit 100 may emit a laser beam whose wavelength is 905 nm. Alternatively, the laser emitting unit 100 may emit a laser beam having a wavelength of 1550 nm.

The laser emitting unit 100 may be provided in the form of a flat panel.

The laser emitting unit 100 may include a support surface and an emission surface. The support surface and the emission surface may be parallel to each other.

The laser emitting unit 100 may emit a laser beam in a direction perpendicular to the support surface. Alternatively, the laser emitting unit 100 may emit a laser beam in a direction perpendicular to the emission surface.

The beam steering unit 200 may generate laser beams of various forms from the laser beam provided from one side. For example, the beam steering unit 200 may generate a laser beam in the form of a linear beam from a laser beam in the form of a point light source. As another example, the beam steering unit 200 may generate a laser beam in the form of a planar beam from a laser beam in the form of a point light source. As still another example, the beam steering unit 200 may generate a laser beam in the form of a planar beam from a laser beam in the form of a linear beam.

The beam steering unit 200 may refract the laser beam emitted from the laser emitting unit 100. For example, the beam steering unit 200 may refract the emitted laser beam on the basis of a nanopattern formed by the plurality of nanopillars 10. An angle-after-refraction of the refracted laser beam may be set on the basis of the nanopattern.

The beam steering unit 200 may include the plurality of nanopillars 10.

The plurality of nanopillars 10 may have a subwavelength size. For example, a pitch between the plurality of nanopillars 10 may be less than a wavelength of the laser beam emitted from the laser emitting unit 100. Alternatively, a width, diameter, and height of the nanopillars 10 may be less than a size of the wavelength of the laser beam.

The beam steering unit 200 may be a metasurface.

The beam steering unit 200 may adjust a phase of a laser beam emitted from the laser emitting unit 100 to refract the laser beam.

The beam steering unit 200 may be disposed on the laser emitting unit 100. For example, the beam steering unit 200 may be disposed at the emission surface side of the laser emitting unit 100.

Alternatively, the beam steering unit 200 may be deposited on the laser emitting unit 100. The plurality of nanopillars 10 may be formed on an upper portion of the laser emitting unit 100. The plurality of nanopillars 10 may form various nanopatterns on the laser emitting unit 100.

The nanopillars 10 may have various shapes. For example, the nanopillars 10 may have a cylindrical shape, a polygonal column shape, a conical shape, a polypyramid shape, or the like. Furthermore, the nanopillars 10 may have an irregular shape.

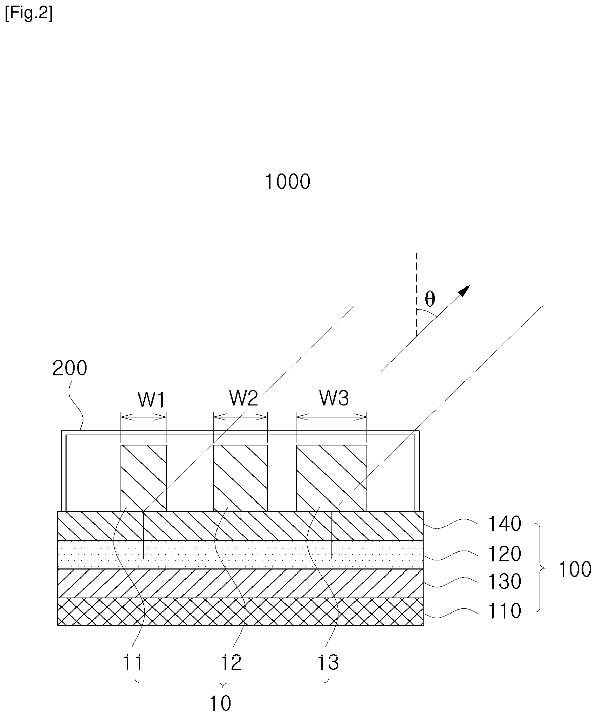

FIG. 2 is a cross-sectional view of a laser emitting device 1000 according to an embodiment.

As illustrated in FIG. 2, the laser emitting device 1000 according to an embodiment may include a laser emitting unit 100 and a beam steering unit 200.

Each configuration of the laser emitting device 1000 will be described in detail below.

The laser emitting unit 100 according to an embodiment may include a substrate 110 electrically connected to an external power source, a light source unit 120 configured to emit a laser beam, and reflection units 130 and 140 configured to reflect the laser beam emitted from the light source unit 120.

The laser beam emitted from the light source unit 120 may oscillate by being reflected by the reflection units 130 and 140. The emitted laser beam may be repeatedly reflected by a first reflection unit 130 and a second reflection unit 140 and then pass through the second reflection unit 140 to be emitted to the outside of the laser emitting unit 100.

The light source unit 120 may emit laser beams of various wavelengths. For example, the light source unit 120 may emit a laser beam whose wavelength is 905 nm. Alternatively, the light source unit 120 may emit a laser beam having a wavelength of 1550 nm.

The light source unit 120 may be formed of various materials. For example, the light source unit 120 may include GaAs, AlGaAs, GaAlAs, and Si.

A wavelength of a laser beam emitted from the light source unit 120 may vary according to materials constituting the light source unit 120.

An intensity of a laser beam emitted from the light source unit 120 may vary according to a strength of power received from the outside.

The light source unit 120 may be disposed between the first reflection unit 130 and the second reflection unit 140.

The first reflection unit 130 may reflect a laser beam provided to one side. For example, the first reflection unit 130 may reflect a laser beam emitted from the light source unit 120 toward the light source unit 120. The first reflection unit 130 may reflect a laser beam reflected from the second reflection unit 140 toward the light source unit 120.

The first reflection unit 130 may include a plurality of layers. The plurality of layers may have a structure in which a layer having a relatively high refractive index and a layer having a relatively low refractive index are alternately disposed. Each of the plurality of layers may have a thickness that is 1/4 of a wavelength of a laser beam emitted from the light source unit 120.

As illustrated, the first reflection unit 130 may be disposed on an upper portion of the substrate 110. For example, the first reflection unit 130 may be deposited on the substrate 110. Of course, another configuration may be included between the substrate 110 and the first reflection unit 130.

The first reflection unit 130 may be a distributed Bragg reflector (DBR).

The first reflection unit 130 may include GaAs, indium tin oxide (ITO), indium zinc oxide (IZO), Ga-In-Zn-oxide (GIZO), Al-Zn-oxide (AZO), Ga-Zn-oxide (GZO), and ZnO.

The second reflection unit 140 may reflect a laser beam provided to one side. For example, the second reflection unit 140 may reflect a laser beam emitted from the light source unit 120 toward the light source unit 120. The second reflection unit 140 may reflect the laser beam reflected from the first reflection unit 130 toward the light source unit 120.

The second reflection unit 140 may include a plurality of layers. The plurality of layers may have a structure in which a layer having a relatively high refractive index and a layer having a relatively low refractive index are alternately disposed. Each of the plurality of layers may have a thickness that is 1/4 of a wavelength of a laser beam emitted from the light source unit 120.

A laser beam that is emitted from the light source unit 120 and then reflected by the first reflection unit 130 and the second reflection unit 140 may pass through the second reflection unit 140 and be emitted toward the nanopillars 10. The laser beam may be emitted in a direction perpendicular to the substrate 110.

The second reflection unit 140 may be disposed on an upper portion of the light source unit 120. For example, the second reflection unit 140 may be deposited on the light source unit 120. Of course, another configuration may be included between the substrate 110 and the second reflection unit 140.

The second reflection unit 140 may be a distributed Bragg reflector (DBR).

The second reflection unit 140 may include GaAs, CuAl2O, NiO, and CuO.

An electrical attribute of the first reflection unit 130 may differ from an electrical attribute of the second reflection unit 140. For example, the first reflection unit 130 may be an n-type semiconductor, and the second reflection unit 140 may be a p-type semiconductor.

The first reflection unit 130 may include more layers than the second reflection unit 140.

A reflectivity of the first reflection unit 130 may be higher than a reflectivity of the second reflection unit 140.

The laser emitting unit 100 according to an embodiment may be a vertical cavity surface emitting laser (VCSEL) element. A laser beam emitted from the laser emitting unit 100 may be emitted in the direction perpendicular to the substrate 110. The emitted laser beam may be emitted in the direction perpendicular to the support surface of the laser emitting unit 100.

In FIG. 2, the first reflection unit 130 is illustrated as being disposed between the substrate 110 and the light source unit 120. However, this is merely an example, and the locations of the first reflection unit 130 and the second reflection unit 140 may also be reversed. The laser emitting unit 100 may also include configurations other than the illustrated configurations.

Meanwhile, in FIG. 2, the nanopillars 10 and the second reflection unit 140 are illustrated as being in contact with each other. However, this is merely for convenience of the description, and another configuration may be disposed between the nanopillars 10 and the second reflection unit 140. For example, a transparent electrode layer may be disposed between the nanopillars 10 and the second reflection unit 140.

The beam steering unit 200 may refract a laser beam emitted from the laser emitting unit 100. For example, the beam steering unit 200 may control a phase of the laser beam to steer the laser beam. Also, the beam steering unit 200 may control a light quantity of the laser beam to steer the laser beam.

The beam steering unit 200 may include the plurality of nanopillars 10.

A height of the nanopillars 10 may be at least half or more of a height of a wavelength of a laser beam emitted from the laser emitting unit 100.

The nanopillars 10 may be formed of various materials. For example, the nanopillars 10 may be formed of metals such as As, Au, Al, and Pt or metal nitrides such as TiN and TaN.

A refractive index of the nanopillars 10 may be higher than the refractive index of the second reflection unit 140.

The plurality of nanopillars 10 may form various nanopatterns. The beam steering unit 200 may steer a laser beam emitted from the laser emitting unit 100 on the basis of the nanopatterns.

The nanopillars 10 may form nanopatterns on the basis of various attributes. The attributes may include a width W, a pitch P, a height H, and a number per unit length of the nanopillars 10.

Hereinafter, nanopatterns formed on the basis of various attributes and laser beam steering according to the nanopatterns will be described.

The plurality of nanopillars 10 may form nanopatterns on the basis of the width W thereof. For example, the plurality of nanopillars 10 may be disposed such that widths W1, W2, and W3 thereof gradually increase in one direction. In this case, a laser beam emitted from the laser emitting unit 100 may be steered in the direction in which the width W of the nanopillars 10 increases.

For example, the beam steering unit 200 may include a first nanopillar 11 having a first width W1, a second nanopillar 12 having a second width W2, and a third nanopillar 13 having a third width W3. The third width W3 may be greater than the first width W1 and the second width W2. The second width W2 may be greater than the first width W1. That is, the width W of the nanopillars 10 may gradually increase from the first nanopillar 11 toward the third nanopillar 13. In this case, a laser beam emitted from the laser emitting unit 100 may be steered in a third direction, which is a direction between a first direction, in which the laser beam is emitted from the laser emitting unit 100, and a second direction, which is a direction from the first nanopillar 11 to the third nanopillar 13. The third direction may be calculated on the basis of the sum of a first vector having the first direction and a second vector having the second direction. The second direction may be perpendicular to the first direction.

Meanwhile, a steering angle θ of the laser beam may vary according to a change rate of the width W of the nanopillars 10. Here, the change rate of the width W of the nanopillars 10 may refer to a numerical value indicating, on average, a degree of change in the width W of the plurality of nanopillars 10 which are adjacent to each other. Here, the steering angle θ may refer to an angle between a laser beam steered by the beam steering unit 200 and a virtual reference line R. The reference line R may relate to an emission direction of a laser beam emitted from the laser emitting unit 100. For example, the reference line R may be parallel to the emission direction.

The change rate of the width W of the nanopillars 10 may be calculated on the basis of a difference between the first width W1 and the second width W2 and a difference between the second width W2 and the third width W3.

The difference between the first width W1 and the second width W2 may be different from the difference between the second width W2 and the third width W3.

The steering angle θ of the laser beam may vary according to the width W of the nanopillars 10.

Specifically, the steering angle θ may increase as the change rate of the width W of the nanopillars 10 increases.

For example, the nanopillars 10 may form, on the basis of the width W thereof, a first pattern having a first change rate. Also, the nanopillars 10 may form, on the basis of the width W thereof, a second pattern having a second change rate which is lower than the first change rate.

In this case, a first steering angle due to the first pattern may be larger than a second steering angle due to the second pattern.

Meanwhile, the steering angle θ may be in a range of -90° to 90°.

The plurality of nanopillars 10 may form nanopatterns on the basis of a change in the pitch P between the nanopillars P adjacent to each other. The beam steering unit 200 may steer a laser beam emitted from the laser emitting unit 100 on the basis of the nanopatterns formed on the basis of the change in the pitch P between the nanopillars 10.

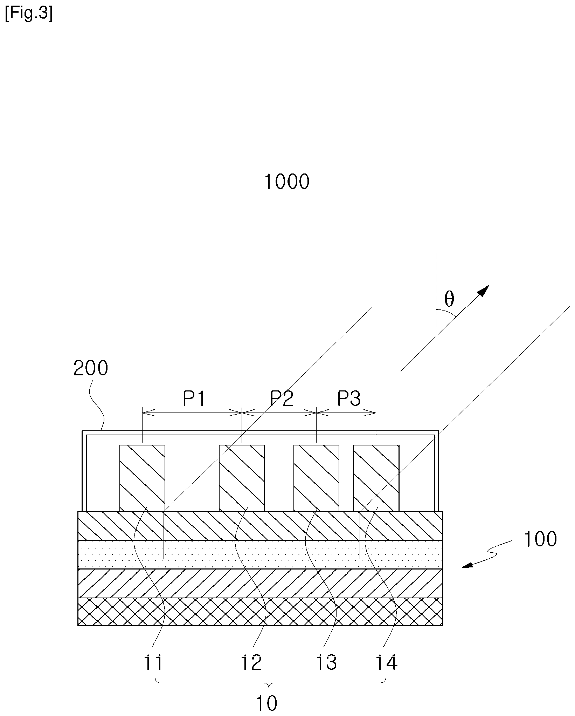

FIG. 3 is a cross-sectional view for describing beam steering according to changes in pitches P1, P2, and P3 between nanopillars 10. A laser emitting device 1000 may include a laser emitting unit 100 and a beam steering unit 200. The beam steering unit 200 may include a plurality of nanopillars 10.

The laser emitting unit 100 of FIG. 3 may correspond to the laser emitting unit 100 described above with reference to FIGS. 1 and 2. Accordingly, detailed description thereof will be omitted, and differences from the laser emitting device 1000 of FIG. 2 will mainly be described.

According to an embodiment, a pitch P between the nanopillars 10 may gradually decrease in one direction. Here, the pitch P may refer to a distance between centers of two nanopillars 10 adjacent to each other. For example, a first pitch P1 may be defined as a distance between a center of a first nanopillar 11 and a center of a second nanopillar 12. Alternatively, the first pitch P1 may be defined as the shortest distance between the first nanopillar 11 and the second nanopillar 12.

A laser beam emitted from the laser emitting unit 100 may be steered in a direction in which the pitch P between the nanopillars 10 decreases.

The beam steering unit 200 may include a first nanopillar 11, a second nanopillar 12, a third nanopillar 13, and a fourth nanopillar 14. In this case, a first pitch P1 may be obtained on the basis of a distance between the first nanopillar 11 and the second nanopillar 12. Likewise, a second pitch P2 may be obtained on the basis of a distance between the second nanopillar 12 and the third nanopillar 13. Also, a third pitch P3 may be obtained on the basis of a distance between the third nanopillar 13 and the fourth nanopillar 14. In this case, the first pitch P1 may be greater than the second pitch P2 and the third pitch P3. The second pitch P2 may be greater than the third pitch P3. That is, the pitch P gradually decreases from the first nanopillar 11 toward the fourth nanopillar 14.

In this case, a laser beam emitted from the laser emitting unit 100 may be steered in a direction between a first direction in which the laser beam is emitted from the laser emitting unit 100 and a second direction from the first nanopillar 11 to the third nanopillar 13.

The steering angle θ of the laser beam may vary according to the pitch P between the nanopillars 10.

Specifically, the steering angle θ of the laser beam may vary according to a change rate of the pitch P between the nanopillars 10. Here, the change rate of the pitch P between the nanopillars 10 may refer to a numerical value indicating, on average, a degree of change in the pitch P between the nanopillars 10 adjacent to each other.

The steering angle θ of the laser beam may increase as the change rate of the pitch P between the nanopillars 10 increases.

For example, the nanopillars 10 may form, on the basis of the pitch P therebetween, a first pattern having a first change rate. Also, the nanopillars 10 may form, on the basis of the pitch P therebetween, a second pattern having a second change rate which is lower than the first change rate.

In this case, a first steering angle due to the first pattern may be larger than a second steering angle due to the second pattern.

Meanwhile, the above-described laser beam steering principle according to a change in the pitch P between the nanopillars 10 may be similarly applied even when the number of nanopillars 10 per unit length changes.

For example, when the number of nanopillars 10 per unit length changes, a laser beam emitted from the laser emitting unit 100 may be steered in a direction between a first direction in which the laser beam is emitted from the laser emitting unit 100 and a second direction in which the number of nanopillars 10 per unit length increases.

Meanwhile, the plurality of nanopillars 10 may form nanopatterns on the basis of a change in a height H of the nanopillars 10.

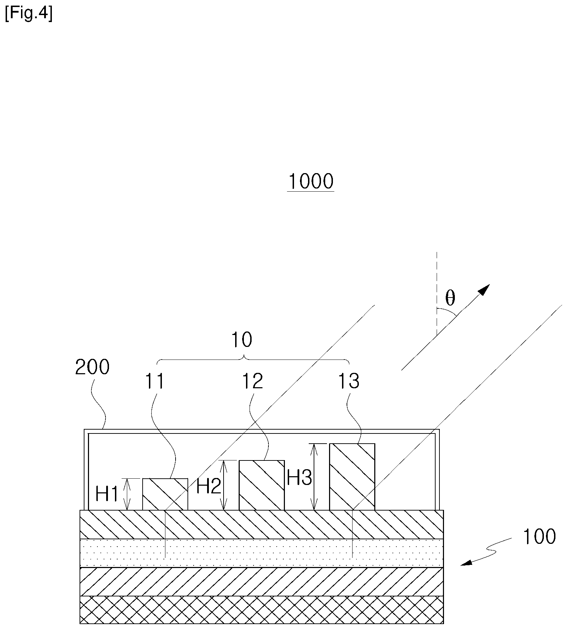

FIG. 4 is a cross-sectional view for describing beam steering according to a change in a height H of the nanopillars 10. Referring to FIG. 4, a laser emitting device 1000 may include a laser emitting unit 100 and a beam steering unit 200. The beam steering unit 200 may include a plurality of nanopillars 10.

The laser emitting unit 100 of FIG. 4 may correspond to the laser emitting unit 100 described above with reference to FIGS. 1 and 2. Accordingly, detailed description thereof will be omitted, and differences from the laser emitting device 1000 of FIG. 2 will be mainly described.

According to an embodiment, heights H1, H2, and H3 of the plurality of nanopillars 10 may gradually increase in one direction. A laser beam emitted from the laser emitting unit 100 may be steered in a direction in which the height H of the nanopillars 10 increases.

For example, the beam steering unit 200 may include a first nanopillar 11 having a first height H1, a second nanopillar 12 having a second height H2, and a third nanopillar 13 having a third height H3. The third height H3 may be higher than the first height H1 and the second height H2. The second height H2 may be higher than the first height H1. That is, the height H of the nanopillars 10 may gradually increase from the first nanopillar 11 to the third nanopillar 13. In this case, a laser beam emitted from the laser emitting unit 100 may be steered in a direction between a first direction in which the laser beam is emitted from the laser emitting unit 100 and a second direction from the first nanopillar 11 to the third nanopillar 13.

The steering angle θ of the laser beam may vary according to the height H of the nanopillars 10.

Specifically, the steering angle θ of the laser beam may vary according to a change rate of the height H of the nanopillars 10. Here, the change rate of the height H of the nanopillars 10 may refer to a numerical value indicating, on average, a degree of change in the height H of the nanopillars 10 adjacent to each other.

The change rate of the height H of the nanopillars 10 may be calculated on the basis of a difference between the first height H1 and the second height H2 and a difference between the second height H2 and the third height H3. The difference between the first height H1 and the second height H2 may be different from the difference between the second height H2 and the third height H3.

The steering angle θ of the laser beam may increase as the change rate of the height H of the nanopillars 10 increases.

For example, the nanopillars 10 may form, on the basis of the height H thereof, a first pattern having a first change rate. Also, the nanopillars 10 may form, on the basis of the height H thereof, a second pattern having a second change rate which is lower than the first change rate.

In this case, a first steering angle due to the first pattern may be larger than a second steering angle due to the second pattern.

Meanwhile, although in FIGS. 2 to 4, the first to fourth nanopillars 11, 12, 13, and 14 are illustrated as being formed as one set on the laser emitting unit 100, a plurality of sets of nanopillars 10 may also form nanopatterns on a single laser emitting unit 100. For example, a new nanopattern in which the nanopatterns formed in FIGS. 2 to 4 are repeated may be formed on the laser emitting unit 100.

Also, the nanopatterns formed in FIGS. 2 to 4 may be formed in combination with each other on a single laser emitting unit 100.

Hereinafter, a laser emitting device having various nanopatterns and laser beam steering according to the nanopatterns will be described.

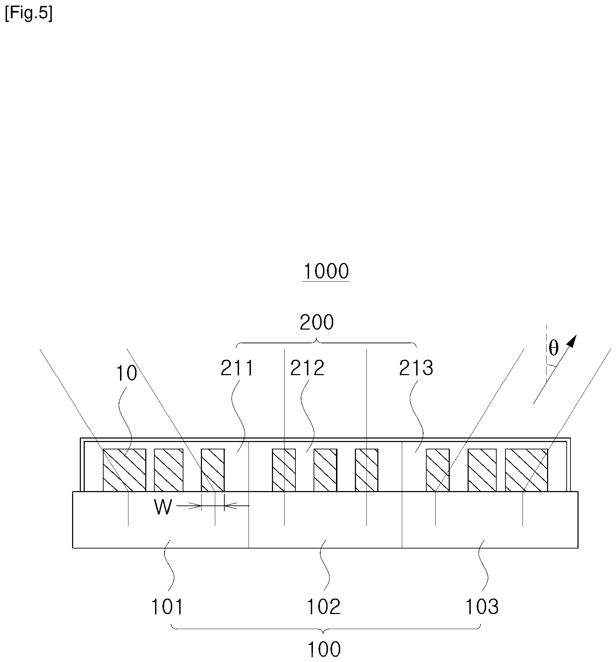

FIG. 5 is a cross-sectional view for describing a laser emitting device 1000 according to an embodiment. Referring to FIG. 5, the laser emitting device 1000 may include a plurality of laser emitting units 101, 102, and 103. Also, the laser emitting device 1000 may include a beam steering unit 200 including a plurality of nanopillars 10.

Laser beams emitted from the plurality of laser emitting units 101, 102, and 103 may be steered by the plurality of nanopillars 10 disposed on the plurality of laser emitting units 101, 102, and 103.

Each configuration of the laser emitting device 1000 will be described in detail below.

The laser emitting device 1000 may include a first laser emitting unit 101, a second laser emitting unit 102, and a third laser emitting unit 103. Meanwhile, the first to third laser emitting units 101, 102, and 103 may correspond to the laser emitting unit 100 described above with reference to FIGS. 1 and 2. Accordingly, detailed description thereof will be omitted.

The laser emitting unit 100 may be provided in the form of an array. For example, the laser emitting unit 100 may be provided in the form of a 1×3 array. In this case, the first to third laser emitting units 101, 102, and 103 may be respectively disposed in a first column to a third column of an array.

The first to third laser emitting units 101, 102, and 103 may emit a laser beam in the same direction. For example, the first to third laser emitting units 101, 102, and 103 may emit a laser beam in a direction perpendicular to an emission surface of the laser emitting device 1000.

The beam steering unit 200 may be provided in the form of an array. The beam steering unit 200 may include a plurality of beam steering cells. The beam steering cells may include a first beam steering cell 211, a second beam steering cell 212, and a third beam steering cell 213. The plurality of beam steering cells may be arranged in the form of an array.

The first to third beam steering cells 211, 212, and 213 may control phases of laser beams emitted from the plurality of laser emitting units 101, 102, and 103, respectively, to change irradiation directions of the laser beams.

Also, the first to third beam steering cells 211, 212, and 213 may control transmittances of laser beams emitted from the plurality of laser emitting units 101, 102, and 103, respectively, to change irradiation directions of the laser beams.

Each of the first to third beam steering cells 211, 212, and 213 may include the plurality of nanopillars 10 forming nanopatterns. A laser beam emitted from the laser emitting unit 100 may be steered by the nanopillars 10.

The nanopillars 10 may steer a laser beam emitted from the laser emitting unit 100 to form laser beams of various shapes.

For example, the nanopillars 10 may form a laser beam having a shape diverging from a center of the laser emitting unit 100. As another example, the nanopillars 10 may form a laser beam having a shape converging toward an irradiation path of laser beams emitted from the laser emitting unit 100 disposed at the center of the array. As still another example, the nanopillars 10 may form a laser beam irradiated in a direction perpendicular to a support surface of the laser emitting device 1000.

Hereinafter, for convenience of description, the case in which a laser beam steered by the nanopillars 10 has a form of diverging from the center of the laser emitting unit 100 will be mainly described.

Meanwhile, the plurality of nanopillars 10 may form nanopatterns on the basis of locations of beam steering cells. For example, the nanopillars 10 may form nanopatterns that cause a steering angle θ due to a beam steering cell far from the center of the beam steering unit 200 to be larger than a steering angle θ due to a beam steering cell close to the center of the beam steering unit 200.

Such nanopatterns may be formed on the basis of above-described width W of the nanopillars 10, pitch P between the nanopillars 10, and height H of the nanopillars 10.

Referring to FIG. 5, the nanopillars 10 may form nanopatterns on the basis of a change in the width W thereof and locations of the beam steering cells.

Specifically, the second beam steering cell 212 located at a central portion of the beam steering unit 200 may include a plurality of nanopillars 10 having the same width W.

Also, the first beam steering cell 211 located farther from the center of the beam steering unit 200 than the second beam steering cell 212 may include a plurality of nanopillars 10 whose width W gradually increases away from the center of the beam steering unit 200.

Likewise, the third beam steering cell 213 located farther from the center of the beam steering unit 200 than the second beam steering cell 212 may include a plurality of nanopillars 10 whose width W gradually increases away from the center of the beam steering unit 200.

Accordingly, the beam steering unit 200 may form a laser beam having a diverging shape.

Meanwhile, a first steering angle of the first beam steering cell located far from the center of the beam steering unit 200 may be larger than a second steering angle of the second beam steering cell located close to the center of the beam steering unit 200.

In this case, a change rate of a width W of the nanopillars 10 included in the first beam steering cell may be higher than a change rate of a width W of the nanopillars 10 included in the second beam steering cell.

Meanwhile, in FIG. 5, laser beams steered by the first beam steering cell 211 and the third beam steering cell 213 are each illustrated as not crossing an extension line extending in an emission direction of a laser beam steered by the second beam steering cell 212. However, embodiments are not limited thereto, and the laser beams steered by the first beam steering cell 211 and the third beam steering cell 213, may also each cross the extension line.

Accordingly, the laser beam steered by the first beam steering cell 211 may be steered in a direction between a first direction in which the laser beam is emitted from the laser emitting unit 100 and a second direction from the first beam steering cell 211 to the center of the beam steering unit 200.

Likewise, the laser beam steered by the third beam steering cell 213 may be steered in a direction between a third direction in which the laser beam is emitted from the laser emitting unit 100 and a fourth direction from the third beam steering cell 213 to the center of the beam steering unit 200.

Meanwhile, the plurality of nanopillars 10 forming nanopatterns may form patterns which are symmetrical about the center of the beam steering unit 200. For example, a first nanopattern formed by the nanopillars 10 included in the first beam steering cell 211 and a third nanopattern formed by the nanopillars 10 included in the third beam steering cell 213 may be symmetrical to each other.

Accordingly, the first steering angle due to the first beam steering cell 211 may be equal in size to the third steering angle due to the third beam steering cell 213.

Meanwhile, the shapes of the nanopillars 10 included in the plurality of beam steering cells may be different from each other. For example, the nanopillars 10 included in the first beam steering cell 211 may have a cylindrical shape, and the nanopillars 10 included in the second beam steering cell 212 may have a polygonal column shape.

Also, the shapes of the plurality of nanopillars 10 included in the same beam steering cell may be different from each other. For example, some of the plurality of nanopillars 10 included in the first beam steering cell 211 may have a cylindrical shape, and the remaining nanopillars 10 may have a polygonal column shape.

Meanwhile, steering angles θ of the plurality of beam steering cells may be different from each other. For example, the first steering angle of the first beam steering cell 211 and a third steering angle of the third beam steering cell 213 may be different from each other.

Meanwhile, the plurality of laser emitting units 100 may be controlled independently. For example, attributes (wavelength, intensity, shooting cycle, and the like) of laser beams emitted from each of the laser emitting units 100 may be different. Also, the on/off state of each of the laser emitting units 100 may be controlled separately.

For example, the laser emitting unit 100 may include a plurality of VCSEL elements arranged in the form of an array. In this case, the on/off states of the plurality of VCSEL elements may be controlled independently. That is, the laser emitting unit 100 may include an addressable VCSEL array.

The laser emitting device 1000 may adjust the on/off state and intensity of each of the plurality of laser emitting units 100 to adjust steering angles of laser beams.

Alternatively, the plurality of laser emitting units 100 may be linked. For example, the on/off states of the first laser emitting unit 101 and the second laser emitting unit 102 may be controlled together.

The laser emitting device 1000 may emit laser beams of various wavelengths. For example, the first laser emitting unit 101 may emit a first laser beam having a first wavelength, and the second laser emitting unit 102 may emit a second laser beam having a second wavelength.

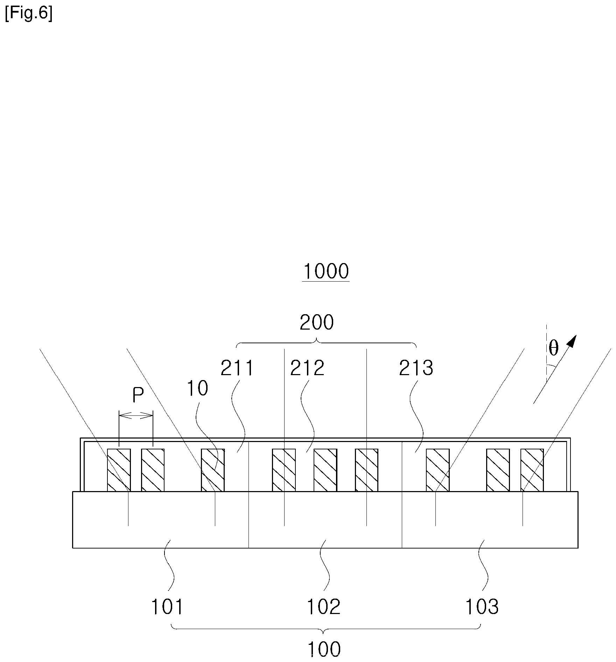

FIG. 6 is a cross-sectional view for describing a laser emitting device 1000 according to another embodiment. Referring to FIG. 6, the laser emitting device 1000 may include a plurality of laser emitting units 100. Also, the laser emitting device 1000 may include a beam steering unit 200 including a plurality of nanopillars 10. The beam steering unit 200 may include a plurality of beam steering cells.

Laser beams emitted from the plurality of laser emitting units 100 may be steered by a plurality of nanopillars 10 included in the plurality of beam steering cells.

Each configuration of the laser emitting device 1000 will be described in detail below.

The laser emitting device 1000 may include a first laser emitting unit 101, a second laser emitting unit 102, and a third laser emitting unit 103. The beam steering cells may include a first beam steering cell 211, a second beam steering cell 212, and a third beam steering cell 213.

Meanwhile, the first to third laser emitting units 101, 102, and 103 may correspond to the laser emitting unit100 described above with reference to FIGS. 1, 2, and 5. Accordingly, detailed description thereof will be omitted, and differences from the laser emitting device 1000 of FIG. 5 will be mainly described.

Referring to FIG. 6, the nanopillars 10 may form nanopatterns on the basis of a change in a pitch P therebetween and locations of the beam steering cells.

Specifically, the second beam steering cell 212 located at the central portion of the beam steering unit 200 may include a plurality of nanopillars 10 disposed at equal pitches P.

Also, the first beam steering cell 211 located farther from the center of the beam steering unit 200 than the second beam steering cell 212 may include a plurality of nanopillars 10 which are disposed at a pitch P which gradually increases away from the center of the beam steering unit 200.

Likewise, the third beam steering cell 213 located farther from the center of the beam steering unit 200 than the second beam steering cell 212 may include a plurality of nanopillars 10 which are disposed at a pitch P which gradually increases away from the center of the beam steering unit 200.

Accordingly, the beam steering unit 200 may form a laser beam having a diverging shape.

Meanwhile, a first steering angle of the first beam steering cell located far from the center of the beam steering unit 200 may be larger than a second steering angle of the second beam steering cell located close to the beam steering unit 200.

In this case, a change rate of a pitch P between the nanopillars 10 included in the first beam steering cell may be higher than a change rate of a pitch P between the nanopillars 10 included in the second beam steering cell.

Meanwhile, the above-described laser beam steering principle according to a change in the pitch P between the nanopillars 10 may be similarly applied even when the number of nanopillars 10 per unit length changes.

For example, the plurality of nanopillars 10 included in the first beam steering cell 211 may form a nanopattern in which the number of nanopillars 10 per unit length gradually increases away from the center of the beam steering unit 200.

Likewise, the plurality of nanopillars 10 included in the third beam steering cell 213 may form a nanopattern in which the number of nanopillars 10 per unit length gradually increases away from the center of the beam steering unit 200.

Also, the plurality of nanopillars 10 included in the second beam steering cell 212 located at the central portion of the beam steering unit 200 may form a nanopattern in which the number of nanopillars 10 per unit length is constant.

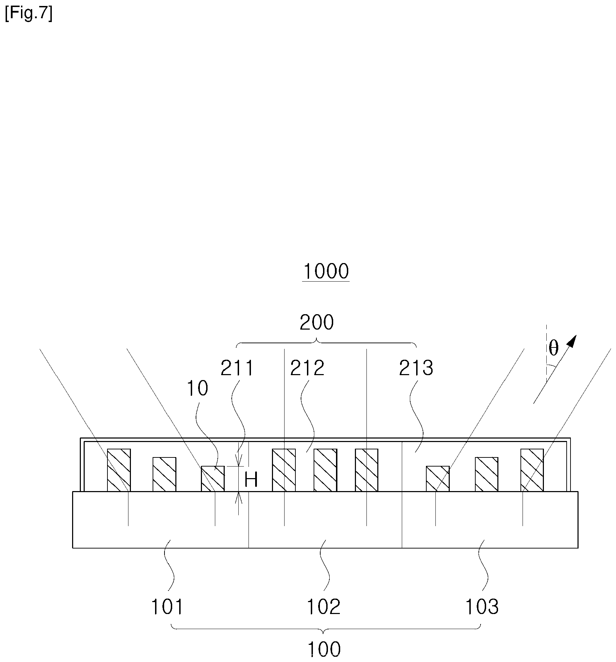

FIG. 7 is a cross-sectional view for describing a laser emitting device 1000 according to still another embodiment. Referring to FIG. 7, the laser emitting device 1000 may include a plurality of laser emitting units 100. Also, the laser emitting device 1000 may include a beam steering unit 200 including a plurality of nanopillars 10. The beam steering unit 200 may include a plurality of beam steering cells.

Laser beams emitted from the plurality of laser emitting units 100 may be steered by a plurality of nanopillars 10 included in the plurality of beam steering cells.

Each configuration of the laser emitting device 1000 will be described in detail below.

The laser emitting device 1000 may include a first laser emitting unit 101, a second laser emitting unit 102, and a third laser emitting unit 103. The beam steering cells may include a first beam steering cell 211, a second beam steering cell 212, and a third beam steering cell 213.

Meanwhile, the first to third laser emitting units 101, 102, and 103 may correspond to the laser emitting unit100 described above with reference to FIGS. 1, 2, and 5. Accordingly, detailed description thereof will be omitted, and differences from the laser emitting device 1000 of FIG. 5 will be mainly described.

Referring to FIG. 7, the nanopillars 10 may form nanopatterns on the basis of a change in a height H thereof and locations of the beam steering cells.

Specifically, the second beam steering cell 212 located at the central portion of the beam steering unit 200 may include a plurality of nanopillars 10 having the same height H.

Also, the first beam steering cell 211 located farther from the center of the beam steering unit 200 than the second beam steering cell 212 may include a plurality of nanopillars 10 whose height H gradually increases away from the center of the beam steering unit 200.

Likewise, the third beam steering cell 213 located farther from the center of the beam steering unit 200 than the second beam steering cell 212 may include a plurality of nanopillars 10 whose height H gradually increases away from the center of the beam steering unit 200.

Accordingly, the beam steering unit 200 may form a laser beam having a diverging shape.

Meanwhile, a first steering angle of the first beam steering cell located far from the center of the beam steering unit 200 may be larger than a second steering angle of the second beam steering cell located close to the center of the beam steering unit 200.

In this case, a change rate of a height H of the nanopillars 10 included in the first beam steering cell may be higher than a change rate of a height H of the nanopillars 10 included in the second beam steering cell.

Meanwhile, for convenience of description, nanopillars 10 have been described as forming nanopatterns by using only one of above attributes W, P, and H. However, embodiments are not limited thereto, and the nanopillars 10 may form nanopatterns by using more than one of the attributes. For example, the plurality of nanopillars 10 included in the first beam steering cell 211 may form nanopatterns on the basis of a change in the width W thereof, and the plurality of nanopillars 10 included in the third beam steering cell 213 may form nanopatterns on the basis of a change in the pitch P therebetween.

Also, the plurality of nanopillars 10 may form nanopatterns on a single beam steering cell by using multiple attributes. For example, the plurality of nanopillars 10 included in the first beam steering cell 211 may form nanopatterns on the basis of changes in the width W thereof and the pitch P therebetween.

Meanwhile, although in FIGS. 5 to 7, the plurality of nanopillars 10 forming nanopatterns are illustrated as having shapes symmetrical about the center of the array, the nanopatterns may also have asymmetrical shapes. Accordingly, a first steering angle of the first beam steering cell 211 may be different from a third steering angle of a laser beam emitted from the third beam steering cell 213.

Also, the plurality of nanopillars 10 included in each of the plurality of beam steering cells may form the same nanopattern. Accordingly, laser beams emitted from the plurality of laser emitting units 100 may be steered in the same direction.

Meanwhile, although it is illustrated in FIGS. 5 to 7 that a single nanopattern is formed in each beam steering cell, nanopatterns in which the same pattern is repeated may also be formed in a single beam steering cell.

Meanwhile, the second beam steering cell 212 may not include the nanopillars 10. Accordingly, a laser beam passing through the second beam steering cell 212 may be irradiated in a direction which is the same as an emission direction in which the laser beam is emitted from the laser emitting unit 100.

Hereinafter, beam steering by beam steering cells arranged in the form of a two-dimensional array will be described.

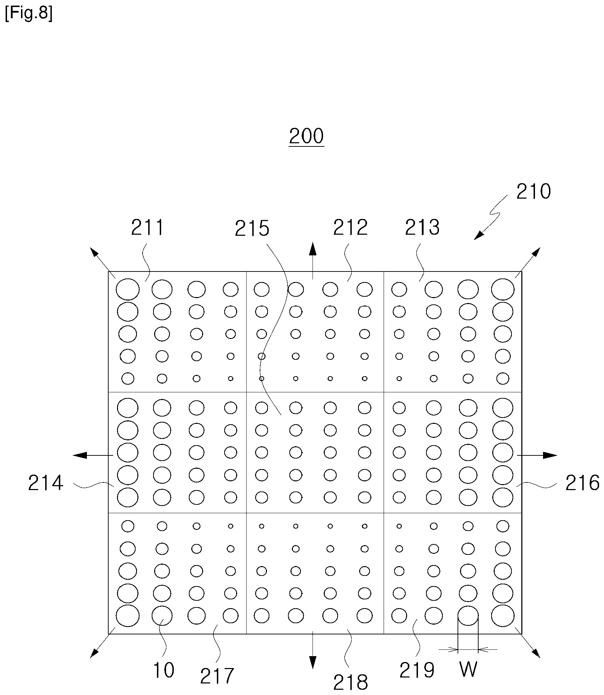

FIG. 8 is a view for describing a beam steering unit according to an embodiment.

Referring to FIG. 8, a beam steering unit 200 may include a plurality of beam steering cells 210 and a plurality of nanopillars 10. The beam steering cells 210 may include first to ninth beam steering cells 211, 212, 213, 214, 215, 216, 217, 218, and 219.

The beam steering cells 210 according to an embodiment may be provided in the form of a two-dimensional array. For example, laser emitting units 100 may be provided in the form of a 3×3 array. The first to ninth beam steering cells 211, 212, 213, 214, 215, 216, 217, 218, and 219 may be arranged in the two-dimensional array in a row direction corresponding to a vertical direction and a column direction corresponding to a horizontal direction.

The beam steering cells 210 may use a plurality of nanopillars 10 forming nanopatterns to steer laser beams emitted from the laser emitting units.

The beam steering cells 210 may steer the laser beams emitted from the laser emitting units 100 to form laser beams of various shapes.

For example, the beam steering cells 210 may form a laser beam having a shape diverging from the center of the laser emitting unit 100.

The plurality of nanopillars 10 may form nanopatterns on the basis of locations of the beam steering cells 210. For example, the plurality of nanopillars 10 may form a nanopattern in which a width W thereof gradually increases away from the center of the beam steering unit 200. Accordingly, laser beams emitted from the laser emitting unit 100 may have a shape diverging from the center of the beam steering unit 200.

Referring to FIG. 8, the plurality of nanopillars 10 may form nanopatterns on the basis of locations of the beam steering cells 210.

For example, a plurality of nanopillars 10 included in the fifth beam steering cell 215 located at the central portion of the beam steering unit 200 may have the same size and be disposed at constant pitches. Accordingly, a laser beam steered by the fifth beam steering cell 215 may pass the nanopillars 10, which are disposed as above, as it is without being refracted by the nanopillars 10.

Meanwhile, the fifth beam steering cell 215 may not include the nanopillars 10. Accordingly, a laser beam emitted from the laser emitting unit 100 may pass through the fifth beam steering cell 215 while an emission direction of the laser beam is maintained.

The fourth beam steering cell 214 may be disposed in the same row as the fifth beam steering cell 215 but in a column that is further to the left than a column in which the fifth beam steering cell 215 is disposed. In this case, a plurality of nanopillars 10 included in the fourth beam steering cell 214 may form a nanopattern in which a width W thereof gradually increases away from the center of the beam steering unit 200. Accordingly, a steering direction of the fourth beam steering cell 214 may be the same as a direction from the center of the beam steering unit 200 toward the fourth beam steering cell 214.

Likewise, a plurality of nanopillars 10 included in the sixth beam steering cell 216, which is disposed in the same row as the fifth beam steering cell 215 but in a column that is further to the right than the column in which the fifth beam steering cell 215 is disposed, may form a nanopattern in which a width W thereof gradually increases away from the center of the beam steering unit 200. Accordingly, a steering direction of the sixth beam steering cell 216 may be the same as a direction from the center of the beam steering unit 200 toward the sixth beam steering cell 216.

Meanwhile, when the fourth beam steering cell 214 and the sixth beam steering cell 216 are disposed to be symmetrical about the center of the beam steering unit 200, steering angles of the fourth beam steering cell 214 and the sixth beam steering cell 216 may be equal in size.

The second beam steering cell 212 may be disposed in the same column as the fifth beam steering cell 215 but in a row that is further to the top than a row in which the fifth beam steering cell 215 is disposed. In this case, a plurality of nanopillars 10 included in the second beam steering cell 212 may form a nanopattern in which a width W thereof gradually increases away from the center of the beam steering unit 200. Accordingly, a steering direction of the second beam steering cell 212 may be the same as a direction from the center of the beam steering unit 200 toward the second beam steering cell 212.

Likewise, a plurality of nanopillars 10 included in the eighth beam steering cell 218, which is disposed in the same column as the fifth beam steering cell 215 but in a row that is further to the bottom than the row in which the fifth beam steering cell 215 is disposed, may form a nanopattern in which a width W thereof gradually increases away from the center of the beam steering unit 200. Accordingly, a steering direction of the eighth beam steering cell 218 may be the same as a direction from the center of the beam steering unit 200 toward the eighth beam steering cell 218.

Meanwhile, when the second beam steering cell 212 and the eighth beam steering cell 218 are disposed to be symmetrical about the center of the beam steering unit 200, steering angles of the second beam steering cell 212 and the eighth beam steering cell 218 may be equal in size.

The first beam steering cell 211 may be disposed at an upper left side of the fifth beam steering cell 215. In this case, the plurality of nanopillars 10 included in the first beam steering cell 211 may form a nanopattern in which a width W thereof gradually increases away from the center of the beam steering unit 200. Accordingly, a steering direction of the first beam steering cell 211 may be the same as a direction from the center of the beam steering unit 200 toward the first beam steering cell 211.

The third beam steering cell 213 may be disposed at an upper right side of the fifth beam steering cell 215. In this case, the plurality of nanopillars 10 included in the third beam steering cell 213 may form a nanopattern in which a width W thereof gradually increases away from the center of the beam steering unit 200. Accordingly, a steering direction of the third beam steering cell 213 may be the same as a direction from the center of the beam steering unit 200 toward the third beam steering cell 213.

The seventh beam steering cell 217 may be disposed at a lower left side of the fifth beam steering cell 215. In this case, the plurality of nanopillars 10 included in the seventh beam steering cell 217 may form a nanopattern in which a width W thereof gradually increases away from the center of the beam steering unit 200. Accordingly, a steering direction of the seventh beam steering cell 217 may be the same as a direction from the center of the beam steering unit 200 toward the seventh beam steering cell 217.

The ninth beam steering cell 219 may be disposed at a lower right side of the fifth beam steering cell 215. In this case, the plurality of nanopillars 10 included in the ninth beam steering cell 219 may form a nanopattern in which a width W thereof gradually increases away from the center of the beam steering unit 200. Accordingly, a steering direction of the ninth beam steering cell 219 may be the same as a direction from the center of the beam steering unit 200 toward the ninth beam steering cell 219.

Meanwhile, nanopatterns formed by the plurality of nanopillars 10 included in the beam steering cells 210, which are spaced apart from the center of the beam steering unit 200 at equal distances, may be related to each other.

For example, the first beam steering cell 211 and the third beam steering cell 213 may be spaced apart from the center of the beam steering unit 200 at equal distances. In this case, the plurality of nanopillars 10 included in the first beam steering cell 211 may form a first nanopattern. Also, the plurality of nanopillars 10 included in the third beam steering cell 213 may form a third nanopattern.

In this case, when the first nanopattern is rotated by a predetermined angle about the center of the beam steering unit 200 as an axis, the first nanopattern and the third nanopattern may have the same shape. The predetermined angle may be obtained on the basis of locations of the first beam steering cell 211 and the third beam steering cell 213 relative to the center of the beam steering unit 200.

Meanwhile, a beam steering unit 200 according to another embodiment may steer a laser beam on the basis of a change in a pitch P between nanopillars 10, i.e., the number of nanopillars 10 per unit length.

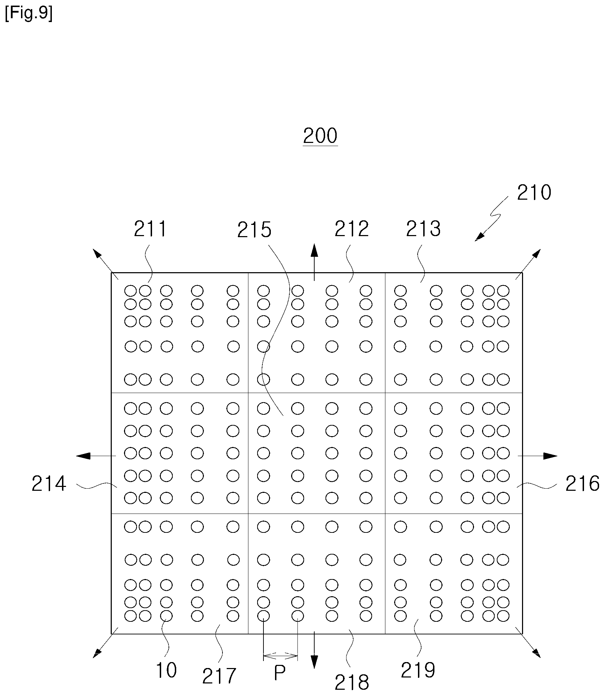

FIG. 9 is a view for describing a beam steering unit according to another embodiment.

Referring to FIG. 9, a beam steering unit 200 may include a plurality of beam steering cells 210 and a plurality of nanopillars 10. The beam steering cells 210 may include first to ninth beam steering cells 211, 212, 213, 214, 215, 216, 217, 218, and 219.

The beam steering cells 210 according to an embodiment may be provided in the form of a two-dimensional array. For example, laser emitting units 100 may be provided in the form of a 3×3 array. The first to ninth beam steering cells 211, 212, 213, 214, 215, 216, 217, 218, and 219 may be arranged in the two-dimensional array in a row direction corresponding to the vertical direction and a column direction corresponding to the horizontal direction.

The plurality of nanopillars 10 may form nanopatterns on the basis of locations of the beam steering cells 210. For example, the plurality of nanopillars 10 may form a nanopattern in which a pitch P therebetween gradually decreases away from the center of the beam steering unit 200. Alternatively, the plurality of nanopillars 10 may form a nanopattern in which the number of nanopillars 10 per unit length gradually increases away from the center of the beam steering unit 200. Accordingly, a laser beam emitted from the laser emitting unit 100 may have a shape diverging from the center of the beam steering unit 200.

Referring to FIG. 9, the plurality of nanopillars 10 may form nanopatterns on the basis of locations of the beam steering cells 210.

For example, a plurality of nanopillars 10 included in the fifth beam steering cell 215 located at the central portion of the beam steering unit 200 may have the same size and be disposed at constant pitches. Accordingly, a laser beam steered by the fifth beam steering cell 215 may pass the nanopillars 10, which are disposed as above, as it is without being refracted by the nanopillars 10.

Meanwhile, the fifth beam steering cell 215 may not include the nanopillars 10. Accordingly, a laser beam emitted from the laser emitting unit 100 may pass through the fifth beam steering cell 215 while an emission direction of the laser beam is maintained.

The fourth beam steering cell 214 may be disposed in the same row as the fifth beam steering cell 215 but in a column that is further to the left than a column in which the fifth beam steering cell 215 is disposed. In this case, a plurality of nanopillars 10 included in the fourth beam steering cell 214 may form a nanopattern in which a pitch P therebetween gradually decreases away from the center of the beam steering unit 200. Accordingly, a steering direction of the fourth beam steering cell 214 may be the same as a direction from the center of the beam steering unit 200 toward the fourth beam steering cell 214.

Likewise, a plurality of nanopillars 10 included in the sixth beam steering cell 216, which is disposed in the same row as the fifth beam steering cell 215 but in a column that is further to the right than the column in which the fifth beam steering cell 215 is disposed, may form a nanopattern in which a pitch P therebetween gradually decreases away from the center of the beam steering unit 200. Accordingly, a steering direction of the sixth beam steering cell 216 may be the same as a direction from the center of the beam steering unit 200 toward the sixth beam steering cell 216.

Meanwhile, when the fourth beam steering cell 214 and the sixth beam steering cell 216 are disposed to be symmetrical about the center of the beam steering unit 200, steering angles of the fourth beam steering cell 214 and the sixth beam steering cell 216 may be equal in size.

The second beam steering cell 212 may be disposed in the same column as the fifth beam steering cell 215 but in a row that is further to the top than a row in which the fifth beam steering cell 215 is disposed. In this case, a plurality of nanopillars 10 included in the second beam steering cell 212 may form a nanopattern in which a pitch P therebetween gradually decreases away from the center of the beam steering unit 200. Accordingly, a steering direction of the second beam steering cell 212 may be the same as a direction from the center of the beam steering unit 200 toward the second beam steering cell 212.

Likewise, a plurality of nanopillars 10 included in the eighth beam steering cell 218, which is disposed in the same column as the fifth beam steering cell 215 but in a row that is further to the bottom than the row in which the fifth beam steering cell 215 is disposed, may form a nanopattern in which a pitch P therebetween gradually decreases away from the center of the beam steering unit 200. Accordingly, a steering direction of the eighth beam steering cell 218 may be the same as a direction from the center of the beam steering unit 200 toward the eighth beam steering cell 218.

Meanwhile, when the second beam steering cell 212 and the eighth beam steering cell 218 are disposed to be symmetrical about the center of the beam steering unit 200, steering angles of the second beam steering cell 212 and the eighth beam steering cell 218 may be equal in size.

The first beam steering cell 211 may be disposed at an upper left side of the fifth beam steering cell 215. In this case, the plurality of nanopillars 10 included in the first beam steering cell 211 may form a nanopattern in which a pitch P therebetween gradually decreases away from the center of the beam steering unit 200. Accordingly, a steering direction of the first beam steering cell 211 may be the same as a direction from the center of the beam steering unit 200 toward the first beam steering cell 211.

The third beam steering cell 213 may be disposed at an upper right side of the fifth beam steering cell 215. In this case, the plurality of nanopillars 10 included in the third beam steering cell 213 may form a nanopattern in which a pitch P therebetween gradually decreases away from the center of the beam steering unit 200. Accordingly, a steering direction of the third beam steering cell 213 may be the same as a direction from the center of the beam steering unit 200 toward the third beam steering cell 213.

The seventh beam steering cell 217 may be disposed at a lower left side of the fifth beam steering cell 215. In this case, the plurality of nanopillars 10 included in the seventh beam steering cell 217 may form a nanopattern in which a pitch P therebetween gradually decreases away from the center of the beam steering unit 200. Accordingly, a steering direction of the seventh beam steering cell 217 may be the same as a direction from the center of the beam steering unit 200 toward the seventh beam steering cell 217.

The ninth beam steering cell 219 may be disposed at a lower right side of the fifth beam steering cell 215. In this case, the plurality of nanopillars 10 included in the ninth beam steering cell 219 may form a nanopattern in which a pitch P therebetween gradually decreases away from the center of the beam steering unit 200. Accordingly, a steering direction of the ninth beam steering cell 219 may be the same as a direction from the center of the beam steering unit 200 toward the ninth beam steering cell 219.

Meanwhile, nanopatterns formed by the plurality of nanopillars 10 included in the beam steering cells 210, which are spaced apart from the center of the beam steering unit 200 at equal distances, may be related to each other.

For example, the first beam steering cell 211 and the third beam steering cell 213 may be spaced apart from the center of the beam steering unit 200 at equal distances. In this case, the plurality of nanopillars 10 included in the first beam steering cell 211 may form a first nanopattern. Also, the plurality of nanopillars 10 included in the third beam steering cell 213 may form a third nanopattern.

In this case, when the first nanopattern is rotated by a predetermined angle about the center of the beam steering unit 200 as an axis, the first nanopattern and the third nanopattern may have the same shape. The predetermined angle may be obtained on the basis of locations of the first beam steering cell 211 and the third beam steering cell 213 relative to the center of the beam steering unit 200.

Meanwhile, a beam steering unit 200 according to still another embodiment may steer a laser beam on the basis of a change in a height H of the nanopillars 10.

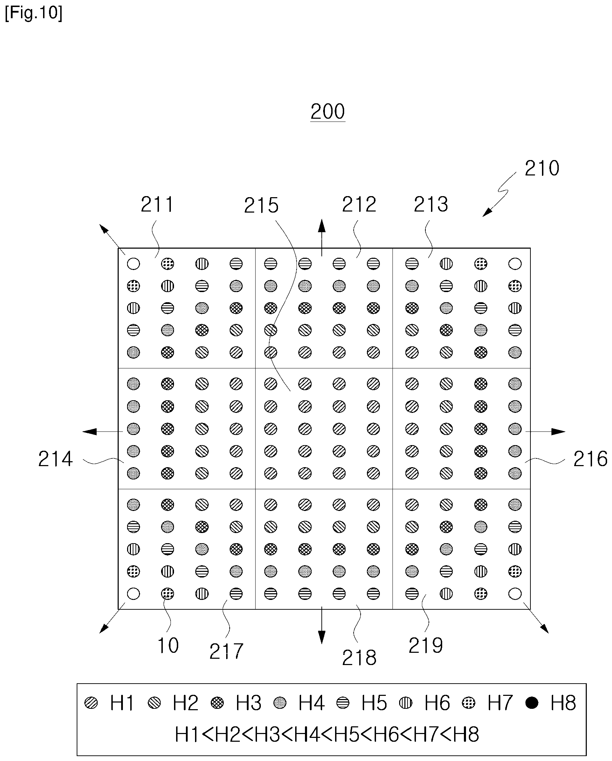

FIG. 10 is a view for describing a beam steering unit according to still another embodiment.

Referring to FIG. 10, a beam steering unit 200 may include a plurality of beam steering cells 210 and a plurality of nanopillars 10. The beam steering cells 210 may include first to ninth beam steering cells 211, 212, 213, 214, 215, 216, 217, 218, and 219.

The beam steering cells 210 according to an embodiment may be provided in the form of a two-dimensional array. For example, laser emitting units 100 may be provided in the form of a 3×3 array. The first to ninth beam steering cells 211, 212, 213, 214, 215, 216, 217, 218, and 219 may be arranged in the two-dimensional array in a row direction corresponding to the vertical direction and a column direction corresponding to the horizontal direction.

The plurality of nanopillars 10 may form nanopatterns on the basis of locations of the beam steering cells 210. For example, the plurality of nanopillars 10 may form a nanopattern in which a height H thereof gradually increases away from the center of the beam steering unit 200. Accordingly, laser beams emitted from the laser emitting unit 100 may have a shape diverging from the center of the beam steering unit 200.

As illustrated in FIG. 10, first to eighth heights H1, H2, H3, H4, H5, H6, H7, and H8 may have values gradually increasing from the first height H1 to the eighth height H8.

Referring to FIG. 10, the plurality of nanopillars 10 may form nanopatterns on the basis of locations of the beam steering cells 210.

For example, a plurality of nanopillars 10 included in the fifth beam steering cell 215 located at the central portion of the beam steering unit 200 may have the same size and be disposed at constant pitches. Accordingly, a laser beam steered by the fifth beam steering cell 215 may pass the nanopillars 10, which are disposed as above, as it is without being refracted by the nanopillars 10.

Meanwhile, the fifth beam steering cell 215 may not include the nanopillars 10. Accordingly, a laser beam emitted from the laser emitting unit 100 may pass through the fifth beam steering cell 215 while an emission direction of the laser beam is maintained.

The fourth beam steering cell 214 may be disposed in the same row as the fifth beam steering cell 215 but in a column that is further to the left than a column in which the fifth beam steering cell 215 is disposed. In this case, a plurality of nanopillars 10 included in the fourth beam steering cell 214 may form a nanopattern in which a height H thereof gradually increases away from the center of the beam steering unit 200. Accordingly, a steering direction of the fourth beam steering cell 214 may be the same as a direction from the center of the beam steering unit 200 toward the fourth beam steering cell 214.

Likewise, a plurality of nanopillars 10 included in the sixth beam steering cell 216, which is disposed in the same row as the fifth beam steering cell 215 but in a column that is further to the right than the column in which the fifth beam steering cell 215 is disposed, may form a nanopattern in which a height H thereof gradually increases away from the center of the beam steering unit 200. Accordingly, a steering direction of the sixth beam steering cell 216 may be the same as a direction from the center of the beam steering unit 200 toward the sixth beam steering cell 216.

Meanwhile, when the fourth beam steering cell 214 and the sixth beam steering cell 216 are disposed to be symmetrical about the center of the beam steering unit 200, steering angles of the fourth beam steering cell 214 and the sixth beam steering cell 216 may be equal in size.

The second beam steering cell 212 may be disposed in the same column as the fifth beam steering cell 215 but in a row that is further to the top than a row in which the fifth beam steering cell 215 is disposed. In this case, a plurality of nanopillars 10 included in the second beam steering cell 212 may form a nanopattern in which a height H thereof gradually increases away from the center of the beam steering unit 200. Accordingly, a steering direction of the second beam steering cell 212 may be the same as a direction from the center of the beam steering unit 200 toward the second beam steering cell 212.

Likewise, a plurality of nanopillars 10 included in the eighth beam steering cell 218, which is disposed in the same column as the fifth beam steering cell 215 but in a row that is further to the bottom than the row in which the fifth beam steering cell 215 is disposed, may form a nanopattern in which a height H thereof gradually increases away from the center of the beam steering unit 200. Accordingly, a steering direction of the eighth beam steering cell 218 may be the same as a direction from the center of the beam steering unit 200 toward the eighth beam steering cell 218.

Meanwhile, when the second beam steering cell 212 and the eighth beam steering cell 218 are disposed to be symmetrical about the center of the beam steering unit 200, steering angles of the second beam steering cell 212 and the eighth beam steering cell 218 may be equal in size.

The first beam steering cell 211 may be disposed at an upper left side of the fifth beam steering cell 215. In this case, the plurality of nanopillars 10 included in the first beam steering cell 211 may form a nanopattern in which a height H thereof gradually increases away from the center of the beam steering unit 200. Accordingly, a steering direction of the first beam steering cell 211 may be the same as a direction from the center of the beam steering unit 200 toward the first beam steering cell 211.

The third beam steering cell 213 may be disposed at an upper right side of the fifth beam steering cell 215. In this case, the plurality of nanopillars 10 included in the third beam steering cell 213 may form a nanopattern in which a height H thereof gradually increases away from the center of the beam steering unit 200. Accordingly, a steering direction of the third beam steering cell 213 may be the same as a direction from the center of the beam steering unit 200 toward the third beam steering cell 213.

The seventh beam steering cell 217 may be disposed at a lower left side of the fifth beam steering cell 215. In this case, the plurality of nanopillars 10 included in the seventh beam steering cell 217 may form a nanopattern in which a height H thereof gradually increases away from the center of the beam steering unit 200. Accordingly, a steering direction of the seventh beam steering cell 217 may be the same as a direction from the center of the beam steering unit 200 toward the seventh beam steering cell 217.

The ninth beam steering cell 219 may be disposed at a lower right side of the fifth beam steering cell 215. In this case, the plurality of nanopillars 10 included in the ninth beam steering cell 219 may form a nanopattern in which a height H thereof gradually increases away from the center of the beam steering unit 200. Accordingly, a steering direction of the ninth beam steering cell 219 may be the same as a direction from the center of the beam steering unit 200 toward the ninth beam steering cell 219.

Meanwhile, nanopatterns formed by the plurality of nanopillars 10 included in the beam steering cells 210, which are spaced apart from the center of the beam steering unit 200 at equal distances, may be related to each other.

For example, the first beam steering cell 211 and the third beam steering cell 213 may be spaced apart from the center of the beam steering unit 200 at equal distances. In this case, the plurality of nanopillars 10 included in the first beam steering cell 211 may form a first nanopattern. Also, the plurality of nanopillars 10 included in the third beam steering cell 213 may form a third nanopattern.

In this case, when the first nanopattern is rotated by a predetermined angle about the center of the beam steering unit 200 as an axis, the first nanopattern and the third nanopattern may have the same shape. The predetermined angle may be obtained on the basis of locations of the first beam steering cell 211 and the third beam steering cell 213 relative to the center of the beam steering unit 200.

Meanwhile, for convenience of description, nanopatterns formed on the basis of any one attribute of the width W, pitch P, and height H have been described above with reference to FIGS. 8 to 10.

Hereinafter, nanopatterns formed on the basis of multiple attributes will be described.

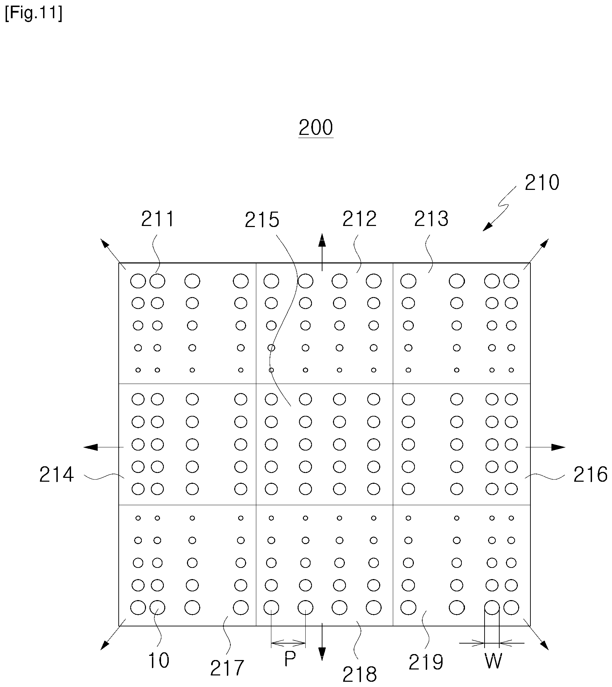

FIG. 11 is a view for describing a beam steering unit according to yet another embodiment.

Referring to FIG. 11, a beam steering unit 200 may include a plurality of beam steering cells 210 and a plurality of nanopillars 10. The beam steering cells 210 may include first to ninth beam steering cells 211, 212, 213, 214, 215, 216, 217, 218, and 219.

The beam steering cells 210 according to an embodiment may be provided in the form of a two-dimensional array. For example, laser emitting units 100 may be provided in the form of a 3×3 array. The first to ninth beam steering cells 211, 212, 213, 214, 215, 216, 217, 218, and 219 may be arranged in the two-dimensional array in a row direction corresponding to the vertical direction and a column direction corresponding to the horizontal direction.

The plurality of nanopillars 10 included in the beam steering cells 210 may form nanopatterns on the basis of a width W and a pitch P. Specifically, the plurality of nanopillars 10 may form nanopatterns on the basis of the width W in the row direction and on the basis of the pitch P in the column direction.

The plurality of nanopillars 10 may form nanopatterns on the basis of locations of the beam steering cells 210.

For example, the plurality of nanopillars 10 may form a nanopattern in which the width W of the plurality of nanopillars 10 gradually increases in a direction from the center of the beam steering unit 200 toward a location of a row in which the beam steering cell 210 including the plurality of nanopillars 10 is included.

Also, the plurality of nanopillars 10 may form a nanopattern in which the pitch P between the plurality of nanopillars 10 gradually decreases in a direction from the center of the beam steering unit 200 toward a location of a column in which the beam steering cell 210 including the plurality of nanopillars 10 is included. That is, the plurality of nanopillars 10 may form a nanopattern in which the number of nanopillars 10 per unit length gradually increases in a direction from the center of the beam steering unit 200 toward a location of a column in which the beam steering cell 210 including the plurality of nanopillars 10 is included.

For example, a plurality of nanopillars 10 included in the fifth beam steering cell 215 located at the central portion of the beam steering unit 200 may have the same size and be disposed at constant pitches. Accordingly, a laser beam steered by the fifth beam steering cell 215 may pass the nanopillars 10, which are disposed as above, as it is without being refracted by the nanopillars 10.

Meanwhile, the fifth beam steering cell 215 may not include the nanopillars 10. Accordingly, a laser beam emitted from the laser emitting unit 100 may pass through the fifth beam steering cell 215 while an emission direction of the laser beam is maintained.

The fourth beam steering cell 214 may be disposed in the same row as the fifth beam steering cell 215 but in a column that is further to the left than a column in which the fifth beam steering cell 215 is disposed. In this case, a plurality of nanopillars 10 included in the fourth beam steering cell 214 may form a nanopattern in which a pitch P therebetween gradually decreases away from the center of the beam steering unit 200. Accordingly, a steering direction of the fourth beam steering cell 214 may be the same as a direction from the center of the beam steering unit 200 toward the fourth beam steering cell 214.

Likewise, a plurality of nanopillars 10 included in the sixth beam steering cell 216, which is disposed in the same row as the fifth beam steering cell 215 but in a column that is further to the right than the column in which the fifth beam steering cell 215 is disposed, may form a nanopattern in which a pitch P therebetween gradually decreases away from the center of the beam steering unit 200. Accordingly, a steering direction of the sixth beam steering cell 216 may be the same as a direction from the center of the beam steering unit 200 toward the sixth beam steering cell 216.

Meanwhile, when the fourth beam steering cell 214 and the sixth beam steering cell 216 are disposed to be symmetrical about the center of the beam steering unit 200, steering angles of the fourth beam steering cell 214 and the sixth beam steering cell 216 may be equal in size.

The second beam steering cell 212 may be disposed in the same column as the fifth beam steering cell 215 but in a row that is further to the top than a row in which the fifth beam steering cell 215 is disposed. In this case, a plurality of nanopillars 10 included in the second beam steering cell 212 may form a nanopattern in which a width W thereof gradually increases away from the center of the beam steering unit 200. Accordingly, a steering direction of the second beam steering cell 212 may be the same as a direction from the center of the beam steering unit 200 toward the second beam steering cell 212.

Likewise, a plurality of nanopillars 10 included in the eighth beam steering cell 218, which is disposed in the same column as the fifth beam steering cell 215 but in a row that is further to the bottom than the row in which the fifth beam steering cell 215 is disposed, may form a nanopattern in which a width W thereof gradually increases away from the center of the beam steering unit 200. Accordingly, a steering direction of the eighth beam steering cell 218 may be the same as a direction from the center of the beam steering unit 200 toward the eighth beam steering cell 218.

Meanwhile, when the second beam steering cell 212 and the eighth beam steering cell 218 are disposed to be symmetrical about the center of the beam steering unit 200, steering angles of the second beam steering cell 212 and the eighth beam steering cell 218 may be equal in size.

The first beam steering cell 211 may be disposed at an upper left side of the fifth beam steering cell 215.

In this case, the plurality of nanopillars 10 included in the first beam steering cell 211 may form a nanopattern in which a pitch P therebetween gradually decreases away from the center of the beam steering unit 200 in the column direction.

Also, the plurality of nanopillars 10 included in the first beam steering cell 211 may form a nanopattern in which a width W thereof gradually increases away from the center of the beam steering unit 200 in the row direction.

Accordingly, a steering direction of the first beam steering cell 211 may be the same as a direction from the center of the beam steering unit 200 toward the first beam steering cell 211.

The third beam steering cell 213 may be disposed at an upper right side of the fifth beam steering cell 215.

In this case, the plurality of nanopillars 10 included in the third beam steering cell 213 may form a nanopattern in which a pitch P therebetween gradually decreases away from the center of the beam steering unit 200 in the column direction.

Also, the plurality of nanopillars 10 included in the third beam steering cell 213 may form a nanopattern in which a width W thereof gradually increases away from the center of the beam steering unit 200 in the row direction.

Accordingly, a steering direction of the third beam steering cell 213 may be the same as a direction from the center of the beam steering unit 200 toward the third beam steering cell 213.

The seventh beam steering cell 217 may be disposed at a lower left side of the fifth beam steering cell 215.

In this case, the plurality of nanopillars 10 included in the seventh beam steering cell 217 may form a nanopattern in which a pitch P therebetween gradually decreases away from the center of the beam steering unit 200 in the column direction.

Also, the plurality of nanopillars 10 included in the seventh beam steering cell 217 may form a nanopattern in which a width W thereof gradually increases away from the center of the beam steering unit 200 in the row direction.

Accordingly, a steering direction of the seventh beam steering cell 217 may be the same as a direction from the center of the beam steering unit 200 toward the seventh beam steering cell 217.

The ninth beam steering cell 219 may be disposed at a lower right side of the fifth beam steering cell 215.

In this case, the plurality of nanopillars 10 included in the ninth beam steering cell 219 may form a nanopattern in which a pitch P therebetween gradually decreases away from the center of the beam steering unit 200 in the column direction.

Also, the plurality of nanopillars 10 included in the ninth beam steering cell 219 may form a nanopattern in which a width W thereof gradually increases away from the center of the beam steering unit 200 in the row direction.

Accordingly, a steering direction of the ninth beam steering cell 219 may be the same as a direction from the center of the beam steering unit 200 toward the ninth beam steering cell 219.

Meanwhile, nanopatterns formed by the plurality of nanopillars 10 included in the beam steering cells 210, which are spaced apart from the center of the beam steering unit 200 at equal distances, may be related to each other.

For example, the first beam steering cell 211 and the third beam steering cell 213 may be spaced apart from the center of the beam steering unit 200 at equal distances. In this case, the plurality of nanopillars 10 included in the first beam steering cell 211 may form a first nanopattern. Also, the plurality of nanopillars 10 included in the third beam steering cell 213 may form a third nanopattern.

In this case, when the first nanopattern is rotated by a predetermined angle about the center of the beam steering unit 200 as an axis, the first nanopattern and the third nanopattern may have the same shape. The predetermined angle may be obtained on the basis of locations of the first beam steering cell 211 and the third beam steering cell 213 relative to the center of the beam steering unit 200.

Meanwhile, unlike in FIG. 11, the plurality of nanopillars 10 may form nanopatterns on the basis of the pitch P in the row direction and on the basis of the width W in the column direction.

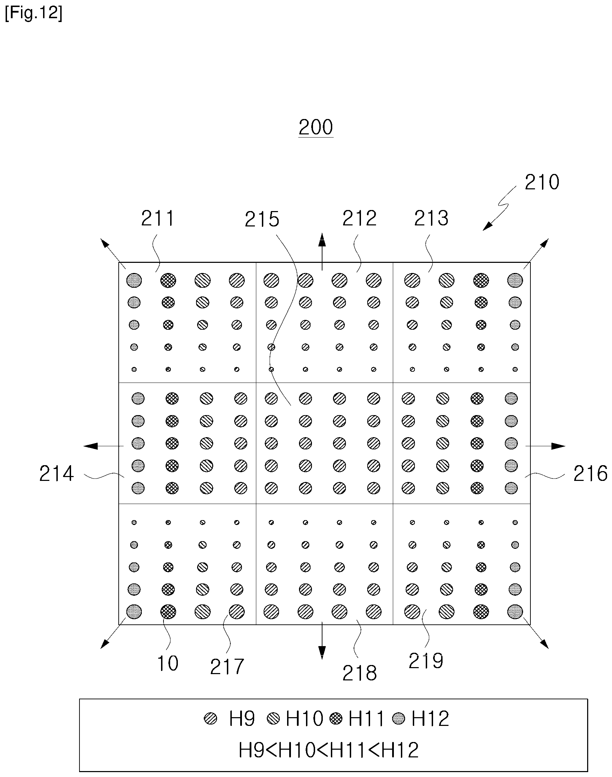

FIG. 12 is a view for describing a beam steering unit according to yet another embodiment.

Referring to FIG. 12, a beam steering unit 200 may include a plurality of beam steering cells 210 and a plurality of nanopillars 10. The beam steering cells 210 may include first to ninth beam steering cells 211, 212, 213, 214, 215, 216, 217, 218, and 219.

The beam steering cells 210 according to an embodiment may be provided in the form of a two-dimensional array. For example, laser emitting units 100 may be provided in the form of a 3×3 array. The first to ninth beam steering cells 211, 212, 213, 214, 215, 216, 217, 218, and 219 may be arranged in the two-dimensional array in a row direction corresponding to the vertical direction and a column direction corresponding to the horizontal direction.

The plurality of nanopillars 10 included in the beam steering cells 210 may form nanopatterns on the basis of a width W and a height H. Specifically, the plurality of nanopillars 10 may form nanopatterns on the basis of the width W in the row direction and on the basis of the height H in the column direction.

The plurality of nanopillars 10 may form nanopatterns on the basis of locations of the beam steering cells 210.

For example, the plurality of nanopillars 10 may form a nanopattern in which the width W of the plurality of nanopillars 10 gradually increases in a direction from the center of the beam steering unit 200 toward a location of a row in which the beam steering cell 210 including the plurality of nanopillars 10 is included.

Also, the plurality of nanopillars 10 may form a nanopattern in which the height H of the plurality of nanopillars 10 gradually increases in a direction from the center of the beam steering unit 200 toward a location of a column in which the beam steering cell 210 including the plurality of nanopillars 10 is included.

For example, a plurality of nanopillars 10 included in the fifth beam steering cell 215 located at the central portion of the beam steering unit 200 may have the same size and be disposed at constant pitches. Accordingly, a laser beam steered by the fifth beam steering cell 215 may pass the nanopillars 10, which are disposed as above, as it is without being refracted by the nanopillars 10.

Meanwhile, the fifth beam steering cell 215 may not include the nanopillars 10. Accordingly, a laser beam emitted from the laser emitting unit 100 may pass through the fifth beam steering cell 215 while an emission direction of the laser beam is maintained.

The fourth beam steering cell 214 may be disposed in the same row as the fifth beam steering cell 215 but in a column that is further to the left than a column in which the fifth beam steering cell 215 is disposed. In this case, a plurality of nanopillars 10 included in the fourth beam steering cell 214 may form a nanopattern in which a height H thereof gradually increases away from the center of the beam steering unit 200. Accordingly, a steering direction of the fourth beam steering cell 214 may be the same as a direction from the center of the beam steering unit 200 toward the fourth beam steering cell 214.

Likewise, a plurality of nanopillars 10 included in the sixth beam steering cell 216, which is disposed in the same row as the fifth beam steering cell 215 but in a column that is further to the right than the column in which the fifth beam steering cell 215 is disposed, may form a nanopattern in which a height H thereof gradually increases away from the center of the beam steering unit 200. Accordingly, a steering direction of the sixth beam steering cell 216 may be the same as a direction from the center of the beam steering unit 200 toward the sixth beam steering cell 216.

Meanwhile, when the fourth beam steering cell 214 and the sixth beam steering cell 216 are disposed to be symmetrical about the center of the beam steering unit 200, steering angles of the fourth beam steering cell 214 and the sixth beam steering cell 216 may be equal in size.

The second beam steering cell 212 may be disposed in the same column as the fifth beam steering cell 215 but in a row that is further to the top than a row in which the fifth beam steering cell 215 is disposed. In this case, a plurality of nanopillars 10 included in the second beam steering cell 212 may form a nanopattern in which a width W thereof gradually increases away from the center of the beam steering unit 200. Accordingly, a steering direction of the second beam steering cell 212 may be the same as a direction from the center of the beam steering unit 200 toward the second beam steering cell 212.

Likewise, a plurality of nanopillars 10 included in the eighth beam steering cell 218, which is disposed in the same column as the fifth beam steering cell 215 but in a row that is further to the bottom than the row in which the fifth beam steering cell 215 is disposed, may form a nanopattern in which a width W thereof gradually increases away from the center of the beam steering unit 200. Accordingly, a steering direction of the eighth beam steering cell 218 may be the same as a direction from the center of the beam steering unit 200 toward the eighth beam steering cell 218.

Meanwhile, when the second beam steering cell 212 and the eighth beam steering cell 218 are disposed to be symmetrical about the center of the beam steering unit 200, steering angles of the second beam steering cell 212 and the eighth beam steering cell 218 may be equal in size.

The first beam steering cell 211 may be disposed at an upper left side of the fifth beam steering cell 215.

In this case, the plurality of nanopillars 10 included in the first beam steering cell 211 may form a nanopattern in which a height H thereof gradually increases away from the center of the beam steering unit 200 in the column direction.

Also, the plurality of nanopillars 10 included in the first beam steering cell 211 may form a nanopattern in which a width W thereof gradually increases away from the center of the beam steering unit 200 in the row direction.

Accordingly, a steering direction of the first beam steering cell 211 may be the same as a direction from the center of the beam steering unit 200 toward the first beam steering cell 211.

The third beam steering cell 213 may be disposed at an upper right side of the fifth beam steering cell 215.

In this case, the plurality of nanopillars 10 included in the third beam steering cell 213 may form a nanopattern in which a height H thereof gradually increases away from the center of the beam steering unit 200 in the column direction.

Also, the plurality of nanopillars 10 included in the third beam steering cell 213 may form a nanopattern in which a width W thereof gradually increases away from the center of the beam steering unit 200 in the row direction.

Accordingly, a steering direction of the third beam steering cell 213 may be the same as a direction from the center of the beam steering unit 200 toward the third beam steering cell 213.

The seventh beam steering cell 217 may be disposed at a lower left side of the fifth beam steering cell 215.

In this case, the plurality of nanopillars 10 included in the seventh beam steering cell 217 may form a nanopattern in which a height H thereof gradually increases away from the center of the beam steering unit 200 in the column direction.

Also, the plurality of nanopillars 10 included in the seventh beam steering cell 217 may form a nanopattern in which a width W thereof gradually increases away from the center of the beam steering unit 200 in the row direction.

Accordingly, a steering direction of the seventh beam steering cell 217 may be the same as a direction from the center of the beam steering unit 200 toward the seventh beam steering cell 217.

The ninth beam steering cell 219 may be disposed at a lower right side of the fifth beam steering cell 215.

In this case, the plurality of nanopillars 10 included in the ninth beam steering cell 219 may form a nanopattern in which a height H thereof gradually increases away from the center of the beam steering unit 200 in the column direction.

Also, the plurality of nanopillars 10 included in the ninth beam steering cell 219 may form a nanopattern in which a width W thereof gradually increases away from the center of the beam steering unit 200 in the row direction.

Accordingly, a steering direction of the ninth beam steering cell 219 may be the same as a direction from the center of the beam steering unit 200 toward the ninth beam steering cell 219.

Meanwhile, nanopatterns formed by the plurality of nanopillars 10 included in the beam steering cells 210, which are spaced apart from the center of the beam steering unit 200 at equal distances, may be related to each other.

For example, the first beam steering cell 211 and the third beam steering cell 213 may be spaced apart from the center of the beam steering unit 200 at equal distances. In this case, the plurality of nanopillars 10 included in the first beam steering cell 211 may form a first nanopattern. Also, the plurality of nanopillars 10 included in the third beam steering cell 213 may form a third nanopattern.

In this case, when the first nanopattern is rotated by a predetermined angle about the center of the beam steering unit 200 as an axis, the first nanopattern and the third nanopattern may have the same shape. The predetermined angle may be obtained on the basis of locations of the first beam steering cell 211 and the third beam steering cell 213 relative to the center of the beam steering unit 200.

Meanwhile, unlike in FIG. 12, the plurality of nanopillars 10 may form nanopatterns on the basis of the height H in the row direction and on the basis of the width W in the column direction.

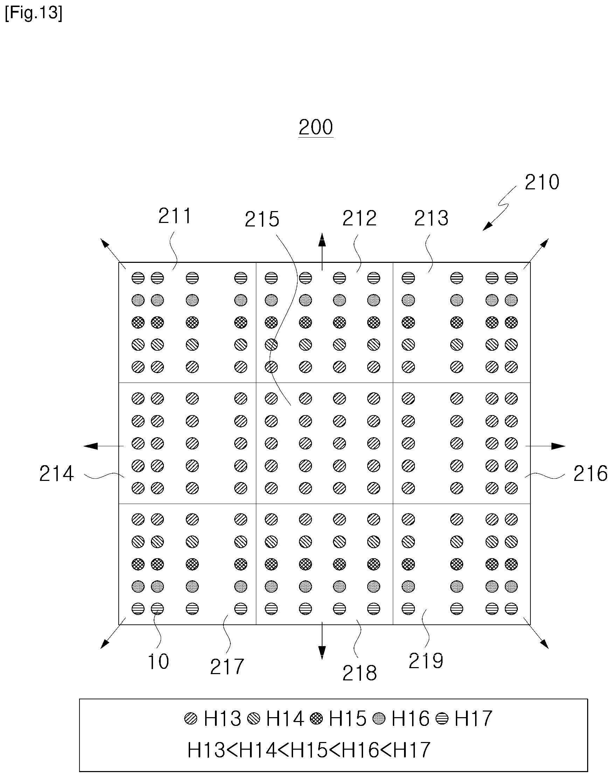

FIG. 13 is a view for describing a beam steering unit according to yet another embodiment.

Referring to FIG. 13, a beam steering unit 200 may include a plurality of beam steering cells 210 and a plurality of nanopillars 10. The beam steering cells 210 may include first to ninth beam steering cells 211, 212, 213, 214, 215, 216, 217, 218, and 219.

The beam steering cells 210 according to an embodiment may be provided in the form of a two-dimensional array. For example, laser emitting units 100 may be provided in the form of a 3×3 array. The first to ninth beam steering cells 211, 212, 213, 214, 215, 216, 217, 218, and 219 may be arranged in the two-dimensional array in a row direction corresponding to the vertical direction and a column direction corresponding to the horizontal direction.

The plurality of nanopillars 10 included in the beam steering cells 210 may form nanopatterns on the basis of a pitch P and a height H. Specifically, the plurality of nanopillars 10 may form nanopatterns on the basis of the height H in the row direction and on the basis of the pitch P in the column direction.

The plurality of nanopillars 10 may form nanopatterns on the basis of locations of the beam steering cells 210.

For example, the plurality of nanopillars 10 may form a nanopattern in which the height H of the plurality of nanopillars 10 gradually increases in a direction from the center of the beam steering unit 200 toward a location of a row in which the beam steering cell 210 including the plurality of nanopillars 10 is included.

Also, the plurality of nanopillars 10 may form a nanopattern in which the pitch P between the plurality of nanopillars 10 gradually decreases in a direction from the center of the beam steering unit 200 toward a location of a column in which the beam steering cell 210 including the plurality of nanopillars 10 is included.

For example, a plurality of nanopillars 10 included in the fifth beam steering cell 215 located at the central portion of the beam steering unit 200 may have the same size and be disposed at constant pitches. Accordingly, a laser beam steered by the fifth beam steering cell 215 may pass the nanopillars 10, which are disposed as above, as it is without being refracted by the nanopillars 10.

Meanwhile, the fifth beam steering cell 215 may not include the nanopillars 10. Accordingly, a laser beam emitted from the laser emitting unit 100 may pass through the fifth beam steering cell 215 while an emission direction of the laser beam is maintained.

The fourth beam steering cell 214 may be disposed in the same row as the fifth beam steering cell 215 but in a column that is further to the left than a column in which the fifth beam steering cell 215 is disposed. In this case, a plurality of nanopillars 10 included in the fourth beam steering cell 214 may form a nanopattern in which a pitch P therebetween gradually decreases away from the center of the beam steering unit 200. Accordingly, a steering direction of the fourth beam steering cell 214 may be the same as a direction from the center of the beam steering unit 200 toward the fourth beam steering cell 214.

Likewise, a plurality of nanopillars 10 included in the sixth beam steering cell 216, which is disposed in the same row as the fifth beam steering cell 215 but in a column that is further to the right than the column in which the fifth beam steering cell 215 is disposed, may form a nanopattern in which a pitch P therebetween gradually decreases away from the center of the beam steering unit 200. Accordingly, a steering direction of the sixth beam steering cell 216 may be the same as a direction from the center of the beam steering unit 200 toward the sixth beam steering cell 216.

Meanwhile, when the fourth beam steering cell 214 and the sixth beam steering cell 216 are disposed to be symmetrical about the center of the beam steering unit 200, steering angles of the fourth beam steering cell 214 and the sixth beam steering cell 216 may be equal in size.

The second beam steering cell 212 may be disposed in the same column as the fifth beam steering cell 215 but in a row that is further to the top than a row in which the fifth beam steering cell 215 is disposed. In this case, a plurality of nanopillars 10 included in the second beam steering cell 212 may form a nanopattern in which a height H thereof gradually increases away from the center of the beam steering unit 200. Accordingly, a steering direction of the second beam steering cell 212 may be the same as a direction from the center of the beam steering unit 200 toward the second beam steering cell 212.

Likewise, a plurality of nanopillars 10 included in the eighth beam steering cell 218, which is disposed in the same column as the fifth beam steering cell 215 but in a row that is further to the bottom than the row in which the fifth beam steering cell 215 is disposed, may form a nanopattern in which a height H thereof gradually increases away from the center of the beam steering unit 200. Accordingly, a steering direction of the eighth beam steering cell 218 may be the same as a direction from the center of the beam steering unit 200 toward the eighth beam steering cell 218.

Meanwhile, when the second beam steering cell 212 and the eighth beam steering cell 218 are disposed to be symmetrical about the center of the beam steering unit 200, steering angles of the second beam steering cell 212 and the eighth beam steering cell 218 may be equal in size.

The first beam steering cell 211 may be disposed at an upper left side of the fifth beam steering cell 215.

In this case, the plurality of nanopillars 10 included in the first beam steering cell 211 may form a nanopattern in which a pitch P therebetween gradually decreases away from the center of the beam steering unit 200 in the column direction.

Also, the plurality of nanopillars 10 included in the first beam steering cell 211 may form a nanopattern in which a height H thereof gradually increases away from the center of the beam steering unit 200 in the row direction.

Accordingly, a steering direction of the first beam steering cell 211 may be the same as a direction from the center of the beam steering unit 200 toward the first beam steering cell 211.

The third beam steering cell 213 may be disposed at an upper right side of the fifth beam steering cell 215.

In this case, the plurality of nanopillars 10 included in the third beam steering cell 213 may form a nanopattern in which a pitch P therebetween gradually decreases away from the center of the beam steering unit 200 in the column direction.

Also, the plurality of nanopillars 10 included in the third beam steering cell 213 may form a nanopattern in which a height H thereof gradually increases away from the center of the beam steering unit 200 in the row direction.

Accordingly, a steering direction of the third beam steering cell 213 may be the same as a direction from the center of the beam steering unit 200 toward the third beam steering cell 213.

The seventh beam steering cell 217 may be disposed at a lower left side of the fifth beam steering cell 215.

In this case, the plurality of nanopillars 10 included in the seventh beam steering cell 217 may form a nanopattern in which a pitch P therebetween gradually decreases away from the center of the beam steering unit 200 in the column direction.

Also, the plurality of nanopillars 10 included in the seventh beam steering cell 217 may form a nanopattern in which a height H thereof gradually increases away from the center of the beam steering unit 200 in the row direction.

Accordingly, a steering direction of the seventh beam steering cell 217 may be the same as a direction from the center of the beam steering unit 200 toward the seventh beam steering cell 217.

The ninth beam steering cell 219 may be disposed at a lower right side of the fifth beam steering cell 215.

In this case, the plurality of nanopillars 10 included in the ninth beam steering cell 219 may form a nanopattern in which a pitch P therebetween gradually decreases away from the center of the beam steering unit 200 in the column direction.

Also, the plurality of nanopillars 10 included in the ninth beam steering cell 219 may form a nanopattern in which a height H thereof gradually increases away from the center of the beam steering unit 200 in the row direction.

Accordingly, a steering direction of the ninth beam steering cell 219 may be the same as a direction from the center of the beam steering unit 200 toward the ninth beam steering cell 219.

Meanwhile, nanopatterns formed by the plurality of nanopillars 10 included in the beam steering cells 210, which are spaced apart from the center of the beam steering unit 200 at equal distances, may be related to each other.

For example, the first beam steering cell 211 and the third beam steering cell 213 may be spaced apart from the center of the beam steering unit 200 at equal distances. In this case, the plurality of nanopillars 10 included in the first beam steering cell 211 may form a first nanopattern. Also, the plurality of nanopillars 10 included in the third beam steering cell 213 may form a third nanopattern.

In this case, when the first nanopattern is rotated by a predetermined angle about the center of the beam steering unit 200 as an axis, the first nanopattern and the third nanopattern may have the same shape. The predetermined angle may be obtained on the basis of locations of the first beam steering cell 211 and the third beam steering cell 213 relative to the center of the beam steering unit 200.

Meanwhile, unlike in FIG. 13, the plurality of nanopillars 10 may form nanopatterns on the basis of the pitch P in the row direction and on the basis of the height H in the column direction.

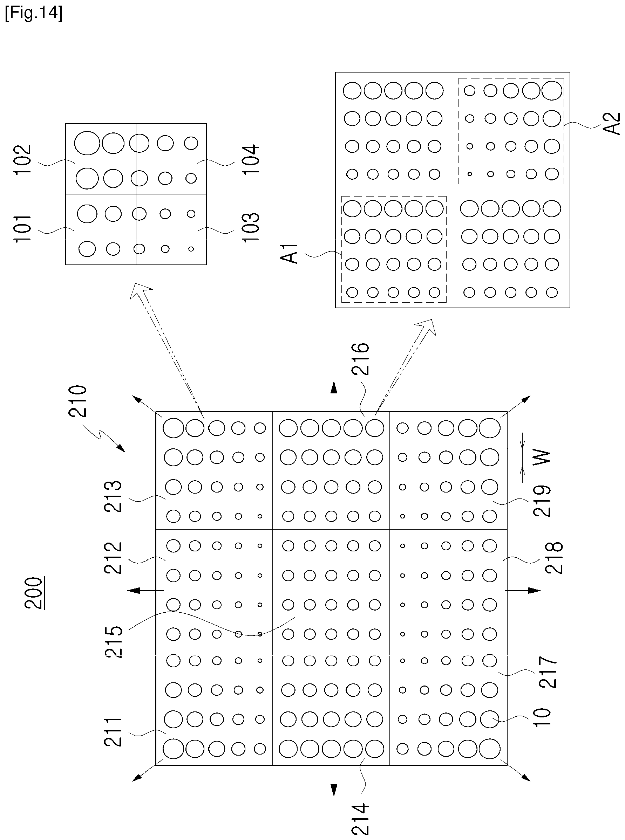

FIG. 14 is a top view for describing a beam steering unit according to an embodiment.

Referring to FIG. 14, a beam steering unit 200 according to an embodiment may include a plurality of beam steering cells 210 and a plurality of nanopillars 10. The beam steering cells 210 may include first to ninth beam steering cells 211, 212, 213, 214, 215, 216, 217, 218, and 219.

The beam steering cells 210 according to an embodiment may be provided in the form of a two-dimensional array. For example, laser emitting units 100 may be provided in the form of a 3×3 array. The first to ninth beam steering cells 211, 212, 213, 214, 215, 216, 217, 218, and 219 may be arranged in the two-dimensional array in a row direction corresponding to the vertical direction and a column direction corresponding to the horizontal direction.

A plurality of laser emitting units 100 may be disposed at a lower portion of at least one of the plurality of beam steering cells 210.

For example, first to fourth laser emitting units 101, 102, 103, and 104 may be disposed at a lower portion of the third beam steering cell 213.

The first to fourth laser emitting units 101, 102, 103, and 104 may be controlled separately.

Attributes of a laser beam emitted from the first laser emitting unit 101 and attributes of a laser beam emitted from the second laser emitting unit 102 may be different.

For example, a wavelength of a laser beam emitted from the first laser emitting unit 101 and a wavelength of a laser beam emitted from the second laser emitting unit 102 may be different.

As another example, an intensity of a laser beam emitted from the first laser emitting unit 101 and an intensity of a laser beam emitted from the second laser emitting unit 102 may be different.

As still another example, laser beam emission time points of the first laser emitting unit 101 and the second laser emitting unit 102 may be different. Specifically, while the first laser emitting unit 101 emits a laser beam, the second laser emitting unit 102 may be turned off.

Meanwhile, the plurality of nanopillars 10 included in the beam steering cells 210 may form a plurality of nanopatterns. For example, the plurality of nanopatterns may include a first nanopattern A1 and a second nanopattern A2.

At least one of the plurality of nanopatterns may be repeatedly formed on the beam steering cell 210. For example, a plurality of nanopillars 10 included in the sixth beam steering cell 216 of FIG. 14 may repeatedly form the first nanopattern A1. Specifically, the first nanopattern A1 may have a pattern in which the width W of the nanopillars 10 repeatedly increases.

The second nanopattern A2 may have a different form from the first nanopattern A1. For example, the first nanopattern A1 may have a form in which the width W of the nanopillars 10 gradually increases away from the center of the beam steering unit 200 while the width W of the nanopillars is constant in the row direction. On the other hand, the second nanopattern A2 may have a form in which the width W of the nanopillars 10 gradually increases away from the center of the beam steering unit 200 while the width W of the nanopillars 10 changes in the row direction.

Meanwhile, by the on/off state of each laser emitting unit being adjusted, laser beams of various shapes may be formed. For example, the shape of a laser beam emitted from the laser emitting device 1000 may vary according to the on/off states of the first laser emitting unit 101 and the second laser emitting unit 102.

By the on/off states of a plurality of light source units included in the laser emitting unit being adjusted, laser beams of various shapes may be formed. For example, the shape of a laser beam which is emitted from the third laser emitting unit 103 and passes the nanopillars 10 may vary according to the on/off states of a first light source unit and a second light source unit included in the third laser emitting unit 103.

By an intensity of a laser beam emitted from each laser emitting unit being adjusted, laser beams of various shapes may be formed. For example, the shape of a laser beam emitted from the laser emitting device 1000 may vary as intensities of laser beams emitted from the first laser emitting unit 101 and the second laser emitting unit 102 are adjusted.

By an intensity of a laser beam emitted from a plurality of light source units included in the laser emitting unit being adjusted, laser beams of various shapes may be formed. For example, the shape of a laser beam which is emitted from the third laser emitting unit 103 and passes the nanopillars 10 may vary as intensities of laser beams emitted from a first light source unit and a second light source unit are adjusted.

Meanwhile, the nanopatterns have been described above as being formed for each beam steering cell 210 as a unit, but the nanopatterns may also be formed in the entire beam steering unit 200 regardless of boundaries of the plurality of beam steering cells 210. Accordingly, the nanopillars 10 may be disposed on a boundary line between two adjacent beam steering cells 210.

The number of nanopillars 10 disposed on each beam steering cell 210 may be different.

For convenience of description, the case in which the beam steering unit 200 is provided as a 3×3 array, i.e., an N×N array, has been described above as an example, but the beam steering unit 200 may also be provided as an N×M array (here, the N and M are different numbers).

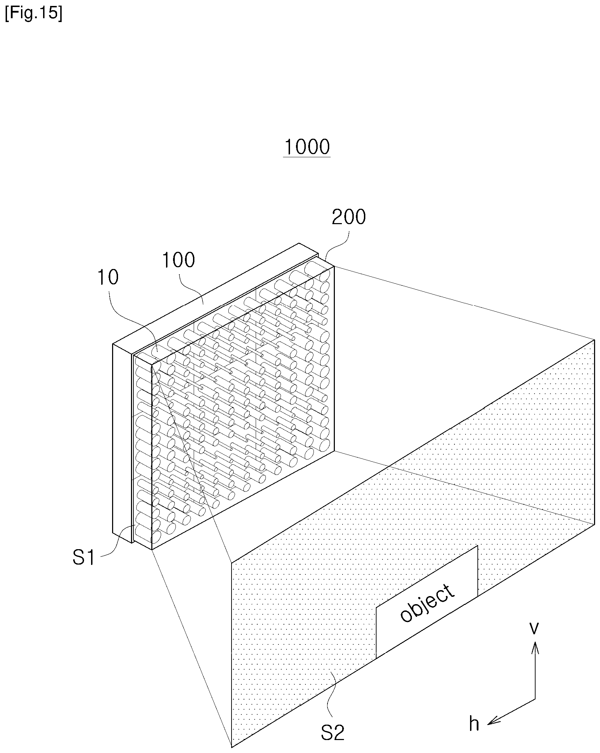

FIG. 15 is a pictorial diagram illustrating a laser beam emitted from a laser emitting device according to an embodiment.

Referring to FIG. 15, a laser emitting device 1000 may include a laser emitting unit 100, a beam steering unit 200, and a plurality of nanopillars 10. Meanwhile, at least one of the plurality of nanopillars 10 illustrated in FIG. 15 may include a plurality of nanostructures. For example, the nanopillar 10 may include one or more nanostructure having an irregular shape.

The laser emitting device 1000 may emit a laser beam toward an object.

The laser emitting device 1000 may generate a plurality of scanning points distributed in an h-direction, which is the horizontal direction, and a v-direction, which is the vertical direction. The laser emitting device 1000 may have a field of view (FOV) formed by the plurality of scanning points. For example, the laser emitting device 1000 may have the FOV in a range of -N° to N° in the h-direction. Also, the laser emitting device 1000 may have the FOV in a range of -M° to M° in the v-direction. Specifically, the laser emitting device 1000 may have the FOV in a range of -60° to 60° in the h-direction and the FOV in a range of -15° to 15° in the v-direction.

The N may be greater than the M. That is, the laser emitting device 1000 may have the FOV in a wider range in the h-direction than in the v-direction.

Regarding the laser emitting unit 100, since the description given above on the laser emitting unit 100 may be applied without change, detailed description thereof will be omitted.

The beam steering unit 200 may include a plurality of nanopillars 10.

The beam steering unit 200 may include the plurality of beam steering cells. The plurality of beam steering cells may be arranged in the form of a two-dimensional array. The plurality of beam steering cells may be arranged in the two-dimensional array in a row direction corresponding to the vertical direction and a column direction corresponding to the horizontal direction.

Each of the plurality of beam steering cells may include a plurality of nanopillars 10.

The plurality of beam steering cells may guide a laser beam emitted from the laser emitting unit 100 to correspond to the plurality of scanning points. In this case, the plurality of beam steering cells may guide the laser beam using the plurality of nanopillars 10.

Meanwhile, a beam steering surface S 1 may be defined as a surface included in a region in which a laser beam emitted from the laser emitting unit 100 is steered. Specifically, the beam steering surface S1 may refer to a cross-section of the beam steering unit 200.

Also, a beam projection surface S2 may be defined as a surface included in a region in which a laser beam emitted from the laser emitting device 1000 is projected to an object.

The beam steering surface S 1 may be parallel to the beam projection surface S2.

As described above, the plurality of nanopillars 10 included in the beam steering unit 200 may form nanopatterns on the basis of locations of the beam steering cells. That is, the plurality of nanopillars 10 may form nanopatterns on the basis of locations thereof on the beam steering surface S1.

Unlike this, the plurality of nanopillars 10 may form nanopatterns on the basis of a steering direction in which the plurality of beam steering cells guide a laser beam emitted from the laser emitting unit 100. That is, the plurality of nanopillars 10 may form nanopatterns on the basis of locations thereof on the beam projection surface S2.

Hereinafter, the nanopatterns formed on the basis of locations on the beam steering surface S 1 and the beam projection surface S2 will be described.

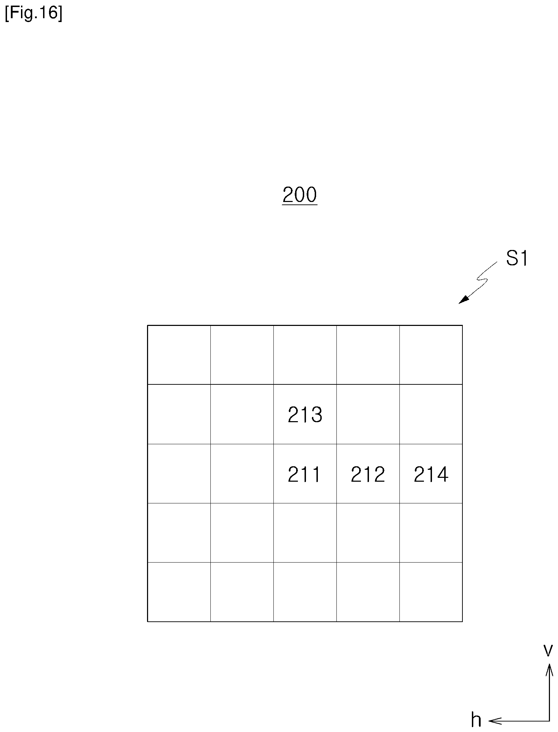

FIG. 16 is a view illustrating a beam steering unit 200 according to an embodiment.

Specifically, FIG. 16 is a view for describing the nanopatterns formed on the basis of locations on the beam steering surface S1.

The beam steering unit 200 may include first to fourth beam steering cells 211, 212, 213, and 214. The first to fourth beam steering cells 211, 212, 213, and 214 may include a plurality of nanopillars forming nanopatterns.

The first beam steering cell 211 may be arranged at the center of the beam steering unit 200.

An h-coordinate of the second beam steering cell 212 may be greater than an h-coordinate of the first beam steering cell 211. In this case, the plurality of nanopillars included in the second beam steering cell 212 may form, from the center of the beam steering unit 200 toward the second beam steering cell 212, a nanopattern in which a first attribute related to at least one of the width W, height H, and number per unit length of the nanopillars repeatedly increases.

A v-coordinate of the third beam steering cell 213 may be greater than a v-coordinate of the first beam steering cell 211. In this case, the plurality of nanopillars included in the third beam steering cell 213 may form, from the center of the beam steering unit 200 toward the third beam steering cell 213, a nanopattern in which an attribute related to at least one of the width W, height H, and number per unit length of the nanopillars repeatedly increases.

Meanwhile, as a distance from the center of the beam steering unit 200 to a beam steering cell becomes larger, a change rate of an attribute of a plurality of nanopillars included in the beam steering cell may increase.

For example, an h-coordinate of the fourth beam steering cell 214 may be greater than an h-coordinate of the second beam steering cell 212. Accordingly, a distance from the center of the beam steering unit 200 to the fourth beam steering cell 214 may be larger than a distance from the center of the beam steering unit 200 to the second beam steering cell 212.

In this case, the plurality of nanopillars included in the fourth beam steering cell 214 may form, from the center of the beam steering unit 200 toward the fourth beam steering cell 214, a nanopattern in which a second attribute related to at least one of the width W, height H, and number per unit length of the nanopillars repeatedly increases. A change rate of an attribute may be higher than the change rate of the first attribute.

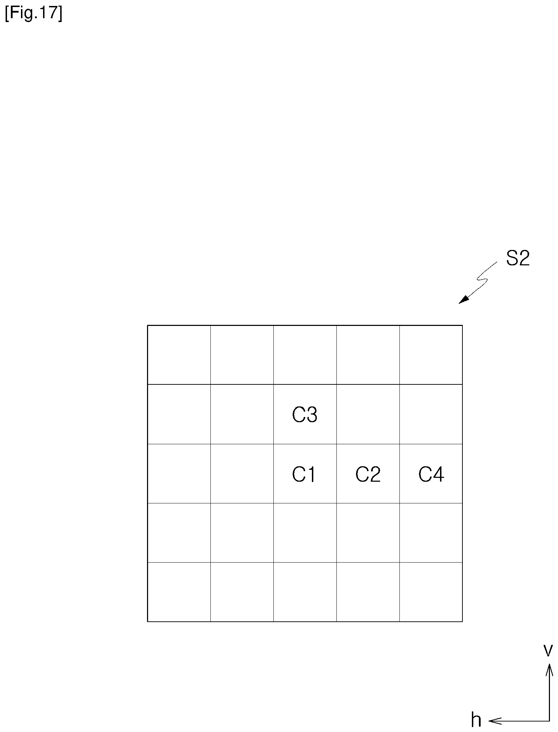

FIG. 17 is a view illustrating a beam projection surface S2 according to an embodiment.

Specifically, FIG. 17 is a view for describing the nanopatterns formed on the basis of locations on the beam projection surface S2.

The beam projection surface S2 may be expressed in the form of a two-dimensional array in the h-direction corresponding to the horizontal direction and the v-direction corresponding to the vertical direction.

A first projection cell C1 may be located at the center of the beam projection surface S2. In this case, a first laser beam projected to the first projection cell C1 may have been steered by a first beam steering cell. The plurality of nanopillars included in the first beam steering cell may form a nanopattern in which a first attribute related to at least one of the width W, height H, and number per unit length of the nanopillars is the same.

An h-coordinate of a second projection cell C2 may be greater than an h-coordinate of the first projection cell C1. In this case, a second laser beam projected to the second projection cell C2 may have been steered by a second beam steering cell. The plurality of nanopillars included in the second beam steering cell may form, in a direction of an h-axis component of a steering direction of the second beam steering cell, nanopatterns in which a second attribute related to at least one of the width W, height H, and number per unit length of the nanopillars repeatedly increases.

A v-coordinate of a third projection cell C3 may be greater than a v-coordinate of the first projection cell C1. In this case, a third laser beam projected to the third projection cell C3 may have been steered by a third beam steering cell. The plurality of nanopillars included in the third beam steering cell may form, in a direction of a v-axis component of a steering direction of the third beam steering cell, nanopatterns in which a third attribute related to at least one of the width W, height H, and number per unit length of the nanopillars repeatedly increases.

Meanwhile, as a location of a cell becomes farther from the center of the beam projection surface S2, a change rate of an attribute of a plurality of nanopillars included in a beam steering cell, which steers a laser beam projected to the cell, may increase.

For example, a fourth projection cell C4 may have an h-coordinate greater than that of the first projection cell C1 but may be located farther from the center of the beam projection surface S2 than the second projection cell C2. A fourth laser beam projected to the fourth projection cell C4 may have been steered by a fourth beam steering cell. The plurality of nanopillars included in the fourth beam steering cell may form, in a direction of an h-axis component of a steering direction of the fourth beam steering cell, nanopatterns in which a fourth attribute related to at least one of the width W, height H, and number per unit length of the nanopillars repeatedly increases.

In this case, a change rate of the fourth attribute may be higher than the change rate of the second attribute.

Meanwhile, such a relationship between the rates of change may remain the same even when sizes of v-axis components of steering directions change.

Meanwhile, a location on the beam steering surface S1 may be related to a location on the beam projection surface S2.

For example, a location on the beam steering surface S1 may correspond to a location on the beam projection surface S2.

Specifically, the first to fourth projection cells C1, C2, C3, and C4 may respectively correspond to the first to fourth beam steering cells 211, 212, 213, and 214 of FIG. 16. That is, a first laser beam irradiated to the first projection cell C1 may have been steered by the first beam steering cell 211. The same applies for the second to fourth projection cells C2, C3, and C4.

Alternatively, a location on the beam steering surface S1 may not correspond to a location on the beam projection surface S2.

Specifically, the first to fourth projection cells C1, C2, C3, and C4 may not respectively correspond to the first to fourth beam steering cells 211, 212, 213, and 214. For example, a third laser beam irradiated to the third projection cell C3 may have been steered by the second beam steering cell 212.

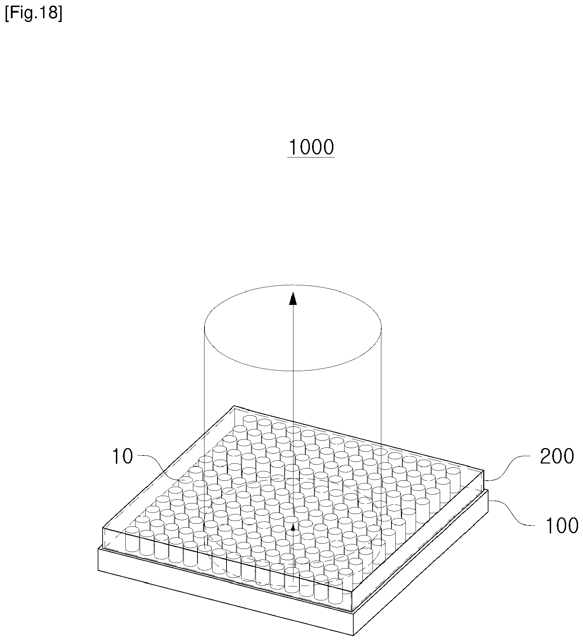

Meanwhile, referring to FIG. 18, sizes of the plurality of nanopillars 10 included in the beam steering unit 200 of the laser emitting device 1000 may be the same. For example, widths W and heights H of the plurality of nanopillars 10 may be the same. Alternatively, pitches P between the plurality of nanopillars 10 may be the same.

In this case, a steering angle θ of a laser beam may be 0°. That is, a first angle, which is an emission angle of a laser beam emitted from the laser emitting unit 100, may be equal to a second angle, which is an irradiation angle of a laser beam that has passed the beam steering unit 200 after being emitted from the laser emitting unit 100.

The laser emitting device 1000 in which the beam steering unit 200 is configured of a single layer has been described above.

Hereinafter, a laser emitting device 1000 in which the beam steering unit 200 is configured of a plurality of layers will be described.

### 1. Multi Layer

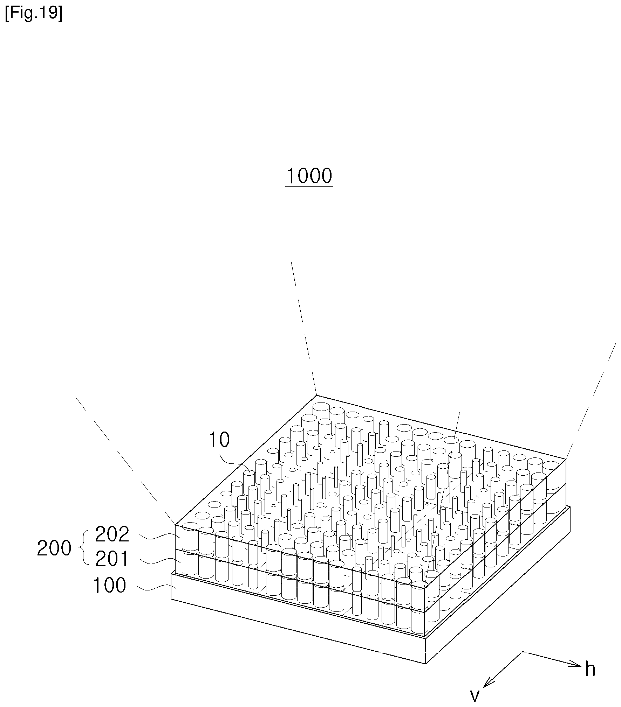

FIG. 19 is a pictorial diagram illustrating a laser emitting device according to an unclaimed embodiment.

Referring to FIG. 19, a laser emitting device 1000 may include a laser emitting unit 100 and a beam steering unit 200.

Meanwhile, the laser emitting device 1000 may operate identically or similarly to the laser emitting device 1000 described above with reference to FIGS. 1 to 18. Accordingly, detailed description of points in common will be omitted, and differences therebetween will be mainly described.

The laser emitting device 1000 may generate laser beams of various shapes from a laser beam emitted from the laser emitting unit 100 by using the beam steering unit 200. For example, the laser emitting device 1000 may generate a laser beam having a shape diverging from the center thereof.

Each configuration of the laser emitting device 1000 will be described in detail below.

The laser emitting unit 100 may operate identically or similarly to the laser emitting unit 100 described above with reference to FIGS. 1 to 18. For example, the laser emitting unit 100 may be arranged in the form of an array and include a plurality of VCSEL elements.

The beam steering unit 200 may steer a laser beam emitted from the laser emitting unit 100. The beam steering unit 200 may generate laser beams of various shapes by steering the emitted laser beam.

For example, the beam steering unit 200 may form, from the emitted laser beam, a laser beam having an h-direction, which is the horizontal direction, and a v-direction, which is the vertical direction.

The beam steering unit 200 may include a first beam steering unit 201 and a second beam steering unit 202. Each of the first beam steering unit 201 and the second beam steering unit 202 may include a plurality of nanopillars 10.

The first beam steering unit 201 may steer a laser beam emitted from the laser emitting unit 100. The plurality of nanopillars 10 included in the first beam steering unit 201 may form a nanopattern. The first beam steering unit 201 may steer, on the basis of the nanopattern, a laser beam emitted from the laser emitting unit 100.

The laser beam steered by the first beam steering unit 201 may be projected toward the second beam steering unit 202.

The second beam steering unit 202 may obtain the laser beam emitted from the first beam steering unit 201. The second beam steering unit 202 may steer the obtained laser beam.

The plurality of nanopillars 10 included in the second beam steering unit 202 may form a nanopattern. The second beam steering unit 202 may steer the obtained laser beam on the basis of the nanopattern.

The laser beam steered by the second beam steering unit 202 may be projected toward an object.

The first beam steering unit 201 may be disposed at an upper portion of the laser emitting unit 100. Specifically, the first beam steering unit 201 may be disposed at an emission surface side at which a laser beam is emitted from the laser emitting unit 100.

The second beam steering unit 202 may be disposed at an upper portion of the first beam steering unit 201.

Accordingly, laser beams emitted from the laser emitting unit 100 may sequentially pass through the first beam steering unit 201 and the second beam steering unit 202.

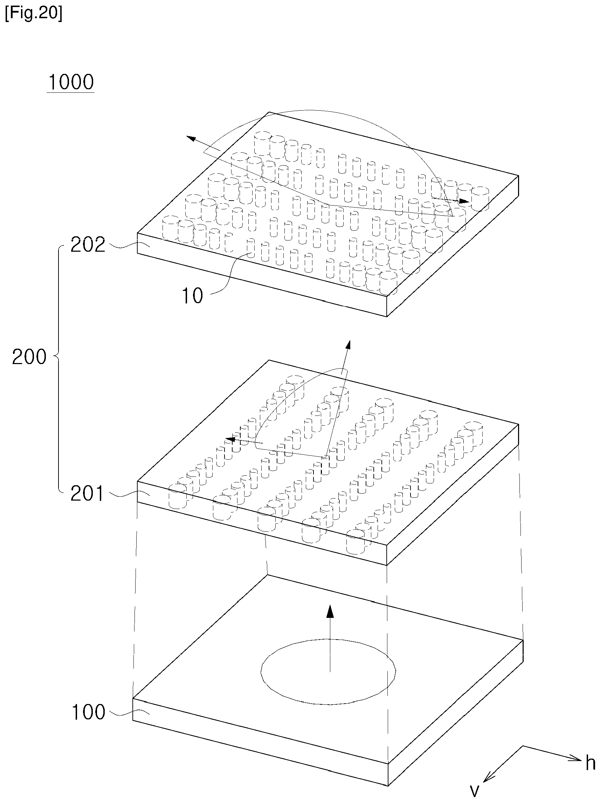

FIG. 20 is an exploded perspective view of a laser emitting device according to an unclaimed embodiment.

Referring to FIG. 20, a laser emitting device 1000 may include a laser emitting unit 100 and a beam steering unit 200. The beam steering unit 200 may include a first beam steering unit 201 and a second beam steering unit 202.

The laser emitting device 1000 may generate a plurality of scanning points distributed in the horizontal direction and vertical direction. The laser emitting device 1000 may have the FOV formed in the horizontal direction and the vertical direction.

The laser emitting unit 100 may be disposed at a lower portion of the first beam steering unit 201 and may irradiate a laser beam toward the first beam steering unit 201. Meanwhile, since the laser emitting unit 100 may operate identically or similarly to the laser emitting unit 100 described above with reference to FIGS. 1 to 18, detailed description thereof will be omitted.

The first beam steering unit 201 may be disposed at an upper portion of the laser emitting unit 100 and obtain a laser beam emitted from the laser emitting unit 100. The first beam steering unit 201 may generate laser beams of various shapes by steering the obtained laser beam.

Specifically, the first beam steering unit 201 may steer the obtained laser beam using a plurality of nanopillars 10. The first beam steering unit 201 may include a metasurface.

The first beam steering unit 201 may steer a laser beam in the h-direction corresponding to the horizontal direction and the v-direction corresponding to the vertical direction.

For example, the first beam steering unit 201 may generate a laser beam having a shape diverging in the v-direction. A vertical steering angle θv of the first beam steering unit 201 may be in a range of -15° to 15°. Here, the steering angle may refer to an angle in a clockwise direction from a virtual reference line which is perpendicular to an emission surface. That is, a steering direction having a positive steering angle may be located at a right side of the reference line, and a steering direction having a negative steering angle may be located at a left side of the reference line.

In this case, the plurality of nanopillars 10 included in the first beam steering unit 201 may form a subwavelength pattern in which at least one attribute of the width W, height H, and number per unit length repeatedly increases in the v-direction.

The second beam steering unit 202 may be disposed at an upper portion of the first beam steering unit 201 and obtain a laser beam steered by the first beam steering unit 201. The second beam steering unit 202 may generate laser beams of various shapes by steering the laser beam obtained from the first beam steering unit 201.

Specifically, the second beam steering unit 202 may steer the obtained laser beam using a plurality of nanopillars 10. The second beam steering unit 202 may include a metasurface.

The second beam steering unit 202 may steer a laser beam in the h-direction corresponding to the horizontal direction and the v-direction corresponding to the vertical direction.

For example, the second beam steering unit 202 may generate a laser beam having a shape diverging in the h-direction. A horizontal steering angle θh of the second beam steering unit 202 may be in a range of -60° to 60°.

In this case, the plurality of nanopillars 10 included in the second beam steering unit 202 may form a subwavelength pattern in which at least one attribute of the width W, height H, and number per unit length repeatedly increases in the h-direction.

Meanwhile, each of the first beam steering unit 201 and the second beam steering unit 202 may include the plurality of beam steering cells including the plurality of nanopillars 10. The plurality of beam steering cells may be arranged in the form of an array along the v-axis or h-axis.

In this case, an arrangement direction of the plurality of beam steering cells included in the first beam steering unit 201 and an arrangement direction of the plurality of beam steering cells included in the second beam steering unit 202 may be different.

For example, the plurality of beam steering cells included in the first beam steering unit 201 may be arranged in the form of an array along the v-axis. On the other hand, the plurality of beam steering cells included in the second beam steering unit 202 may be arranged in the form of an array along the h-axis.

Meanwhile, although some of the laser beams steered by the first beam steering unit 201 are seen in FIG. 20 as being projected to the outside of the second beam steering unit 202, this is merely for convenience of description, and some of the laser beams are not projected to the outside of the second beam steering unit 202 in reality.

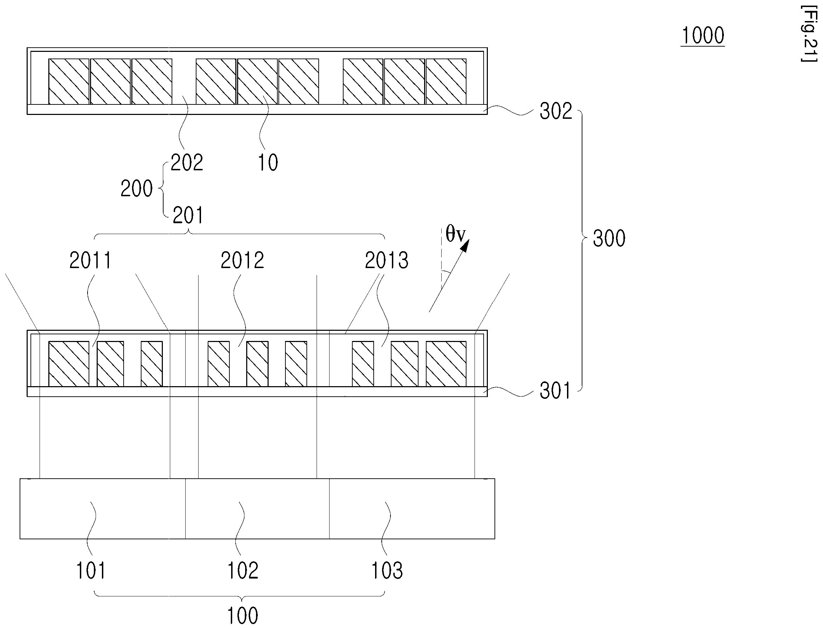

FIGS. 21 to 23 are exploded perspective views of a laser emitting device according to various unclaimed embodiments viewed from the side.

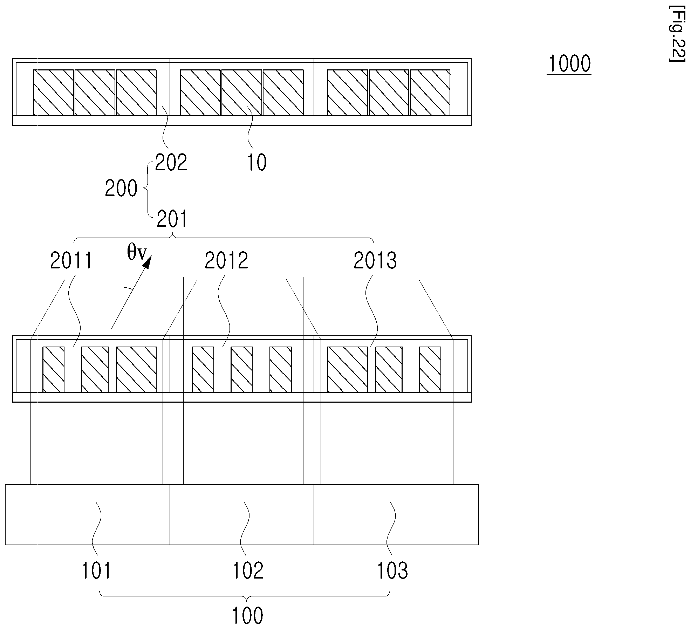

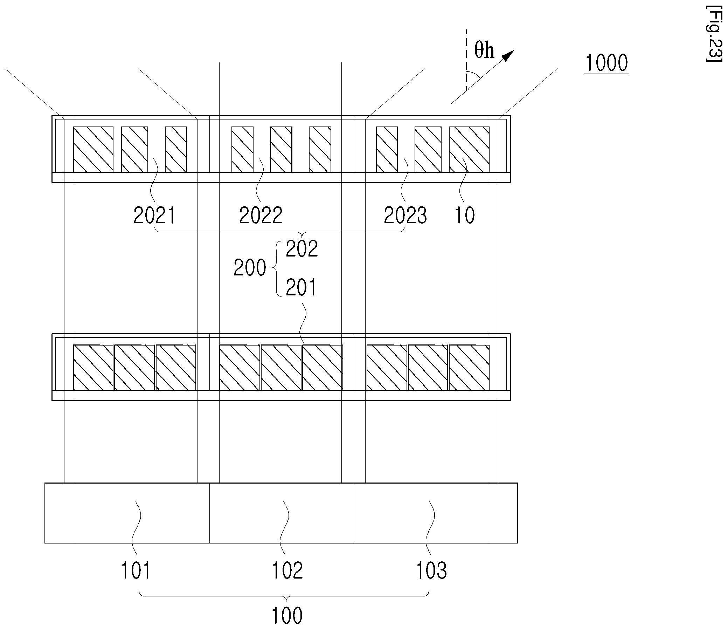

Specifically, FIGS. 21 and 22 are exploded perspective views of a laser emitting device viewed along the h-axis. FIG. 23 is an exploded perspective view of a laser emitting device viewed along the v-axis.

Referring to FIG. 21, a laser emitting device 1000 may include a laser emitting unit 100 and a beam steering unit 200. The beam steering unit 200 may include a first beam steering unit 201 and a second beam steering unit 202. Each of the first beam steering unit 201 and the second beam steering unit 202 may include a plurality of nanopillars 10.

The laser emitting device 1000 may include a support unit 300 configured to support the beam steering unit 200.

The support unit 300 may support the nanopillars 10 included in the beam steering unit 200. Alternatively, the support unit 300 may support a metasurface including the plurality of nanopillars 10. Accordingly, the plurality of nanopillars 10 may be deposited on the support unit 300.

A light transmittance of the support unit 300 may be at least 90% or higher.

The support unit 300 may be formed of various materials. For example, the support unit 300 may include glass, metamaterial, and the like.

The support unit 300 may be provided in the form of a flat panel.

The support unit 300 may include a first support unit 301 and a second support unit 302.

The first support unit 301 may be disposed between the laser emitting unit 100 and the first beam steering unit 201 to support the first beam steering unit 201.

The second support unit 302 may be disposed between the first beam steering unit 201 and the second beam steering unit 202 to support the second beam steering unit 202.

The first support unit 301 and the second support unit 302 may be formed of different materials.

A refractive index of the first support unit 301 may be lower than a refractive index of the nanopillars 10 included in the first beam steering unit 201.

The laser emitting unit 100 may include a plurality of laser emitting units 101, 102, and 103 arranged in the form of a one-dimensional array in the v-direction.

Each of the plurality of laser emitting units 101, 102, and 103 may emit a laser beam toward the beam steering unit 200.

The first beam steering unit 201 may obtain a laser beam emitted from the laser emitting unit 100.

The first beam steering unit 201 may steer the obtained laser beam using the plurality of nanopillars 10.

The first beam steering unit 201 may generate a laser beam having a shape diverging in the v-direction. For example, a vertical steering angle θv of the first beam steering unit 201 may be in the range of -15° to 15°

In this case, the plurality of nanopillars 10 included in the first beam steering unit 201 may form a subwavelength pattern in which a width W thereof increases along the v-axis.

Specifically, the plurality of nanopillars 10 included in the first beam steering unit 201 may form, in a direction away from the center of the first beam steering unit 201 along the v-axis, a nanopattern in which the width W thereof increases.

Meanwhile, the first beam steering unit 201 may include a first beam steering cell 2011, a second beam steering cell 2012, and a third beam steering cell 2013. A plurality of nanopillars 10 included in each of the plurality of beam steering cells 2011, 2012, and 2013 may form a nanopattern on the basis of locations of the plurality of beam steering cells 2011, 2012, and 2013.

For example, the plurality of nanopillars 10 included in the second beam steering cell 2012 located at the center of the first beam steering unit 201 may form a nanopattern in which an attribute related to at least one of the width W, height H, and number per unit length is uniform. Accordingly, a steering angle of the second beam steering cell 2012 may be 0°.

In this case, the plurality of nanopillars 10 included in the first beam steering cell 2011 located at the left of the second beam steering cell 2012 may form a nanopattern in which an attribute related to at least one of the width W, height H, and number per unit length increases in a direction from the center of the first beam steering unit 201 toward the first beam steering cell 2011. Accordingly, a vertical steering angle θv of the first beam steering cell 2011 may have a negative value.

Likewise, the plurality of nanopillars 10 included in the third beam steering cell 2013 located at the right of the second beam steering cell 2012 may form a nanopattern in which an attribute related to at least one of the width W, height H, and number per unit length increases in a direction from the center of the first beam steering unit 201 toward the third beam steering cell 2013. Accordingly, a vertical steering angle θv of the third beam steering cell 2013 may have a positive value.

On the other hand, the plurality of nanopillars 10 may form a nanopattern in which an attribute decreases in a direction from the center of the first beam steering unit 201 toward each of the beam steering cells 2011, 2012, and 2013.

Referring to FIG. 22, the plurality of nanopillars 10 included in the second beam steering cell 2012 located at the center of the first beam steering unit 201 may form a nanopattern in which an attribute related to at least one of the width W, height H, and number per unit length is uniform. Accordingly, a steering angle of the second beam steering cell 2012 may be 0°.

In this case, the plurality of nanopillars 10 included in the first beam steering cell 2011 located at the left of the second beam steering cell 2012 may form a nanopattern in which an attribute related to at least one of the width W, height H, and number per unit length of the nanopillars 10 decreases in a direction from the center of the first beam steering unit 201 toward the first beam steering cell 2011. Accordingly, a vertical steering angle θv of the first beam steering cell 2011 may have a positive value.

Likewise, the plurality of nanopillars 10 included in the third beam steering cell 2013 located at the right of the second beam steering cell 2012 may form a nanopattern in which an attribute related to at least one of the width W, height H, and number per unit length of the nanopillars 10 decreases in a direction from the center of the first beam steering unit 201 toward the third beam steering cell 2013. Accordingly, a vertical steering angle θv of the third beam steering cell 2013 may have a negative value.

The second beam steering unit 202 may obtain a laser beam steered by the first beam steering unit 201.

The second beam steering unit 202 may include a plurality of beam steering cells 2021, 2022, and 2023.

The second beam steering unit 202 may steer the obtained laser beam using a plurality of nanopillars 10.

As illustrated in FIG. 23, the second beam steering unit 202 may generate a laser beam having a shape diverging along the h-axis. For example, a horizontal steering angle θh of the second beam steering unit 202 may be in the range of -60° to 60°.

In this case, the plurality of nanopillars 10 included in the second beam steering unit 202 may form a subwavelength pattern in which a width W thereof increases along the h-axis.

Specifically, the plurality of nanopillars 10 included in the second beam steering unit 202 may form, in a direction away from the center of the second beam steering unit 202 along the h-axis, a nanopattern in which the width W thereof increases.

Likewise, the plurality of nanopillars 10 included in the second beam steering unit 202 may form nanopatterns on the basis of locations of the plurality of beam steering cells 2021, 2022, and 2023.

Meanwhile, a vertical steering angle θv of FIG. 21 may be smaller than a horizontal steering angle θ of FIG. 23. Accordingly, a horizontal range of the FOV of the laser emitting device 1000 may be wider than a vertical range of the FOV.

Meanwhile, the steering performance of the second beam steering unit 202 may vary according to an angle of incidence of a laser beam incident on the second beam steering unit 202. Specifically, the steering performance of the second beam steering unit 202 may be improved as angle of incidence of the laser beam is closer to 90°. Here, angle of incidence may refer to an angle between the second support unit 302 and the incident laser beam.

In other words, the steering performance of the second beam steering unit 202 may be related to a steering angle of the first beam steering unit 201. Specifically, the steering performance of the second beam steering unit 202 may be improved as the steering angle of the first beam steering unit 201 becomes smaller.

Accordingly, the first steering angle of the first beam steering unit 201 may be smaller than the second steering angle of the second beam steering unit 202. That is, the first beam steering unit 201 may steer a laser beam in the vertical direction in which the steering angle is relatively small, and the second beam steering unit 202 may steer a laser beam in the horizontal direction in which the steering angle is relatively large.

Accordingly, the steering performance of the laser emitting device 1000 may be improved.

Meanwhile, although a nanopattern due to a change in the width W of the nanopillars 10 has been described as an example with reference to FIGS. 21 to 23, the plurality of nanopillars 10 included in the beam steering unit 200 may form a nanopattern on the basis of changes in the height H and number per unit length. This should be sufficiently understood from the principle described above with reference to FIGS. 2 to 7.

Meanwhile, steering directions of the first beam steering unit 201 and the second beam steering unit 202 may be switched with each other. That is, the first beam steering unit 201 may steer a laser beam in the h-direction, and the second beam steering unit 202 may steer a laser beam in the v-direction.

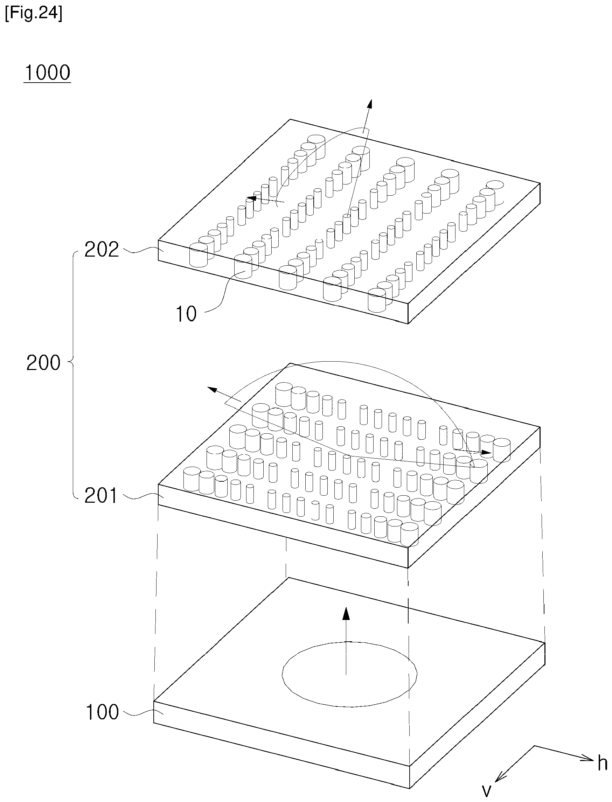

FIG. 24 is an exploded perspective view of a laser emitting device according to another unclaimed embodiment.

Referring to FIG. 24, a laser emitting device 1000 may include a laser emitting unit 100 and a beam steering unit 200. The beam steering unit 200 may include a first beam steering unit 201 and a second beam steering unit 202.

An operation principle of the laser emitting device 1000 may be the same as that of the laser emitting device 1000 of FIG. 20 except for steering directions of the first and second beam steering units 201 and 202. Accordingly, differences from the laser emitting device 1000 of FIG. 20 will be mainly described below.

The first beam steering unit 201 may generate a laser beam having a shape diverging in the h-direction. A horizontal steering angle θh of the first beam steering unit 201 may be in the range of -60° to 60°.

In this case, a plurality of nanopillars 10 included in the first beam steering unit 201 may form a subwavelength pattern in which at least one attribute of the width W, height H, and number per unit length repeatedly increases in the h-direction.

The second beam steering unit 202 may be disposed at an upper portion of the first beam steering unit 201 to obtain a laser beam steered by the first beam steering unit 201. The second beam steering unit 202 may generate laser beams of various shapes by steering the laser beam obtained from the first beam steering unit 201.

Specifically, the second beam steering unit 202 may steer the obtained laser beam using the plurality of nanopillars 10. The second beam steering unit 202 may include a metasurface.

The second beam steering unit 202 may steer a laser beam in the h-direction corresponding to the horizontal direction and the v-direction corresponding to the vertical direction.

For example, the second beam steering unit 202 may generate a laser beam having a shape diverging in the v-direction. A vertical steering angle θv of the second beam steering unit 202 may be in the range of -15° to 15°.

In this case, the plurality of nanopillars 10 included in the second beam steering unit 202 may form a subwavelength pattern in which at least one attribute of the width W, height H, and number per unit length repeatedly increases in the h-direction.

Meanwhile, although some of the laser beams steered by the first beam steering unit 201 are seen in FIG. 24 as being projected to the outside of the second beam steering unit 202, this is merely for convenience of description, and some of the laser beams are not projected to the outside of the second beam steering unit 202 in reality.

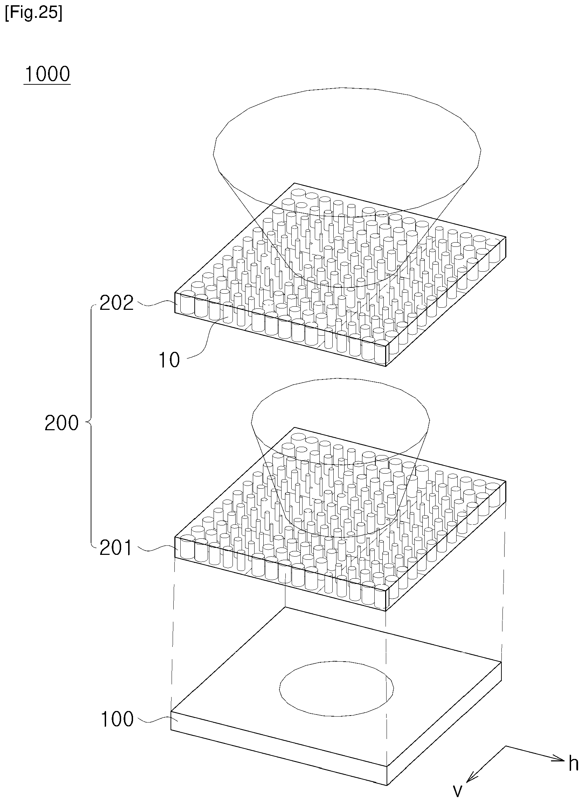

FIG. 25 is an exploded perspective view of a laser emitting device according to still another unclaimed embodiment.

Referring to FIG. 25, a laser emitting device 1000 may include a laser emitting unit 100 and a beam steering unit 200. The beam steering unit 200 may include a first beam steering unit 201 and a second beam steering unit 202.

An operation principle of the laser emitting device 1000 may be the same as that of the laser emitting device 1000 of FIG. 20, except for steering directions and angles of the first and second beam steering units 201 and 202. Accordingly, differences from the laser emitting device 1000 of FIG. 20 will be mainly described below.

The first beam steering unit 201 may generate a laser beam having a shape diverging in the h-direction and v-direction. In this case, a horizontal steering angle θh of the first beam steering unit 201 may be in the range of -20° to 20°. Also, a vertical steering angle θv of the first beam steering unit 201 may be in the range of - 5° to 5°.

In this case, a plurality of nanopillars 10 included in the first beam steering unit 201 may form a subwavelength pattern in which at least one attribute of the width W, height H, and number per unit length repeatedly increases in the h-direction.

Also, the plurality of nanopillars 10 included in the first beam steering unit 201 may form a subwavelength pattern in which at least one attribute of the width W, height H, and number per unit length repeatedly increases in the v-direction.

The second beam steering unit 202 may be disposed at an upper portion of the first beam steering unit 201 to obtain a laser beam steered by the first beam steering unit 201. The second beam steering unit 202 may generate laser beams of various shapes by steering the laser beam obtained from the first beam steering unit 201.

Specifically, the second beam steering unit 202 may steer the obtained laser beam using the plurality of nanopillars 10. The second beam steering unit 202 may include a metasurface.

The second beam steering unit 202 may steer a laser beam in the h-direction corresponding to the horizontal direction and the v-direction corresponding to the vertical direction.

The second beam steering unit 202 may generate a laser beam having a shape diverging in the v-direction and the h-direction.

For example, the second beam steering unit 202 may steer a laser beam steered by the first beam steering unit 201 in the range of -10° to 10° in the h-direction. Accordingly, the laser beam steered by the second beam steering unit 202 may be emitted at a steering angle in the range of -15° to 15°, which is the sum of the steering angle by the first beam steering unit 201 and the steering angle by the second beam steering unit 202.

Also, the second beam steering unit 202 may steer a laser beam steered by the first beam steering unit 201 in the range of -40° to 40° in the v-direction. Accordingly, the laser beam steered by the second beam steering unit 202 may be emitted at a steering angle in the range of -60° to 60°, which is the sum of the steering angle by the first beam steering unit 201 and the steering angle by the second beam steering unit 202.

The plurality of nanopillars 10 included in the second beam steering unit 202 may form a subwavelength pattern in which at least one attribute of the width W, height H, and number per unit length repeatedly increases in the h-direction.

Also, the plurality of nanopillars 10 included in the second beam steering unit 202 may form a subwavelength pattern in which at least one attribute of the width W, height H, and number per unit length repeatedly increases in the v-direction.

Meanwhile, although some of the laser beams steered by the first beam steering unit 201 are seen in FIG. 25 as being projected to the outside of the second beam steering unit 202, this is merely for convenience of description, and some of the laser beams are not projected to the outside of the second beam steering unit 202 in reality.

Sizes of the first beam steering unit 201 and the second beam steering unit 202 may be different. For example, a cross-sectional area along the h-axis of the second beam steering unit 202 may be larger than a cross-sectional area along the h-axis of the first beam steering unit 201.

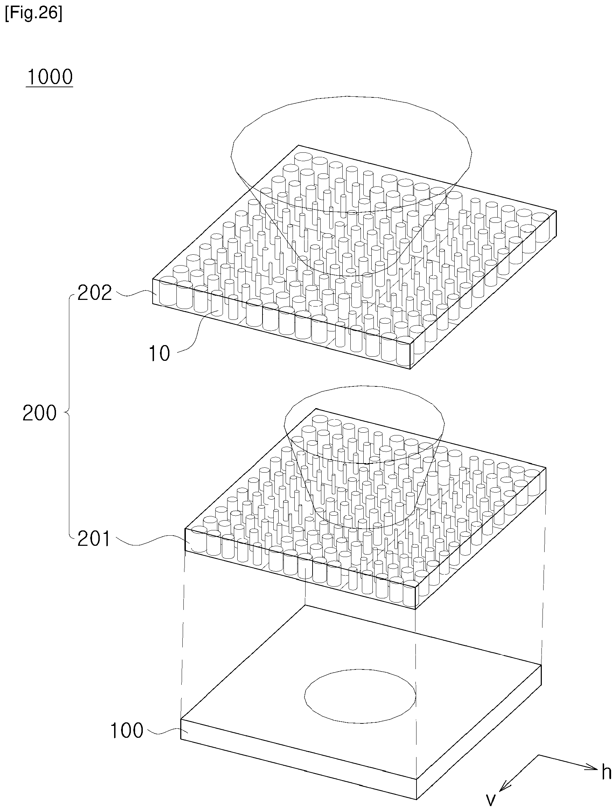

FIG. 26 is an exploded perspective view of a laser emitting device according to yet another unclaimed embodiment.

Referring to FIG. 26, a laser emitting device 1000 may include a laser emitting unit 100 and a beam steering unit 200. The beam steering unit 200 may include a first beam steering unit 201 and a second beam steering unit 202.

An operation principle of the laser emitting device 1000 may be the same as that of the laser emitting device 1000 of FIG. 25, except for a size relationship between the first and second beam steering units 201 and 202. Accordingly, differences from the laser emitting device 1000 of FIG. 25 will be mainly described below.

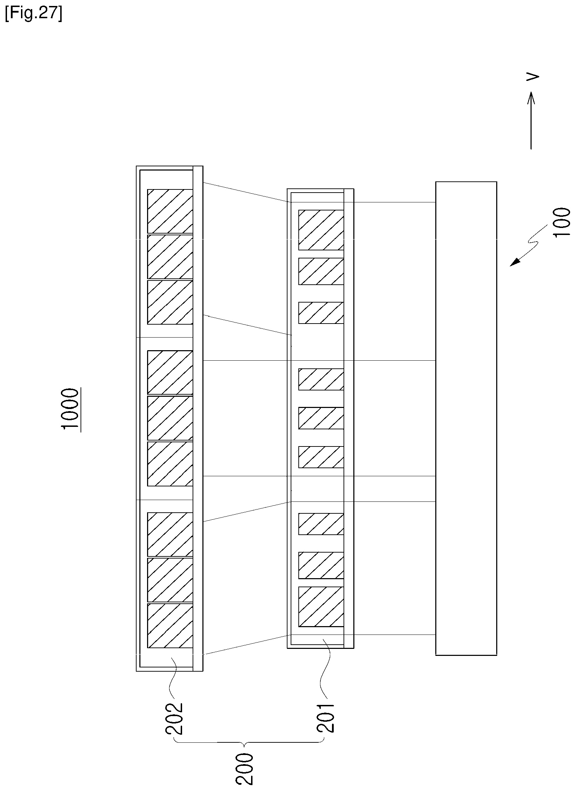

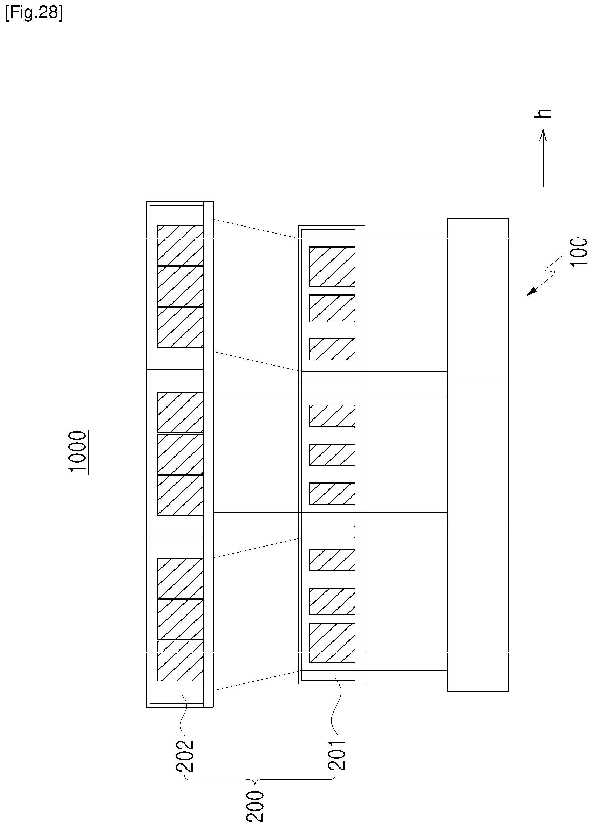

FIGS. 27 and 28 are exploded perspective views of the laser emitting device of FIG. 26 viewed from the side. Specifically, FIG. 27 is an exploded perspective view of the laser emitting device of FIG. 26 viewed along the h-axis. FIG. 28 is an exploded perspective view of the laser emitting device of FIG. 26 viewed along the v-axis.

Referring to FIG. 27, a length along the v-axis of the first beam steering unit 201 may be smaller than a length along the v-axis of the second beam steering unit 202.

Accordingly, the second beam steering unit 202 may easily obtain a laser beam steered by the first beam steering unit 201.

Specifically, when the first beam steering unit 201 generates a laser beam diverging along the v-axis, some of the diverged laser beams may be emitted to the outside of the second beam steering unit 202. Accordingly, light loss may occur due to beam steering by the first beam steering unit 201.

When the length along the v-axis of the second beam steering unit 202 is larger than the length along the v-axis of the first beam steering unit 201, the light loss may be prevented.

Likewise, as illustrated in FIG. 28, when viewed along the v-axis, a length along the h-axis of the first beam steering unit 201 may be smaller than a length along the h-axis of the second beam steering unit 202.

When the first beam steering unit 201 generates a laser beam diverging along the h-axis, some of the diverged laser beams may be emitted to the outside of the second beam steering unit 202. Accordingly, light loss may occur due to beam steering of the first beam steering unit 201.

When the length along the h-axis of the second beam steering unit 202 is larger than the length along the h-axis of the first beam steering unit 201, the light loss may be prevented.

Meanwhile, the length of the second beam steering unit 202 may be set on the basis of a steering direction of the first beam steering unit 201.

For example, when the first beam steering unit 201 steers a laser beam along the v-axis, the length along the v-axis of the second beam steering unit 202 viewed along the h-axis may be larger than the length along the v-axis of the first beam steering unit 201 viewed along the h-axis.

In this case, the length along the h-axis of the second beam steering unit 202 viewed along the v-axis may be equal to the length along the h-axis of the first beam steering unit 201 viewed along the v-axis.

As another example, when the first beam steering unit 201 steers a laser beam along the h-axis, a length along the h-axis of the second beam steering unit 202 viewed along the v-axis may be larger than a length along the h-axis of the first beam steering unit 201 viewed along the v-axis.

In this case, a length along the v-axis of the second beam steering unit 202 viewed along the h-axis may be equal to a length along the v-axis of the first beam steering unit 201 viewed along the h-axis.

As still another example, when the first beam steering unit 201 steers a laser beam along the h-axis and v-axis, lengths along the v-axis and h-axis of the second beam steering unit 202 viewed along the v-axis and h-axis may be larger than lengths along the v-axis and h-axis of the first beam steering unit 201 viewed along the v-axis and h-axis.

Meanwhile, a length of the second beam steering unit 202 may be set on the basis of a size of a steering angle of the first beam steering unit 201.

For example, a length of the second beam steering unit 202 when a steering angle of the first beam steering unit 201 is a first angle may be smaller than a length of the second beam steering unit 202 when the steering angle of the first beam steering unit 201 is a second angle which is larger than the first angle.

Meanwhile, in FIGS. 27 and 28, as the plurality of nanopillars 10 included in the first beam steering unit 201, portions of the nanopillars 10 in which changes in the width W are shown are illustrated. However, this is merely for convenience of description, and when the laser emitting device 1000 of FIG. 26 is viewed from the side in reality, the sizes of the plurality of nanopillars 10 may also look the same.

Meanwhile, the laser emitting device 1000 has been described above with reference to FIGS. 19 to 28 as including two beam steering units 201 and 202. However, embodiments are not limited thereto, and the laser emitting device 1000 may also include three or more beam steering units 200.

### 2. LiDAR

The operation principles of the laser emitting device 1000 according to various embodiments have been described above.

Hereinafter, implementations in which the laser emitting device 1000 is applied will be described.

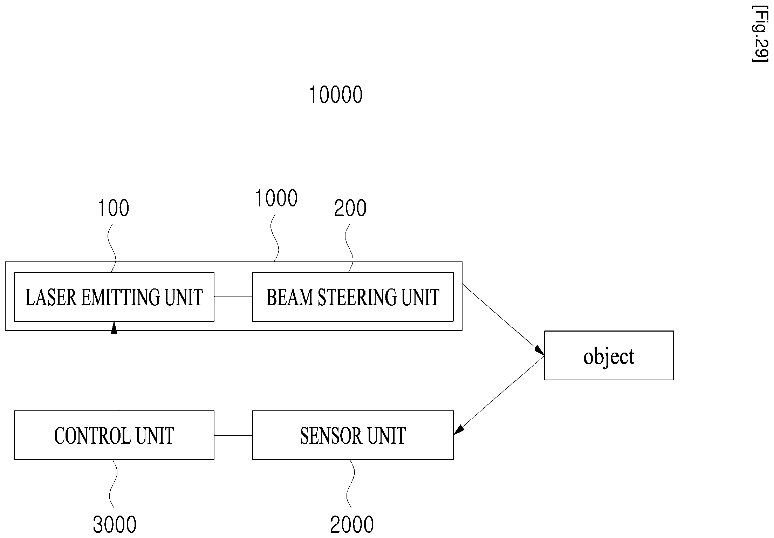

FIG. 29 is a block diagram for describing a light detection and ranging (LiDAR) device according to an unclaimed embodiment. The lidar device may refer to a device for obtaining information on a distance to a surrounding object by using a laser.

Referring to FIG. 29, a lidar device 10000 according to an embodiment may include a laser emitting device 1000, a sensor unit 2000, and a control unit 3000.

A laser beam emitted from the laser emitting device 1000 may be irradiated to an object and then sensed by the sensor unit 2000. The control unit 3000 may obtain information on a distance from the object on the basis of a reception time point of the laser beam sensed by the sensor unit 2000 and an emission time point of the laser beam emitted from the laser emitting device 1000.

Each configuration of the lidar device 10000 will be described in detail below.

The laser emitting device 1000 may include a laser emitting unit 100 and a beam steering unit 200. Meanwhile, since the laser emitting device 1000 may operate identically or similarly to the laser emitting device described above with reference to FIGS. 1 to 28, detailed description thereof will be omitted.

The sensor unit 2000 may sense a laser beam reflected from an object.

The sensor unit 2000 may include a single sensor element or may also include a sensor array formed of a plurality of sensor elements. For example, the second unit 2000 may include an avalanche photodiode (APD) or may also include silicon photomultipliers (SiPM) formed of a plurality of single-photon avalanche diodes (SPADs).

The sensor unit 2000 may be provided as a single channel including a plurality of APDs. The sensor unit 2000 may also include a plurality of channels.

The sensor unit 2000 may include a charge-coupled device (CCD) and a complementary metal-oxide-semiconductor (CMOS) image sensor.

The control unit 3000 may control the laser emitting unit 100 and the sensor unit 2000. For example, the control unit 3000 may control an emission time point, an emission cycle, and an intensity of a laser beam emitted from the laser emitting unit 100.

The control unit 3000 may obtain an emission time point of a laser beam emitted from the laser emitting unit 100. The control unit 3000 may obtain a reception time point of a laser beam reflected from an object and sensed by a sensor 1100. The control unit 3000 may obtain the information on a distance from the object using the emission time point and the reception time point.

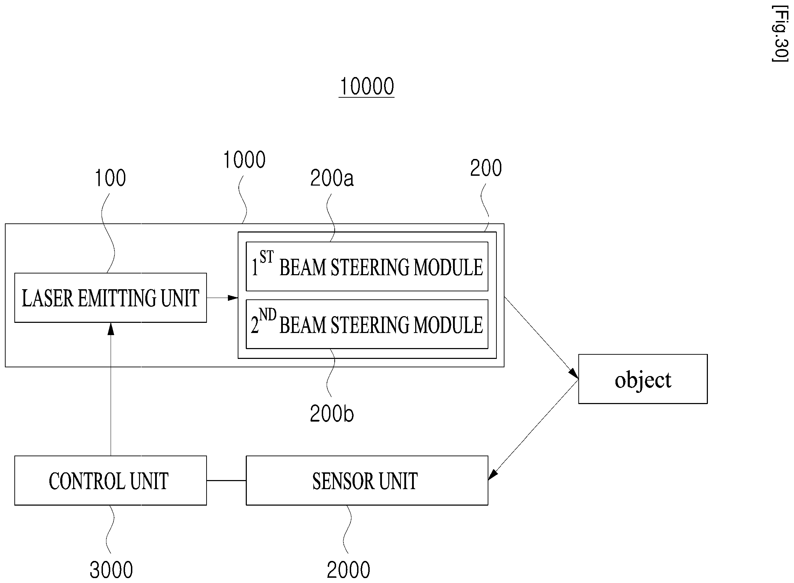

FIG. 30 is a block diagram for describing a lidar device according to another embodiment.

Referring to FIG. 30, a lidar device 10000 according to an unclaimed embodiment may include a laser emitting unit 100, a beam steering unit 200, a sensor unit 2000, and a control unit 3000.

Meanwhile, except for the beam steering unit 200, the lidar device of FIG. 30 may operate identically to the lidar device of FIG. 29. Accordingly, detailed description on other configurations will be omitted, and the beam steering unit 200 will be mainly described.

The beam steering unit 200 may steer a laser beam emitted from the laser emitting unit 100 using a plurality of nanopillars.

The beam steering unit 200 may include a plurality of beam steering modules. For example, the beam steering unit 200 may include a first beam steering module 200a and a second beam steering module 200b.

Each of the first beam steering module 200a and the second beam steering module 200b may include a plurality of nanopillars.

The plurality of nanopillars may form a subwavelength pattern on the basis of at least one attribute of a width W, a pitch P, and a height H.

First nanopillars included in the first beam steering module 200a may form a subwavelength pattern on the basis of a first attribute.

Second nanopillars included in the second beam steering module 200b may form a subwavelength pattern on the basis of a second attribute.

The first attribute and the second attribute may be the same.

Meanwhile, the first beam steering module 200a and the second beam steering module 200b may be disposed on different planes. For example, the second beam steering module 200b may be disposed above the first beam steering module 200a.

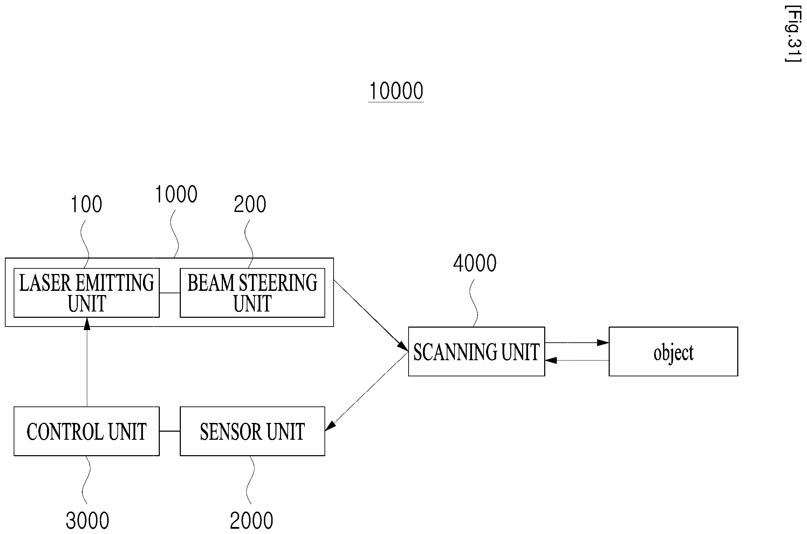

FIG. 31 is a block diagram for describing a lidar device according to still another embodiment.

Referring to FIG. 31, a lidar device 10000 according to an embodiment includes a laser emitting unit 100, a beam steering unit 200, a sensor unit 2000, a control unit 3000, and a scanning unit 4000.

Meanwhile, except for including the scanning unit 4000, the lidar device of FIG. 31 may operate identically to the lidar device of FIG. 29. Accordingly, detailed description on other configurations will be omitted, and the scanning unit 4000 will be mainly described.

A laser beam emitted from the laser emitting unit 100 is steered by the beam steering unit 200. The beam steering unit 200 irradiates the laser beam emitted from the laser emitting unit 100 toward an object through the scanning unit 4000. The sensor unit 2000 receives the laser beam reflected from the object through the scanning unit 4000. The control unit 3000 obtains a distance from the lidar device 10000 to the object using an emission time point of the emitted laser beam and a reception time point of the received laser beam.

The scanning unit 4000 according to an embodiment may obtain the laser beam emitted from the laser emitting device 1000. The scanning unit 4000 may reflect the obtained laser beam toward an object.

The scanning unit 4000 may obtain a laser beam reflected from the object. The scanning unit 4000 may reflect the obtained laser beam toward the sensor unit.

The scanning unit 4000 may steer a laser beam emitted from the laser emitting device 1000. For example, the scanning unit 4000 may change a flight path of the emitted laser beam by reflecting the emitted laser beam. Alternatively, the scanning unit 4000 may change the flight path of the emitted laser beam by refracting the emitted laser beam.

The scanning unit 4000 may form laser beams in various patterns. For example, the scanning unit 4000 may form a laser beam of a line pattern from a laser beam in the form of a point light source. Alternatively, the scanning unit 4000 may form a laser beam in a planar pattern from a laser beam of a line pattern.

The scanning unit 4000 may form the FOV including a plurality of scanning points distributed in the vertical direction and horizontal direction.

The scanning unit 4000 may include various optical configurations.

For example, the scanning unit 4000 may include a scanning mirror configured to reflect light. Specifically, the scanning mirror may include a plane mirror, a micro-electro-mechanical-system (MEMS) mirror, a galvano mirror, and a polygonal mirror.

Also, the scanning unit 4000 may include a lens and a collimator.

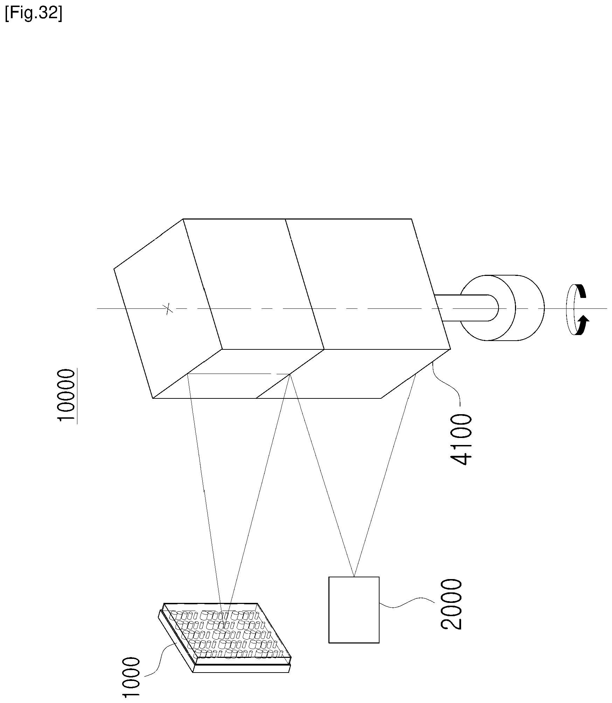

FIG. 32 is a pictorial diagram illustrating a lidar device according to an implementation.

Referring to FIG. 32, a lidar device 10000 may include a laser emitting device 1000, a sensor unit 2000, and a polygonal mirror 4100.

A laser beam emitted from the laser emitting device 1000 may be projected toward an object through the polygonal mirror 4100. A laser beam reflected from the object may be received by the sensor unit 2000 through the polygonal mirror 4100.

Each configuration of the lidar device will be described in detail below.

The laser emitting device 1000 may emit a laser beam toward the polygonal mirror 4100. Specifically, the laser emitting device 1000 may emit a laser beam to an upper portion of a reflective surface of the polygonal mirror 4100.

The laser emitting device 1000 may emit laser beams of various forms. For example, the laser emitting device 1000 may emit a beam of a line pattern extending along a rotation axis of the polygonal mirror 4100.

The laser beam emitted from the laser emitting device 1000 may be projected to a reflective surface of the polygonal mirror 4100.

The polygonal mirror 4100 may change a flight path of the laser beam emitted from the laser emitting device 1000. For example, the polygonal mirror 4100 may change the flight path of the laser beam by reflecting the emitted laser beam.

The polygonal mirror 4100 may project the emitted laser beam toward an object by reflecting the emitted laser beam.

The polygonal mirror 4100 may rotate about one axis. The polygonal mirror 4100 may form laser beams in various patterns by rotating 360°. For example, the polygonal mirror 4100 may form a laser beam in a planar pattern from a laser beam of a line pattern by rotating. Alternatively, the polygonal mirror 4100 may form a laser beam in a linear form extending along an axis perpendicular to the one axis from a laser beam in the form of a point light source.

The polygonal mirror 4100 may obtain a laser beam reflected from the object. The polygonal mirror 4100 may reflect the obtained laser beam toward the sensor unit 2000.

The polygonal mirror 4100 may obtain laser beams reflected from the object through the reflective surface.

The polygonal mirror 4100 may reflect a laser beam obtained through a lower portion of the reflective surface among the obtained laser beams to the sensor unit 2000.

The polygonal mirror 4100 may have various shapes. For example, the polygonal mirror 4100 may have a polygonal column shape.

The polygonal mirror 4100 may include a plurality of reflective surfaces. For example, the polygonal mirror 4100 may include four reflective surfaces.

The sensor unit 2000 may receive a laser beam reflected from the polygonal mirror 4100. Specifically, the sensor unit 2000 may receive a laser beam reflected from an object through the polygonal mirror 4100.

The sensor unit 2000 may be located at the same side as the laser emitting device 1000 with respect to the polygonal mirror 4100. For example, the sensor unit 2000 may be disposed at a lower portion of the laser emitting device 1000.

Meanwhile, the laser emitting device 1000 may include a laser emitting unit including a plurality of VCSEL elements and a beam steering unit including a plurality of nanopillars.

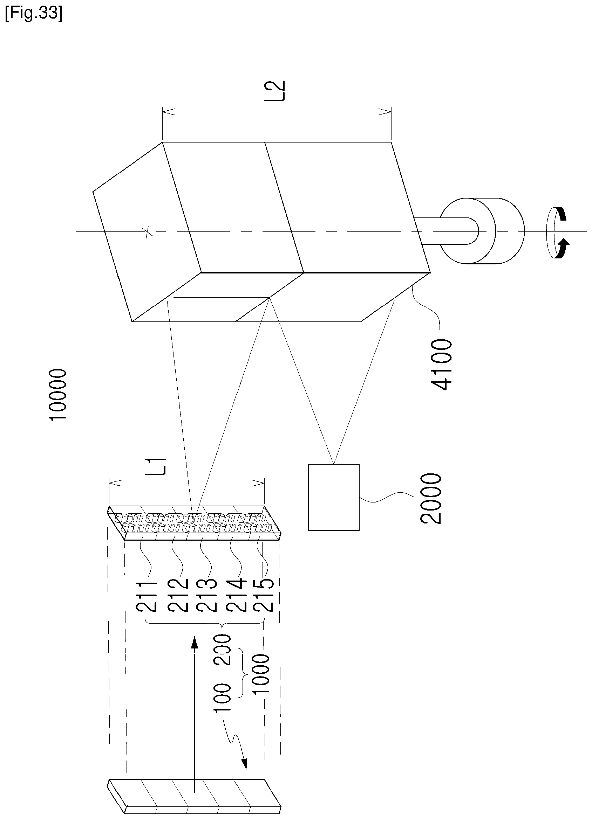

FIG. 33 is a view for describing a lidar device according to an implementation. Specifically, FIG. 33 is an exploded perspective view of the laser emitting device 1000 of FIG. 32.

Referring to FIG. 33, a lidar device 10000 may include a laser emitting device 1000, a sensor unit 2000, and a polygonal mirror 4100.

The laser emitting device 1000 may include a laser emitting unit 100 and a beam steering unit 200.

Each configuration of the laser emitting device 1000 may be described in detail below.

The laser emitting unit 100 according to an embodiment may include a plurality of VCSEL elements.

The plurality of VCSEL elements may be arranged in the form of an array along a rotation axis of the polygonal mirror 4100.

The plurality of VCSEL elements may emit a laser beam in a direction perpendicular to an emission surface of the laser emitting unit 100.

The laser emitting unit 100 may emit a laser beam toward the beam steering unit 200.

The laser emitting unit 100 may emit a laser beam in a direction perpendicular to the rotation axis of the polygonal mirror 4100.

The beam steering unit 200 according to an embodiment may steer a laser beam emitted from the laser emitting unit 100 along the rotation axis.

The beam steering unit 200 may generate a laser beam of a line pattern extending along the rotation axis from the laser beam emitted from the laser emitting unit 100.

The beam steering unit 200 may include a plurality of beam steering cells 210 each including a plurality of nanopillars 10.

For example, the beam steering cells 210 may include a first beam steering cell 211, a second beam steering cell 212, a third beam steering cell 213, a fourth beam steering cell 214, and a fifth beam steering cell 215.

Each of the first to fifth beam steering cells 211, 212, 213, 214, and 215 may steer a laser beam using the plurality of nanopillars 10. For example, each of the first to fifth beam steering cells 211, 212, 213, 214, and 215 may steer a laser beam emitted from the laser emitting unit 100 along the rotation axis of the polygonal mirror 4100 by using the plurality of nanopillars 10.

The first to fifth beam steering cells 211, 212, 213, 214, and 215 may be arranged in the form of an array along the rotation axis.

The plurality of nanopillars 10 may steer a laser beam emitted from the laser emitting unit 100.

The plurality of nanopillars 10 may form a subwavelength pattern on the basis of at least one attribute of the width W, height H, and number per unit length thereof. For example, the plurality of nanopillars 10 may form a subwavelength pattern on the basis of locations at which the plurality of beam steering cells 211, 212, 213, 214, and 215 are arranged in the array in which the plurality of beam steering cells 211, 212, 213, 214, and 215 are arranged.

Specifically, the plurality of nanopillars 10 may form, in a direction from the center of the array toward the beam steering cell 210 in which the plurality of nanopillars 10 are included, a subwavelength pattern in which an attribute repeatedly increases.

Accordingly, the plurality of nanopillars 10 which are included in the first beam steering cell 211 located at the top of the array may form a subwavelength pattern in which an attribute gradually increases toward the top of the array.

On the other hand, the plurality of nanopillars 10 which are included in the fifth beam steering cell 215 located at the bottom of the array may form a subwavelength pattern in which an attribute gradually increases toward the bottom of the array.

Also, the plurality of nanopillars 10 which are included in the third beam steering cell 213 located at the center of the array may form a subwavelength pattern in which an attribute is uniform.

Meanwhile, the plurality of nanopillars 10 may form a subwavelength pattern in which a change rate of an attribute becomes gradually higher the farther the beam steering cell 210 is from the center of the array. For example, a change rate of a first attribute of the plurality of nanopillars 10 included in the first beam steering cell 211 may be higher than a change rate of a second attribute of the plurality of nanopillars 10 included in the second beam steering cell 212.

Accordingly, a size of a rotation-axis component of a steering angle of the beam steering cell 210 may gradually increase away from the center of the array. For example, a size of a rotation-axis component of a first steering angle of the first beam steering cell 211 may be larger than a size of a rotation-axis component of a second steering angle of the second beam steering cell 212.

In this way, the size along the rotation axis of a laser beam emitted from the laser emitting device 1000 may gradually increase from the laser emitting device 1000 toward the polygonal mirror 4100.

Accordingly, a second length L2 along the rotation axis of the polygonal mirror 4100 may be larger than a first length L1 along the rotation axis of the array in which the plurality of beam steering cells 211, 212, 213, 214, and 215 are arranged.

That is, a length along the rotation axis of a laser beam reflected from the polygonal mirror 4100 and projected to an object may be larger than a length along the rotation axis of a laser beam emitted from the laser emitting unit 100.

Accordingly, among measurable ranges of the lidar device 10000, a range along the rotation axis may be increased. Accordingly, short-range object measurement performance of the lidar device 10000 may be improved.

Also, as the length along the rotation axis of the polygonal mirror 4100, that is, a height of the polygonal mirror 4100, increases, a reception amount of the laser beam reflected from an object may increase. Accordingly, a measurable distance of the lidar device 10000 may increase.

Meanwhile, a direction of a rotation-axis component of a steering direction of a beam steering cell 210 located at the top of the array in which the beam steering cells 210 are arranged may be opposite to a direction of a rotation-axis component of a steering direction of a beam steering cell 210 located at the bottom of the array.

For example, a direction of a rotation-axis component of a first steering direction of the first beam steering cell 211 may be opposite to a direction of a rotation-axis component of a fifth steering direction of the fifth beam steering cell 215.

The sensor unit 2000 may receive a laser beam reflected from the polygonal mirror 4100. Specifically, the sensor unit 2000 may receive a laser beam reflected from an object through the polygonal mirror 4100.

The sensor unit 2000 may be located at the same side as the laser emitting device 1000 with respect to the polygonal mirror 4100. For example, the sensor unit 2000 may be disposed at a lower portion of the laser emitting device 1000.

Meanwhile, although, for convenience of description, the plurality of beam steering cells 211, 212, 213, 214, and 215 have been illustrated in FIG. 33 as being arranged in one-dimension, embodiments are not limited thereto, and the plurality of beam steering cells 211, 212, 213, 214, and 215 may also be arranged in the form of a two-dimensional array. For example, the first to fourth beam steering cells 211, 212, 213, and 214 may be arranged in the form of a 2×2 array.

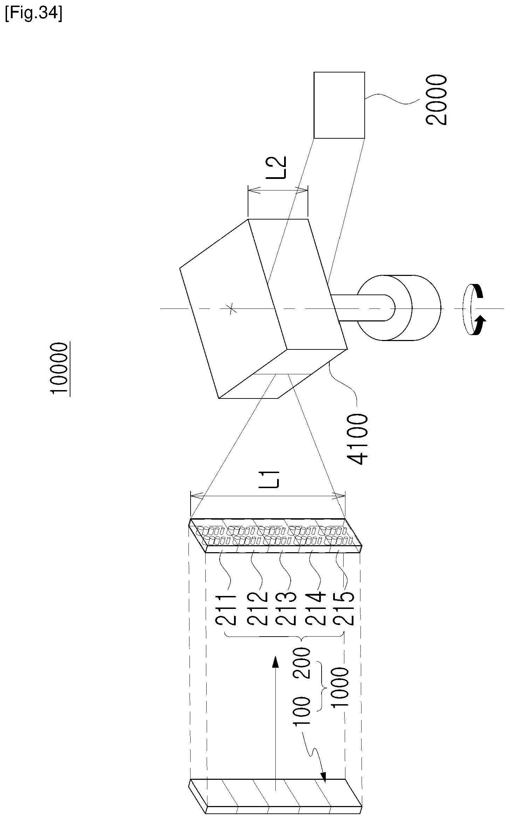

FIG. 34 is a view for describing a lidar device according to another implementation.

Referring to FIG. 34, a lidar device 10000 may include a laser emitting device 1000, a sensor unit 2000, and a polygonal mirror 4100.

The laser emitting device 1000 may include a laser emitting unit 100 and a beam steering unit 200.

Meanwhile, the laser emitting unit of FIG. 34 may correspond to the laser emitting unit of FIG. 33. Accordingly, detailed description thereof will be omitted, and differences from the lidar device of FIG. 33 will be mainly described below.

The beam steering unit 200 according to an embodiment may steer a laser beam emitted from the laser emitting unit 100 along the rotation axis.

The beam steering unit 200 may generate a laser beam of a line pattern extending along the rotation axis from the laser beam emitted from the laser emitting unit 100.

The beam steering unit 200 may include a plurality of beam steering cells 210 each including a plurality of nanopillars 10.

For example, the beam steering cells 210 may include a first beam steering cell 211, a second beam steering cell 212, a third beam steering cell 213, a fourth beam steering cell 214, and a fifth beam steering cell 215.

Each of the first to fifth beam steering cells 211, 212, 213, 214, and 215 may steer a laser beam using the plurality of nanopillars 10. For example, each of the first to fifth beam steering cells 211, 212, 213, 214, and 215 may steer a laser beam emitted from the laser emitting unit 100 along a rotation axis of a polygonal mirror 4100 by using the plurality of nanopillars 10.

The first to fifth beam steering cells 211, 212, 213, 214, and 215 may be arranged in the form of an array along the rotation axis.

The plurality of nanopillars 10 may steer a laser beam emitted from the laser emitting unit 100.

The plurality of nanopillars 10 may form a subwavelength pattern on the basis of at least one attribute of the width W, height H, and number per unit length thereof. For example, the plurality of nanopillars 10 may form a subwavelength pattern on the basis of locations at which the plurality of beam steering cells 211, 212, 213, 214, and 215 are arranged in the array in which the plurality of beam steering cells 211, 212, 213, 214, and 215 are arranged.

Specifically, the plurality of nanopillars 10 may form, in a direction from the center of the array toward the beam steering cell 210 in which the plurality of nanopillars 10 are included, a subwavelength pattern in which an attribute repeatedly decreases.

Accordingly, the plurality of nanopillars 10 which are included in the first beam steering cell 211 located at the top of the array may form a subwavelength pattern in which an attribute gradually decreases toward the top of the array.

On the other hand, the plurality of nanopillars 10 which are included in the fifth beam steering cell 215 located at the bottom of the array may form a subwavelength pattern in which an attribute gradually decreases toward the bottom of the array.

Also, the plurality of nanopillars 10 which are included in the third beam steering cell 213 located at the center of the array may form a subwavelength pattern in which an attribute is uniform.

Meanwhile, the plurality of nanopillars 10 may form a subwavelength pattern in which a change rate of attribute becomes gradually higher the farther the beam steering cell 210 is from the center of the array. For example, a change rate of a first attribute of the plurality of nanopillars 10 included in the first beam steering cell 211 may be higher than a change rate of a second attribute of the plurality of nanopillars 10 included in the second beam steering cell 212.

Accordingly, a size of a rotation-axis component of a steering angle of the beam steering cell 210 may gradually increase away from the center of the array. For example, a size of a rotation-axis component of a first steering angle of the first beam steering cell 211 may be larger than a size of a rotation-axis component of a second steering angle of the second beam steering cell 212.

In this way, the size along the rotation axis of a laser beam emitted from the laser emitting device 1000 may gradually decrease from the laser emitting device 1000 toward the polygonal mirror 4100.

Accordingly, a second length L2 along the rotation axis of the polygonal mirror 4100 may be smaller than a first length L1 along the rotation axis of the array in which the plurality of beam steering cells 211, 212, 213, 214, and 215 are arranged.

Accordingly, the polygonal mirror 4100 may be manufactured in a smaller size. That is, as the size of the polygonal mirror 4100 is reduced, the lidar device 10000 may be manufactured in a smaller size.

Also, as the size of the polygonal mirror 4100 is reduced, a load of a motor which provides a rotary force to the polygonal mirror 4100 may be reduced.

The sensor unit 2000 may receive a laser beam reflected from the polygonal mirror 4100. Specifically, the sensor unit 2000 may receive a laser beam reflected from an object through the polygonal mirror 4100.

Meanwhile, the sensor unit 2000 may be disposed at an opposite side from the laser emitting device 1000 with respect to the polygonal mirror 4100.

The sensor unit 2000 may receive a laser beam reflected from an object through a second reflective surface of the polygonal mirror 4100, which is different from a first reflective surface thereof to which a laser beam emitted from the laser emitting device 1000 is projected.

Accordingly, interference between a first laser beam projected to an object through the first reflective surface and a second laser beam reflected from the object to the second reflective surface may be prevented.

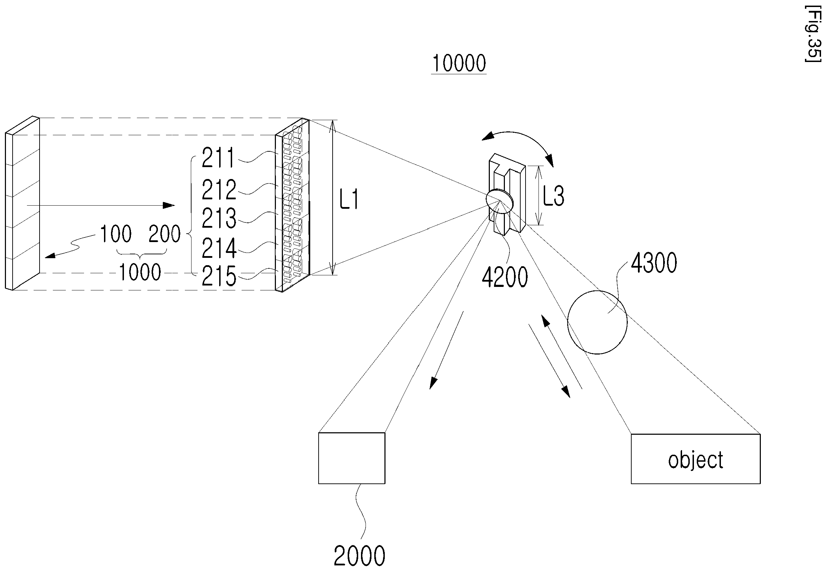

FIG. 35 is a view for describing a lidar device according to still another implementation.

Referring to FIG. 35, a lidar device 10000 may include a laser emitting device 1000, a sensor unit 2000, and a nodding mirror 4200.

The laser emitting device 1000 may include a laser emitting unit 100 and a beam steering unit 200.

Meanwhile, the laser emitting unit of FIG. 35 may correspond to the laser emitting unit of FIG. 33. Accordingly, detailed description thereof will be omitted, and differences from the lidar device of FIG. 33 will be mainly described below.

The beam steering unit 200 according to an embodiment may steer a laser beam emitted from the laser emitting unit 100 along the rotation axis.

The beam steering unit 200 may generate a laser beam of a line pattern extending along the rotation axis from the laser beam emitted from the laser emitting unit 100.

The beam steering unit 200 may include a plurality of beam steering cells 210 each including a plurality of nanopillars 10.

For example, the beam steering cells 210 may include a first beam steering cell 211, a second beam steering cell 212, a third beam steering cell 213, a fourth beam steering cell 214, and a fifth beam steering cell 215.

Each of the first to fifth beam steering cells 211, 212, 213, 214, and 215 may steer a laser beam using the plurality of nanopillars 10. For example, each of the first to fifth beam steering cells 211, 212, 213, 214, and 215 may steer a laser beam emitted from the laser emitting unit 100 along a rotation axis of the nodding mirror 4200 by using the plurality of nanopillars 10.

The first to fifth beam steering cells 211, 212, 213, 214, and 215 may be arranged in the form of an array along the rotation axis.

The plurality of nanopillars 10 may steer a laser beam emitted from the laser emitting unit 100.

The plurality of nanopillars 10 may form a subwavelength pattern on the basis of at least one attribute of the width W, height H, and number per unit length thereof. For example, the plurality of nanopillars 10 may form a subwavelength pattern on the basis of locations at which the plurality of beam steering cells 211, 212, 213, 214, and 215 are arranged in the array in which the plurality of beam steering cells 211, 212, 213, 214, and 215 are arranged.

Specifically, the plurality of nanopillars 10 may form, in a direction from the center of the array toward the beam steering cell 210 in which the plurality of nanopillars 10 are included, a subwavelength pattern in which an attribute repeatedly decreases.

Accordingly, the plurality of nanopillars 10 which are included in the first beam steering cell 211 located at the top of the array may form a subwavelength pattern in which an attribute gradually decreases toward the top of the array.

On the other hand, the plurality of nanopillars 10 which are included in the fifth beam steering cell 215 located at the bottom of the array may form a subwavelength pattern in which an attribute gradually decreases toward the bottom of the array.

Also, the plurality of nanopillars 10 which are included in the third beam steering cell 213 located at the center of the array may form a subwavelength pattern in which an attribute is uniform.

Meanwhile, the plurality of nanopillars 10 may form a subwavelength pattern in which a change rate of attribute becomes gradually higher the farther the beam steering cell 210 is from the center of the array. For example, a change rate of a first attribute of the plurality of nanopillars 10 included in the first beam steering cell 211 may be higher than a change rate of a second attribute of the plurality of nanopillars 10 included in the second beam steering cell 212.

Accordingly, a size of a rotation-axis component of a steering angle of the beam steering cell 210 may gradually increase away from the center of the array. For example, a size of a rotation-axis component of a first steering angle of the first beam steering cell 211 may be larger than a size of a rotation-axis component of a second steering angle of the second beam steering cell 212.

In this way, the size along the rotation axis of a laser beam emitted from the laser emitting device 1000 may gradually decrease from the laser emitting device 1000 toward the nodding mirror 4200.

Accordingly, a third length L3 along the rotation axis of the nodding mirror 4200 may be smaller than a first length L1 along the rotation axis of the array in which the plurality of beam steering cells 211, 212, 213, 214, and 215 are arranged.

Accordingly, the nodding mirror 4200 may be manufactured in a smaller size. That is, as the size of the nodding mirror 4200 is reduced, the lidar device 10000 may be manufactured in a smaller size.

Meanwhile, the nodding mirror 4200 may be a MEMS mirror. In this case, a rotational speed of the nodding mirror 4200 may be higher than a rotational speed of the polygonal mirror 4100 of FIG. 33. Accordingly, a scanning speed of the lidar device 10000 may be increased.

Also, since, in comparison to the lidar device of FIG. 33, the lidar device of FIG. 35 does not include a motor providing a rotary force, durability may be improved.

The sensor unit 2000 may receive a laser beam reflected from the nodding mirror 4200. Specifically, the sensor unit 2000 may receive a laser beam reflected from an object through the nodding mirror 4200.

Meanwhile, the lidar device 10000 may include a condensing lens 4300 for increasing an amount of laser beam received from an object to the nodding mirror 4200.

The condensing lens 4300 may obtain a laser beam reflected from the object. The obtained laser beam may be transmitted to the nodding mirror 4200.

Meanwhile, the nodding mirror 4200 may rotate within a preset range. For example, a rotation range of the nodding mirror 4200 may be -15° to 15°.

Accordingly, the sensor unit 2000 configured to receive a laser beam reflected from an object through the nodding mirror 4200 may be located at the same side as the laser emitting device 1000 with respect to the nodding mirror 4200.

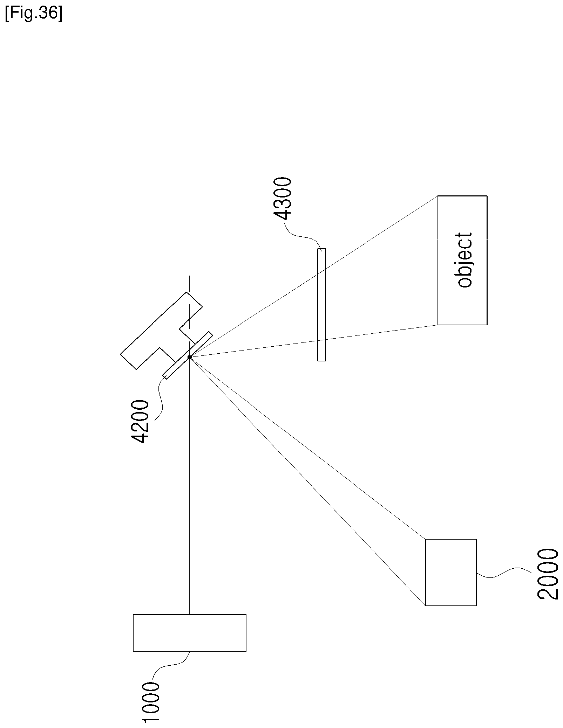

FIG. 36 is a top view of the lidar device of FIG. 35 viewed from the top.

Referring to FIG. 36, a lidar device 10000 may include a laser emitting device 1000 and a nodding mirror 4200.

The nodding mirror 4200 may project a laser beam emitted from the laser emitting device 1000 toward an object by rotating within a predetermined range about a rotation axis.

Meanwhile, the laser emitting device 1000 may emit a laser beam toward the rotation axis of the nodding mirror 4200. That is, a virtual line along which the laser beam emitted from the laser emitting device 1000 extends may cross the rotation axis of the nodding mirror 4200.

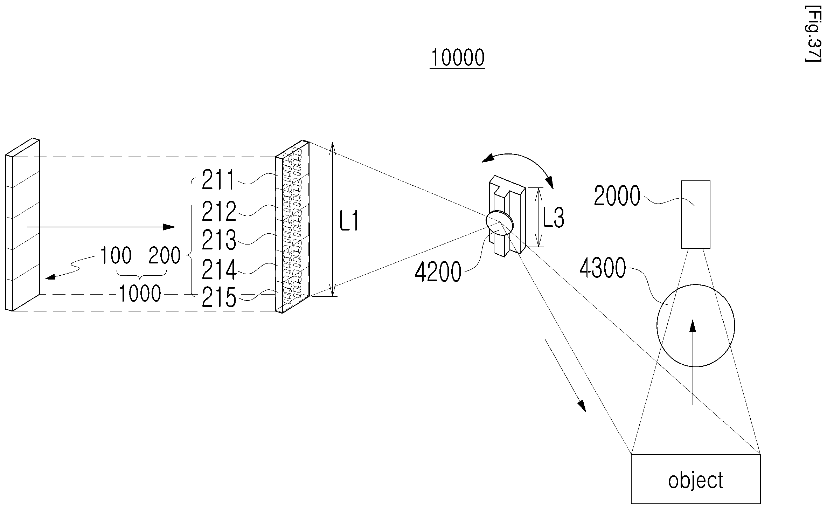

FIG. 37 is a view for describing a lidar device according to still another implementation.

Referring to FIG. 37, a lidar device 10000 may include a laser emitting device 1000, a sensor unit 2000, a nodding mirror 4200, and a condensing lens 4300.

The laser emitting device 1000 may include a laser emitting unit 100 and a beam steering unit 200.

Meanwhile, the laser emitting device 1000 and the nodding mirror 4200 of FIG. 37 may operate identically to the laser emitting device 1000 and the nodding mirror 4200 of FIG. 35. Accordingly, detailed description thereof will be omitted, and differences with the lidar device of FIG. 35 will be mainly described below.

The nodding mirror 4200 may guide a laser beam emitted from the laser emitting device 1000 to an object. For example, the nodding mirror 4200 may guide the emitted laser beam to the object by reflecting the emitted laser beam.

The nodding mirror 4200 may rotate about an axis in a direction in which first to fifth beam steering cells 211, 212, 213, 214, and 215 are arranged. Alternatively, the nodding mirror 4200 may rotate about an axis perpendicular to an emission direction of a laser beam emitted from the laser emitting unit 100.

The nodding mirror 4200 may form a laser beam in a planar form from a laser beam in a linear form by rotating about axis. That is, the nodding mirror 4200 may form a laser beam point cloud.

The nodding mirror 4200 may irradiate the laser beam in the planar form to an object.

The sensor unit 2000 may receive a laser beam reflected from the object.

The condensing lens 4300 may be disposed between the sensor unit 2000 and the object to obtain the laser beam reflected from the object. The obtained laser beam may be obtained by the sensor unit 2000.

The sensor unit 2000 may include a plurality of sensor elements arranged in the form of an array. For example, the plurality of sensor elements may be arranged in a direction parallel to a direction in which the first to fifth beam steering cells 211, 212, 213, 214, and 215 are arranged.

The method according to an embodiment may be implemented in the form of a program command that is executable by various computer means and may be recorded in a computer readable recording medium. The computer readable recording medium may include a program command, a data file, a data structure, and the like solely or in combination. The program command recorded in the medium may be particularly designed for the embodiment or may be known and usable by one of ordinary skill in the computer software art. Examples of the computer readable recording medium include hardware devices particularly configured to store and execute program commands such as magnetic media such as a hard disk, a floppy disk, and a magnetic tape, optical media such as a compact disk read-only memory (CD-ROM) and a digital versatile disk (DVD), magneto-optical media such as a floptical disk, and semiconductor storage devices such as a ROM, a random access memory (RAM), and a flash memory. Examples of the program command include high-level language codes that are computer-executable by using an interpreter and the like as well as machine language codes such as those formed by a compiler. Above-mentioned hardware device may be configured to serve as one or more software modules to execute operations of the embodiment, and vice versa.

### [MODE OF THE INVENTION]

As described above, in the best mode for carrying out the invention, related matters are described.

## Claims

1. A lidar device for measuring a distance to an object within a FOV (field of view) having a vertical direction and a horizontal direction and being formed by a plurality of scanning points, the device comprising:
a laser emitting unit (100) including a plurality of VCSEL(Vertical Cavity Surface Emitting Laser) elements arranged in a form of an array and emitting a plurality of point laser beams,
wherein the plurality of point laser beams have a specific same wavelength;
a steering unit (200) configured to steer and distribute the plurality of point laser beams in the FOV;
a sensor unit (2000) configured to detect a light reflected from the object; and
a control unit (3000) configured to obtain a distance between the lidar device and the object based on an emission time point of the laser beam and a reception time point of the reflected and received light,
wherein the lidar device is **characterized in that**:
i) the steering unit comprises a metasurface including a plurality of beam steering cells (211, 212, 214, 213) arranged in a form of a two-dimensional array having a row direction corresponding to the vertical direction and a column direction corresponding to the horizontal direction,
ii) each of the plurality of the beam steering cells corresponds to each of the plurality of VCSEL elements and each of the plurality of the beam steering cells has their own steering direction different from each other such that the plurality of point laser beams can be distributed in the FOV,
iii) each of the plurality of the beam steering cells comprises a plurality of nanopillars (10) which have a height smaller than the specific wavelength and a width smaller than the specific wavelength and each of the plurality of the beam steering cells is configured to have their own steering direction defined by a vertical steering angle and a horizontal steering angle,
iv) the vertical steering angle of each beam steering cell is determined according to a change rate of a first attribute selected from a height of the nanopillars of each beam steering cell, a width of the nanopillars and a distance between adjacent nanopillars in the vertical direction,
v) the horizontal steering angle is determined according to a change rate of a second attribute selected from the height of the nanopillars of each beam steering cell, the width of the nanopillars and a distance between adjacent nanopillars in the horizontal direction,
vi) in order to distribute the plurality of point laser beams in the FOV along the vertical direction, as a position of a first beam steering cell is further away from a center of the metasurface in the vertical direction, the change rate of the first attribute of the nanopillars in the first beam steering cell increases such that the vertical steering angle of the first beam steering cell is larger according to a distance of the first beam steering cell from the center of the metasurface,
vii) in order to distribute the plurality of point laser beams in the FOV along the horizontal direction, as a position of a second beam steering cell is further away from the center of the metasurface in the horizontal direction, the change rate of the second attribute of the nanopillars in the second beam steering cell increases such that the horizontal steering angle of the second beam steering cell is larger according to a distance of the second beam steering cell from the center of the metasurface.

2. The lidar device of claim 1, wherein the steering direction of one beam steering cell selected from the plurality of the beam steering cells has a vertical component in a range of -M° to M° and a horizontal component in a range of -N° to N°, wherein N is greater than M.

3. The lidar device of claim 1, wherein a location of each of the plurality of scanning points included in the FOV is related to a location of the beam steering cell in the metasurface.

4. The lidar device of claim 1, wherein the nanopillars have a cylindrical or polygonal column shape.

5. The lidar device of claim 1, wherein the first attribute is different from the second attribute.

6. The lidar device of claim 1, wherein the first attribute is one selected from the height of the nanopillars of each beam steering cell, the width of the nanopillars and the distance between adjacent nanopillars, and the second attribute is another one selected from the height of the nanopillars of each beam steering cell, the width of the nanopillars and the distance between adjacent nanopillars.

## Patentansprüche

1. Lidar-Vorrichtung zum Messen einer Entfernung zu einem Objekt innerhalb eines FOV (Sichtfeldes), das eine vertikale Richtung und eine horizontale Richtung aufweist und durch eine Vielzahl von Abtastpunkten gebildet ist, wobei die Vorrichtung Folgendes umfasst:
eine emittierende Lasereinheit (100), die eine Vielzahl von Elementen eines VCSEL (Vertical Cavity Surface Emitting Laser) beinhaltet, die in Form einer Anordnung angeordnet ist und eine Vielzahl von Punktlaserstrahlen emittiert,
wobei die Vielzahl von Punktlaserstrahlen eine spezifische gleiche Wellenlänge aufweist;
eine Lenkungseinheit (200), die dazu konfiguriert ist, die Vielzahl von Punktlaserstrahlen in dem FOV zu lenken und zu verteilen;
eine Sensoreinheit (2000), die dazu konfiguriert ist, ein Licht zu detektieren, das von dem Objekt reflektiert wird; und
eine Steuereinheit (3000), die dazu konfiguriert ist, eine Entfernung zwischen der Lidar-Vorrichtung und dem Objekt auf Grundlage eines Emissionszeitpunkts des Laserstrahls und eines Empfangszeitpunkts des reflektierten und empfangenen Lichts zu erlangen,
wobei die Lidar-Vorrichtung **dadurch gekennzeichnet ist, dass**:
i) die Lenkungseinheit eine Meta-Oberfläche umfasst, die eine Vielzahl von Strahllenkungszellen (211, 212, 214, 213) beinhaltet, die in Form einer zweidimensionalen Anordnung angeordnet ist, die eine Reihenrichtung, die der vertikalen Richtung entspricht, und eine Spaltenrichtung, die der horizontalen Richtung entspricht, aufweist,
ii) jede der Vielzahl von Strahllenkungszellen jeder der Vielzahl von VCSEL-Elementen entspricht und jede der Vielzahl von Strahllenkungszellen ihre eigene Lenkungsrichtung aufweist, die sich derart voneinander unterscheiden, dass die Vielzahl von Punktlaserstrahlen in dem FOV verteilt werden kann,
iii) jede der Vielzahl von Strahllenkungszellen eine Vielzahl von Nano-Säulen (10) umfasst, die eine Höhe, die kleiner als die spezifische Wellenlänge ist, und eine Breite, die kleiner als die spezifische Wellenlänge ist, aufweist, und jede der Vielzahl von Strahllenkungszellen dazu konfiguriert ist, ihre eigene Lenkungsrichtung aufzuweisen, die durch einen vertikalen Lenkungswinkel und einen horizontalen Lenkungswinkel definiert ist,
iv) der vertikale Lenkungswinkel jeder Strahllenkungszelle gemäß einer Änderungsrate eines ersten Attributs bestimmt wird, das aus einer Höhe der Nano-Säulen jeder Strahllenkungszelle, einer Breite der Nano-Säulen und einer Entfernung zwischen benachbarten Nano-Säulen in der vertikalen Richtung ausgewählt ist,
v) der horizontale Lenkungswinkel gemäß einer Änderungsrate eines zweiten Attributs bestimmt wird, das aus der Höhe der Nano-Säulen jeder Strahllenkungszelle, der Breite der Nano-Säulen und einer Entfernung zwischen benachbarten Nano-Säulen in der horizontalen Richtung ausgewählt ist,
vi) um die Vielzahl von Punktlaserstrahlen in dem FOV entlang der vertikalen Richtung zu verteilen, da sich eine Position einer ersten Strahllenkungszelle weiter weg von einer Mitte der Meta-Oberfläche in der vertikalen Richtung befindet, sich die Änderungsrate des ersten Attributs der Nano-Säulen in der ersten Strahllenkungszelle derart erhöht, dass der vertikale Lenkungswinkel der ersten Strahllenkungszelle gemäß einer Entfernung der ersten Strahllenkungszelle von der Mitte der Meta-Oberfläche größer ist,
vii) um die Vielzahl von Punktlaserstrahlen in dem FOV entlang der horizontalen Richtung zu verteilen, da sich eine Position einer zweiten Strahllenkungszelle weiter weg von der Mitte der Meta-Oberfläche in der horizontalen Richtung befindet, sich die Änderungsrate des zweiten Attributs der Nano-Säulen in der zweiten Strahllenkungszelle derart erhöht, dass der horizontale Lenkungswinkel der zweiten Strahllenkungszelle gemäß einer Entfernung der zweiten Strahllenkungszelle von der Mitte der Meta-Oberfläche größer ist.

2. Lidar-Vorrichtung nach Anspruch 1, wobei die Lenkungsrichtung einer Strahllenkungszelle, ausgewählt aus der Vielzahl von Strahllenkungszellen, eine vertikale Komponente in einem Bereich von -M° bis M° und eine horizontale Komponente in einem Bereich von -N° bis N° aufweist, wobei N größer als M ist.

3. Lidar-Vorrichtung nach Anspruch 1, wobei sich eine Stelle jedes der Vielzahl von Abtastpunkten, die in dem FOV beinhaltet ist, auf eine Stelle der Strahllenkungszelle in der Meta-Oberfläche bezieht.

4. Lidar-Vorrichtung nach Anspruch 1, wobei die Nano-Säulen eine zylindrische oder polygonale Spaltenform aufweisen.

5. Lidar-Vorrichtung nach Anspruch 1, wobei sich das erste Attribut von dem zweiten Attribut unterscheidet.

6. Lidar-Vorrichtung nach Anspruch 1, wobei das erste Attribut eines ist, das aus der Höhe der Nano-Säulen jeder Strahllenkungszelle, der Breite der Nano-Säulen und der Entfernung zwischen benachbarten Nano-Säulen ausgewählt ist, und das zweite Attribut ein anderes ist, das aus der Höhe der Nano-Säulen jeder Strahllenkungszelle, der Breite der Nano-Säulen und der Entfernung zwischen benachbarten Nano-Säulen ausgewählt ist.

## Revendications

1. Dispositif lidar pour mesurer une distance à un objet au sein d'un FOV (champ de vision) ayant une direction verticale et une direction horizontale et étant formé par une pluralité de points de balayage, le dispositif comprenant :
une unité d'émission laser (100) incluant une pluralité d'éléments VCSEL (laser à émission par la surface) agencés sous forme d'un réseau et émettant une pluralité de faisceaux laser ponctuels.
dans lequel la pluralité de faisceaux laser ponctuels ont une même longueur d'onde spécifique ;
une unité d'orientation (200) configurée pour orienter et distribuer la pluralité de faisceaux laser ponctuels dans le FOV ;
une unité de détection (2000) configurée pour détecter une lumière réfléchie par l'objet ; et
une unité de commande (3000) configurée pour obtenir une distance entre le dispositif lidar et l'objet sur la base d'un point temporel d'émission du faisceau laser et d'un point temporel de réception de la lumière réfléchie et reçue,
dans lequel le dispositif lidar est **caractérisé en ce que** :
i) l'unité d'orientation comprend une métasurface incluant une pluralité de cellules d'orientation de faisceau (211, 212, 214, 213) agencées sous forme d'un réseau bidimensionnel ayant une direction de rangée correspondant à la direction verticale et une direction de colonne correspondant à la direction horizontale,
ii) chacune de la pluralité de cellules d'orientation de faisceau correspond à chacun de la pluralité d'éléments VCSEL et chacune de la pluralité de cellules d'orientation de faisceau a sa propre direction d'orientation différente des autres, de sorte que la pluralité de faisceaux laser ponctuels peuvent être distribués dans le FOV,
iii) chacune de la pluralité de cellules d'orientation de faisceau comprend une pluralité de nanopilliers (10) qui ont une hauteur plus petite que la longueur d'onde spécifique et une largeur plus petite que la longueur d'onde spécifique, et chacune de la pluralité de cellules d'orientation de faisceau est configurée pour avoir sa propre direction d'orientation définie par un angle d'orientation vertical et un angle d'orientation horizontal,
iv) l'angle d'orientation vertical de chaque cellule d'orientation de faisceau est déterminé selon un taux de changement d'un premier attribut choisi parmi une hauteur des nanopilliers de chaque cellule d'orientation de faisceau, une largeur des nanopilliers et une distance entre des nanopilliers adjacents dans la direction verticale,
v) l'angle d'orientation horizontal est déterminé selon un taux de changement d'un second attribut choisi parmi la hauteur des nanopilliers de chaque cellule d'orientation de faisceau, la largeur des nanopilliers et une distance entre des nanopilliers adjacents dans la direction horizontale,
vi) afin de distribuer la pluralité de faisceaux laser ponctuels dans le FOV le long de la direction verticale, à mesure qu'une position d'une première cellule d'orientation de faisceau s'éloigne d'un centre de la métasurface dans la direction verticale, le taux de changement du premier attribut des nanopilliers dans la première cellule d'orientation de faisceau augmente de telle sorte que l'angle d'orientation vertical de la première cellule d'orientation de faisceau est plus grand selon une distance de la première cellule d'orientation de faisceau par rapport au centre de la métasurface,
vii) afin de distribuer la pluralité de faisceaux laser ponctuels dans le FOV le long de la direction horizontale, à mesure qu'une position d'une seconde cellule d'orientation de faisceau s'éloigne du centre de la métasurface dans la direction horizontale, le taux de changement du second attribut des nanopilliers dans la seconde cellule d'orientation de faisceau augmente de telle sorte que l'angle d'orientation horizontal de la seconde cellule d'orientation de faisceau est plus grand selon une distance de la seconde cellule d'orientation de faisceau par rapport au centre de la métasurface.

2. Dispositif lidar selon la revendication 1, dans lequel la direction d'orientation d'une cellule d'orientation de faisceau choisie dans la pluralité des cellules d'orientation de faisceau a une composante verticale dans une plage de -M° à M° et une composante horizontale dans une plage de -N° à N°, dans lequel N est supérieur à M.

3. Dispositif lidar selon la revendication 1, dans lequel un emplacement de chacun de la pluralité de points de balayage inclus dans le FOV est lié à un emplacement de la cellule d'orientation de faisceau dans la métasurface.

4. Dispositif lidar selon la revendication 1, dans lequel les nanopilliers ont une forme de colonne cylindrique ou polygonale.

5. Dispositif lidar selon la revendication 1, dans lequel le premier attribut est différent du second attribut.

6. Dispositif lidar selon la revendication 1, dans lequel le premier attribut est un attribut choisi parmi la hauteur des nanopilliers de chaque cellule d'orientation de faisceau, la largeur des nanopilliers et la distance entre des nanopilliers adjacents, et le second attribut est un autre attribut choisi parmi la hauteur des nanopilliers de chaque cellule d'orientation de faisceau, la largeur des nanopilliers et la distance entre des nanopilliers adjacents.
